(19) Europäisches Patentamt
European Patent Office
Office européen des brevets

(11) EP 2 402 967 A2

# (12) EUROPEAN PATENT APPLICATION

(43) Date of publication:
**04.01.2012 Bulletin 2012/01**

(51) Int Cl.:
***H01G 9/20*** *(2006.01)* ***H01L 51/00*** *(2006.01)*

(21) Application number: **11169740.5**

(22) Date of filing: **14.06.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **29.06.2010 JP 2010147257**

(71) Applicant: **Sony Corporation**
**Tokyo 108-0075 (JP)**

(72) Inventors:
- **Takada, Harumi**
  **Minato-ku, Tokyo 108-0075 (JP)**
- **Morooka, Masahiro**
  **Minato-ku, Tokyo 108-0075 (JP)**

(74) Representative: **Mills, Julia**
**D Young & Co LLP**
**120 Holborn**
**London EC1N 2DY (GB)**

## (54) Photoelectric conversion element, method of manufacturing the same, photoelectric conversion element module, and method of manufacturing the same

(57) Disclosed herein is a method of manufacturing a photoelectric conversion element, including adhering a counter electrode having a current collector onto a porous photoelectrode and a porous insulating layer which are sequentially layered over a substrate; and bending the current collector and joining the current collector to the substrate.

FIG. 1

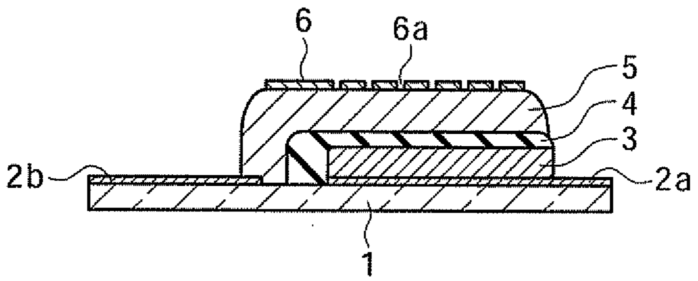


EP 2 402 967 A2

## Description

The present technology relates to a photoelectric conversion element, a method of manufacturing the same, a photoelectric conversion element module and a method of manufacturing the same. More in detail, the present technology relates to a photoelectric conversion element preferable for use as a dye-sensitized solar cell, a method of manufacturing the same, a photoelectric conversion element module preferable for use as a dye-sensitized solar cell module and a method of manufacturing the same.

A solar cell, , which is a photoelectric conversion element for converting sunlight into electrical energy, uses sunlight as an energy source and, hence, has extremely little influence on the global environments. In view of this, further spread of the solar cell is being expected.

As the solar cell, heretofore, crystalline silicon solar cells based on the use of single crystal or polycrystalline silicon and amorphous silicon solar cells have been mainly used.

Meanwhile, the dye-sensitized solar cell proposed by Grätzel et al in 1991 has been paid attention to because the dye-sensitized solar cell is advantageous in that a high photoelectric conversion efficiency can be obtained and that, unlike the silicon solar cells in the past, the dye-sensitized solar cell can be manufactured at low cost without need for large manufacturing equipment (see, for example, Nature, 353, pp. 737-740, 1991).

The dye-sensitized solar cell, in general, has a structure in which a porous photoelectrode formed from titanium oxide or the like and having a photosensitizing dye bonded thereto and a counter electrode are disposed opposite to each other, and the space between the electrodes is filled with an electrolyte layer. To form the electrolyte layer, there is often used an electrolyte solution prepared by dissolving in a solvent an electrolyte including oxidation-reduction species such as iodine and iodide ion. As the material for the counter electrode, platinum is generally used. From the viewpoint of cost and stability of the counter electrode in relation to the electrolyte solution, however, development of dye-sensitized solar cells using carbon as the material for the counter electrode have been under way.

On the other hand, in regard of a dye-sensitized solar cell module, some structures have been proposed. Among others, the dye-sensitized solar cell module of a monolithic structure proposed in Japanese Patent Laid-open No. 2006-236960 has the merit that it can be manufactured at lower cost, as compared with dye-sensitized solar cell modules of other structures (for example, so-called Z-type structure). In the dye-sensitized solar cell module of the monolithic structure, a plurality of mutually separate transparent conductive films are formed on a glass substrate, and a titanium oxide electrode is formed on one of the transparent conductive films. Next, a porous insulating layer is formed so as to extend along an upper surface and a side.surface of the titanium oxide electrode and to make contact with the glass substrate. Subsequently, a carbon counter electrode is formed to extend on the porous insulating film, and is electrically connected to the transparent conductive film adjacent to the transparent conductive film on which the titanium oxide electrode is formed.

## SUMMARY

In the dye-sensitized solar cell module of the monolithic structure as above-mentioned, the carbon counter electrodes are used as wiring for electrical connection between the adjacent ones of the dye-sensitized solar cells. During operation of the dye-sensitized solar cell module, at the carbon counter electrode used as wiring, specifically in an in-plane direction of the carbon counter electrode, electrons are let move a long distance from the transparent conductive film on the glass substrate to a terminal end of the carbon counter electrode. Since the resistance of carbon is high in this case, however, the resistance of the carbon counter electrode is also high. Accordingly, the dye-sensitized solar cell module is high in internal resistance, which leads to a lowering in photoelectric conversion efficiency.

In view of the foregoing, there is a need for a photoelectric conversion element, such as a dye-sensitized solar cell, with which a high photoelectric conversion efficiency can be obtained notwithstanding a monolithic structure and for a method of manufacturing the same.

In addition, there is another need for a photoelectric conversion element module, such as a dye-sensitized solar cell module, with which a high photoelectric conversion efficiency can be obtained notwithstanding a monolithic structure and for a method of manufacturing the same.

Above described needs will become apparent upon a reading of the following description of present specification and appended drawings.

According to an embodiment of the present technology, there is provided

a method of manufacturing a photoelectric conversion element, including:

adhering a counter electrode having a current collector onto a porous photoelectrode and a porous insulating layer which are sequentially layered over a substrate; and
bending the current collector and joining the current collector to the substrate.

Besides, according to another embodiment of the present technology, there is provided

a photoelectric conversion element wherein a counter electrode having a current collector is adhered onto a porous photoelectrode and a porous insulating layer which are sequentially layered over a substrate, and the current collector is bent and joined to the substrate.

In the embodiments of the present technology pertaining to the photoelectric conversion element and the method of manufacturing the same as just-mentioned, typically, the substrate has an insulating substrate, such as a glass substrate, with a first conductive layer and a second conductive layer provided thereover, the first and second conductive layers being typically transparent and being separate from each other. In addition, typically, the porous photoelectrode is formed over the first conductive layer, the porous insulating layer is formed so as to extend along an upper surface and a side surface of the porous photoelectrode and to make contact with the insulating substrate in an area between the first conductive layer and the second conductive layer, and the current collector is bent and electrically connected to the second conductive layer. The current collector, typically, has a conductor plate joined to a surface, on the side opposite to the porous insulating layer side, of the counter electrode. As the conductor plate, preferably, a foil of a metal or alloy is used. Specifically, the foil is, for example, a foil having a metal or alloy containing at least one element selected from the group consisting of Ti, Al, Ni, Ag, Cu, Cr, Fe, Nb, Ta, W, Co and Zr. The foil may be, for example, a foil having stainless steel (e.g., SUS316) or the like. The counter electrode is typically a carbon electrode, particularly, a porous carbon electrode. However, the counter electrode may be other porous electrode than the just-mentioned, insofar as it has a catalyzing ability. The current collector is electrically connected to the second conductive layer, typically by use of a conductive adhesive, but this configuration is not limitative. Typically, at least the porous photoelectrode and the porous insulating layer, preferably the porous photoelectrode, the porous insulating layer and the counter electrodes, are impregnated with an electrolyte solution.

According to a further embodiment of the present technology, there is provided

a method of manufacturing a photoelectric conversion element module, including:

forming, in each of a plurality of areas between a substrate and a conductor plate, a structure having a porous photoelectrode, a porous insulating layer and a counter electrode which are sandwiched between the substrate and the conductor plate in the state of being disposed in this order from the substrate side toward the conductor plate side;

cutting the conductor plate of the structure along a side surface of the counter electrode; and

bending, after the cutting of the conductor plate, a conductor plate portion on the side of a free end of the cut conductor plate and joining the conductor plate portion to the substrate.

Besides, according to yet another embodiment of the present technology, there is provided

a photoelectric conversion element module wherein a counter electrode having a current collector is adhered onto a porous photoelectrode and a porous insulating layer which are sequentially layered in each of a plurality of regions over a substrate, and the conductor plate is bent and joined to the substrate.

In the embodiments of the present technology pertaining to the photoelectric conversion element module and the method of manufacturing the same as just-mentioned, typically, the substrate has an insulating substrate such as a glass substrate with conductive layers, typically transparent conductive layers, provided respectively in a plurality of regions over the insulating substrate. In addition, the porous photoelectrode, the porous insulating layer and the counter electrodes are sandwiched in the area between the conductive layer and the conductor plate, and the conductor plate is bent and electrically connected to the adjacent conductive layer. Specifically, the foil is, for example, a foil having a metal or alloy containing at least one element selected from the group consisting of Ti, Al, Ni, Ag, Cu, Cr, Fe, Nb, Ta, W, Co and Zr. The foil may be, for example, a foil having stainless steel (e.g., SUS316) or the like. The counter electrode is typically a carbon electrode, particularly, a porous carbon electrode. However, the counter electrode may be other porous electrode than the just-mentioned, insofar as it has a catalyzing ability. The current collector is electrically connected to the second conductive layer, typically by use of a conductive adhesive, but this configuration is not limitative. Typically, at least the porous photoelectrode and the porous insulating layer, preferably the porous photoelectrode, the porous insulating layer and the counter electrode, are impregnated with an electrolyte solution.

According to a yet further embodiment of the present technology, there is provided

a method of manufacturing a photoelectric conversion element, including forming a current collector over a porous photoelectrode, a porous insulating layer and a counter electrode which are sequentially layered over a substrate.

Besides, according to still another embodiment of the present technology, there is provided

a photoelectric conversion element wherein a porous photoelectrode, a porous insulating layer and a counter electrode are sequentially layered over a substrate, and a current collector is provided over the counter electrode.

In the embodiments of the present technology pertaining to the photoelectric conversion element and the method of manufacturing the same as above-mentioned, typically, the substrate has an insulating substrate, such as a glass substrate, with a first conductive layer and a second conductive layer provided thereover, the first and second conductive layers being typically transparent and being separate from each other. In addition, the porous photoelectrode is formed over the first conductive layer, the porous insulating layer is formed so as to extend along an upper surface and a side surface of the porous photoelectrode and to make contact with the insulating substrate in an area between the first conductive layer and the second conductive layer. The current collector may have a plurality of openings. In this case, the open area ratio of the current collector is preferably not less than 5% and less than 100%. The current collector, typically, has a conductor plate. As the conductor plate, preferably, a foil having a metal or alloy is used. Specifically, the foil is, for example, a foil having a metal or alloy containing at least one element selected from the group consisting of Ti, Al, Ni, Ag, Cu, Cr, Fe, Nb, Ta, W, Co and Zr. The foil may be, for example, a foil having stainless steel (e.g., SUS316) or the like. The counter electrode is typically a carbon electrode, particularly, a porous carbon electrode. However, the counter electrode may be other porous electrode than the just-mentioned, insofar as it has a catalyzing ability. After the current collector is adhered to the counter electrode, the current collector may be bent and joined to the substrate. Besides, in sealing the photoelectric conversion element, a process may be adopted in which a sealing material is provided so as to surround the peripheries of the porous photoelectrode, the porous insulating layer and the counter electrode present over the substrate, and thereafter a sealing plate preliminarily provided with the current collector on a one-side surface thereof is placed on the sealing material to achieve sealing and to put the current collector into contact with the counter electrode. Typically, at least the porous photoelectrode and the porous insulating layer, preferably the porous photoelectrode, the porous insulating layer and the counter electrode, are impregnated with an electrolyte solution.

According to a still further embodiment of the present technology, there is provided
a method of manufacturing a photoelectric conversion element, including adhering a counter electrode having a current collector onto a porous insulating layer and a conductive member which are components of a body having a porous photoelectrode and the porous insulating layer sequentially layered over a substrate, the body having the conductive member formed over the substrate in an area different from the areas of the porous photoelectrode and the porous insulating layer.

Besides, according to an embodiment of the present technology, there is provided
a photoelectric conversion element wherein a porous photoelectrode, a porous insulating layer, a counter electrode and a current collector are sequentially layered over a substrate, and the substrate and the counter electrode are electrically connected to each other through a conductive member at a portion of the substrate different from portions corresponding to the porous photoelectrode and the porous insulating layer.

In the embodiments of the present technology pertaining to the photoelectric conversion element and the method of manufacturing the same as just-mentioned, typically, the substrate has an insulating substrate, such as a glass substrate, with the first conductive layer and the second conductive layer provided thereover, the first and second conductive layers being typically transparent and being separate from each other. The porous photoelectrode is formed over the first conductive layer, and the porous insulating layer is formed so as to extend along an upper surface and a side surface of the porous photoelectrode and to make contact with the insulating substrate in an area between the first conductive layer and the second conductive layer. In addition, the conductive member is formed over the second conductive layer. The current collector, typically, has a conductor plate. As the conductor plate, preferably, a foil having a metal or alloy is used. Specifically, the foil is, for example, a foil having a metal or alloy containing at least one element selected from the group consisting of Ti, Al, Ni, Ag, Cu, Cr, Fe, Nb, Ta, W, Co and Zr. The foil may be, for example, a foil having stainless steel (e.g., SUS316) or the like. The counter electrode is typically a carbon electrode, particularly, a porous carbon electrode. However, the counter electrode may be other porous electrode than the just-mentioned, insofar as it has a catalyzing ability. Typically, at least the porous photoelectrode and the porous insulating layer, preferably the porous photoelectrode, the porous insulating layer and the counter electrode, are impregnated with an electrolyte solution.

According to another embodiment of the present technology, there is provided
a method of manufacturing a photoelectric conversion element module, including adhering a counter electrode having a current collector onto a porous insulating layer and a conductive member which are components of a body having a porous photoelectrode and the porous insulating layer sequentially layered in each of a plurality of regions over a substrate, the body having the conductive member at a portion of the substrate different from portions corresponding to the porous photoelectrode and the porous insulating layer.

Besides, according to a further embodiment of the present technology, there is provided

a photoelectric conversion element module wherein a porous photoelectrode, a porous insulating layer, a counter electrode and a current collector are sequentially layered in each of a plurality of regions over a substrate, and the substrate and the counter electrode are electrically connected to each other through a conductive member at a portion of the substrate different from portions corresponding to the porous photoelectrode and the porous insulating layer.

In the embodiments of the present technology pertaining to the photoelectric conversion element module and the method of manufacturing the same as just-mentioned, typically, the substrate has an insulating substrate, such as a glass substrate, with conductive layers, typically transparent conductive layers, provided respectively in a plurality of regions over the insulating substrate. The porous photoelectrode is formed over the conductive layer, and the porous insulating layer is formed so as to extend along an upper surface and a side surface of the porous photoelectrode and to make contact with the insulating substrate in an area between the conductive layer and the conductive layer adjacent thereto. In addition, a conductive member is formed at a portion of the conductive layer different from portions corresponding to the porous photoelectrode and the porous insulating layer. The current collector, typically, has a conductor plate. As the conductor plate, preferably, a foil having a metal or alloy is used. Specifically, the foil is, for example, a foil having a metal or alloy containing at least one element selected from the group consisting of Ti, Al, Ni, Ag, Cu, Cr, Fe, Nb, Ta, W, Co and Zr. The foil may be, for example, a foil having stainless steel (e.g., SUS316) or the like. The counter electrode is typically a carbon electrode, particularly, a porous carbon electrode. However, the counter electrode may be other porous electrode than the just-mentioned, insofar as it has a catalyzing ability. Besides, in sealing the photoelectric conversion element module, a process may be adopted in which a sealing material is provided so as to surround the peripheries of the porous photoelectrode, the porous insulating layer and the counter electrode present over the substrate, and thereafter a sealing plate is placed on the sealing material to achieve sealing. Typically, at least the porous photoelectrode and the porous insulating layer, preferably the porous photoelectrode, the porous insulating layer and the counter electrode, are impregnated with an electrolyte solution.

The photoelectric conversion element or photoelectric conversion element module is typically a dye-sensitized photoelectric conversion element or dye-sensitized photoelectric conversion element module in which a photosensitizing dye is bonded to (or adsorbed on) a porous photoelectrode. In this case, the method of manufacturing the photoelectric conversion element or photoelectric conversion element module, typically, further includes bonding the photosensitizing dye to the porous photoelectrode. The porous photoelectrode, typically, has particulates having a semiconductor. The semiconductor preferably include titanium oxide ($TiO_2$), particularly, anatase-type $TiO_2$.

As the porous photoelectrode, one which has particulates of a so-called core-shell structure may be used, and, in this case, it is unnecessary to bond the photosensitizing dye to the porous photoelectrode. As the porous photoelectrode, preferably, there is used one which has particulates of a core-shell structure in which the core has a metal and the shell surrounding the core has a metallic oxide. Use of such a porous photoelectrode ensures that, in the case where the porous photoelectrode or the like is impregnated with an electrolyte solution, the electrolyte in the electrolyte solution would not make contact with the metal cores of the metal/metallic oxide particulates, so that dissolution of the porous photoelectrode by the electrolyte can be effectively prevented from occurring. Therefore, as the metal for constituting the cores of the metal/metallic oxide particulates, use can be made of gold (Au), silver (Ag), copper (Cu) and the like which have a high effect of surface plasmon resonance and have been difficult to use in the related art. Consequently, it is possible to obtain a sufficient surface plasmon resonance effect in photoelectric conversion. Besides, platinum (Pt), palladium (Pd) and the like can also be used as the metal for constituting the cores of the metal/metallic oxide particulates. As the metallic oxide for constituting the shells of the metal/metallic oxide particulates, a metallic oxide insoluble in the electrolyte used is used, after being selected as appropriate. The metallic oxide to be used here is preferably at least one metallic oxide selected from the group consisting of titanium oxide ($TiO_2$), tin oxide ($SnO_2$), niobium oxide ($Nb_2O_5$) and zinc oxide (ZnO), but is not limited to the just-mentioned. For instance, such metallic oxides as tungsten oxide ($WO_3$) and strontium titanate ($SrTiO_3$) can also be used. The particle diameter of the particulates is appropriately selected, and is preferably in the range of 1 to 500 nm. In addition, the grain diameter of the cores of the particulates is also appropriately selected, and is preferably in the range of 1 to 200 nm.

The photoelectric conversion element or photoelectric conversion element module, most typically, is configured as a solar cell or solar cell module. It is to be noted here, however, that the photoelectric conversion element or photoelectric conversion element module may be other than a solar cell; for example, it may be a photosensor.

The photoelectric conversion element or photoelectric conversion element module can be used as a power source for a variety of electronic apparatuses. The electronic apparatuses may basically be any ones, including portable-type ones and stationary-type ones. Specific examples of the electronic apparatuses include cellular phones, mobile apparatuses, robots, personal computers, on-vehicle apparatuses, various household electric appliances, etc. In this case, the photoelectric conversion element or photoelectric conversion element module is, for example, a solar cell or solar cell module to be used as a power source for the just-mentioned electronic apparatuses.

According to yet another embodiment of the present technology, there is provided
a carbon electrode containing metallic oxide particulates with a particle diameter of 1 to 50 nm.

Besides, according to a yet further embodiment of the present technology, there is provided

a method of manufacturing a carbon electrode, including:

forming a paste containing carbon powder and metallic oxide particulates with a particle diameter of 1 to 50 nm on a substrate; and
solidifying the paste.

In the embodiments of the present technology pertaining to the carbon electrode and the method of manufacturing the same as just-mentioned, preferably, the content of the metallic oxide particulates is not less than 20 at% and less than 100 at%. The particle diameter of the metallic oxide particulates is preferably in the range of 25 to 50 nm. The metallic oxide, preferably, contains at least one metallic element selected from the group consisting of Ti, sn, Sb, Zn and Al, for example.

According to still another embodiment of the present technology, there is provided

A method of manufacturing a photoelectric conversion element, including:

Sequentially layering a porous photoelectrode, a porous insulating layer and a counter electrode over a substrate and thereafter immersing at least the porous photoelectrode, the porous insulating layer and the counter electrode in a solution of a photosensitizing dye so as to adsorb the photosensitizing dye on the porous photoelectrode; and
Taking the substrate, the porous photoelectrode, the porous insulating layer and the counter electrode out of the photosensitizing dye solution and thereafter cleaning the counter electrode by use of a cleaning liquid so as to remove the photosensitizing dye adsorbed on the counter electrode.

In the embodiment of the present technology pertaining to the method of manufacturing the photoelectric conversion element as just-mentioned, the conditions described above in relation to the embodiments of the present technology pertaining to the methods of manufacturing the photoelectric conversion element are established, unless contradictory to the above-mentioned properties.

Meanwhile, as an additive to be added to electrolyte solutions, 4-tert-butylpyridine has hitherto been generally known. The present inventors found out that there exists an additive which, when used, makes it possible to obtain cell characteristics superior to those obtained by use of 4-tert-butylpyridine. More specifically, cell characteristics better than those obtained by use of 4-tert-butylpyridine can be obtained by use of an additive which satisfies $6.04 \le pK_a \le 7.3$, where $pK_a$ is the equilibrium constant of dissociation equilibrium of a conjugate acid in water. The additive to be used here may basically be any one that having a $pK_a$ satisfying $6.04 \le pK_a \le 7.3$. Typical examples of the additive include pyridine additives and those additives which have a heterocyclic ring. Specific examples of the pyridine additives include 2-aminopyridine (2-NH2-Py), 4-methoxypyridine (4-MeO-Py), and 4-ethylpyridine (4-Et-By), which are non-limitative examples. On the other hand, specific examples of the additives having a heterocyclic ring include N-methylimidazole (MIm), 2,4-lutidine (24-Lu), 2, 5-lutidine (25-Lu), 2,6-lutidine (26-Lu), 3,4-lutidine (34-Lu), and 3,5-lutidine (35-Lu), which are non-limitative examples. The additive has, for example, at least one selected from the group consisting of 2-aminopyridine, 4-methoxypyridine, 4-ethylpyridine, N-methylimidazole, 2,4-lutidine, 2,5-lutidine, 2,6-lutidine, 3,4-lutidine and 3,5-lutidine. Incidentally, compounds which have the structure of a pyridine or heterocyclic ring compound with a $pK_a$ satisfying $6.04 \le pK_a \le 7.3$ in the molecule thereof are also expected to produce an effect equivalent or similar to that of the above-mentioned additives having a $pK_a$ satisfying $6.04 \le pK_{a \le}$ 7.3. The molecular weight of the solvent of the electrolyte solution is preferably not less than 47.36. Examples of such a solvent include nitrile solvents such as 3-methoxypropionitrile (MPN) , methoxyacetonitrile (MAN), acetonitrile (AN), valeronitrile (VN), etc., carbonate solvents such as ethylene carbonate, propylene carbonate, etc., sulfone solvents such as sulfolane, etc., lactone solvents such as y-butyrolactone, etc., which may be used either singly or in mixture of two or more thereof, and which are non-limitative examples.

On the other hand, as the solvent for the electrolyte solutions in dye-sensitized solar cells, volatile organic solvents such as acetonitrile have hitherto been used. Such a dye-sensitized solar cell, however, has had a problem that if the electrolyte solution is exposed to the atmospheric air due to breakage of the casing or the like, transpiration of the electrolyte solution would occur, leading to failure of the solar cell. In order to solve this problem, in recent years, difficultly volatilizable molten salts called ionic liquids have come to be used as the solvent for the electrolyte solution, in place of the volatile organic solvents (see, for example, Inorg. Chem., 1996, 35, 1168 to 1178 and J. Chem. Phys., 124, 184902 (2006)). As a result, the problem of volatilization of the electrolyte solutions in dye-sensitized solar cells has been being improved. Since the ionic liquids are much higher in viscosity coefficient than the organic solvents used in the past, however, the dye-sensitized solar cells in which the ionic liquid is used are inferior in photoelectric conversion characteristics to the dye-sensitized solar cells in which the volatile organic solvent is used. In view of the actual circumstances, there is a need for a dye-sensitized solar cell in which volatilization of the electrolyte solution can be restrained and, simultaneously, excellent photoelectric conversion characteristics can be obtained. According to a present inventors' finding, specific combinations of ionic liquid and organic solvent ensure that volatilization of the electrolyte solution in a

dye-sensitized solar cell can be restrained, without causing degradation in photoelectric conversion characteristics. Specifically, it was found out effective to let the solvent of the electrolyte solution contain both an ionic liquid having an electron pair acceptive functional group and an organic solvent having an electron pair donative functional group.

Here, the above-mentioned "ionic liquid" include not only salts which are in liquid state at 100°C (inclusive of those which have a melting point or a glass transition temperature of not less than 100°C but which can be brought into liquid state at room temperature by supercooling) but also other salts which can be brought into liquid state through formation of at least one phase by addition of a solvent. The ionic liquid may fundamentally be any ionic liquid that has an electron pair acceptive functional group, and the organic solvent may basically be any one that has an electron donative functional group. Typically, the ionic liquid is one in which the cation has an electron pair acceptive functional group. The ionic liquid, preferably, includes an organic cation which is comprised of an aromatic amine cation having a quaternary nitrogen atom and which has a hydrogen atom in the aromatic ring, and an anion which has a van der Waals volume of not less than 76 $Å^3$ (inclusive of not only organic anions but also inorganic anions such as $AlC1_4^-$, $FeC1_4^-$ , etc. ) . This anion-cation combination is a non-limitative example of the ionic liquid. The content of the ionic liquid in the solvent is selected as appropriate; preferably, the ionic liquid is contained in an amount of not less than 15 wt% and less than 100 wt%, based on the solvent including the ionic liquid and the organic solvent. The electron pair donative functional group of the organic solvent, preferably, is an ether group or an amino group, which is a non-limitative example.

Where the solvent of the electrolyte solution contains both an ionic liquid having an electron pair acceptive functional group and an organic solvent having an electron pair donative functional group as above-mentioned, the following effects can be obtained. In the solvent of the electrolyte solution, hydrogen bond is formed between the electron pair acceptive functional group of the ionic liquid and the electron pair donative functional group of the organic solvent. Since the molecule of the ionic liquid and the molecule of the organic solvent are bonded to each other through the hydrogen bond, it is possible to restrain the volatilization of the organic solvent and, hence, volatilization of the electrolyte solution, as compared with the case where the organic solvent alone is used as the solvent of the electrolyte solution. In addition, since the solvent of the electrolyte solution contains the organic solvent in addition to the ionic liquid, the viscosity coefficient of the electrolyte solution can be lowered and degradation of photoelectric conversion characteristics can be prevented or at least impeded, as compared with the case where only the ionic liquid is used as the solvent of the electrolyte solution. Consequently, it is possible to realize a photoelectric conversion element in which volatilization of the electrolyte solution can be restrained and, simultaneously, excellent photoelectric conversion characteristics can be obtained.

In the embodiments of the present technology configured as above, the counter electrode has the current collector, or the current collector is provided at the counter electrode, whereby a reduction in the substantial sheet resistance of the counter electrode is promised. Therefore, even where a carbon counter electrode having a high resistance value is used as the counter electrode, a reduction in the internal resistance of the photoelectric conversion element or photoelectric conversion element module can be contrived, whereby an enhanced photoelectric conversion efficiency is promised.

Embodiments of the invention will now be described with reference to the accompanying drawings, throughout which like parts are referred to by like references, and in which:

FIG. 1 is a sectional view showing a dye-sensitized photoelectric conversion element according to a first embodiment of the present technology;

FIG. 2 is a schematic diagram for illustrating the operation principle of the dye-sensitized photoelectric conversion element according to the first embodiment;

FIG. 3 is a schematic diagram showing the structural formula of Z907;

FIG. 4 is a schematic diagram showing measurement results of IPCE spectrum of a dye-sensitized photoelectric conversion element in which Z907 alone is bonded to a porous photoelectrode;

FIG. 5 is a schematic diagram showing the structural formula of Dye A;

FIG. 6 is a schematic diagram showing measurement results of IPCE spectrum of a dye-sensitized photoelectric conversion element in which Dye A alone is bonded to a porous photoelectrode;

FIG. 7 is a photograph as substitute for drawing, which shows an optical microscopic image of a current collector in a dye-sensitized photoelectric conversion element obtained in Example 1;

FIG. 8 is a photograph as substitute for drawing, which shows an optical microscopic image of a current collector in a dye-sensitized photoelectric conversion element obtained in Example 2;

FIG. 9 is a schematic diagram showing current-voltage characteristic, for dye-sensitized photoelectric conversion elements obtained in Examples 1 and 2 and Comparative Example 1;

FIG. 10 is a sectional view showing a dye-sensitized photoelectric conversion element according to a second embodiment of the present technology;

FIGS. 11A and 11B are sectional views for illustrating a method of manufacturing the dye-sensitized photoelectric conversion element according to the second embodiment;

FIG. 12 is a sectional view showing a dye-sensitized photoelectric conversion element according to a third embodiment of the present technology;
FIGS. 13A and 13B respectively show a sectional view and a plan view for illustrating a method of manufacturing the dye-sensitized photoelectric conversion element according to the third embodiment;
FIG. 14 is a sectional view showing a dye-sensitized photoelectric conversion element according to a fourth embodiment of the present technology;
FIG. 15 is a sectional view showing a dye-sensitized photoelectric conversion element according to a fifth embodiment of the present technology;
FIG. 16 is a sectional view for illustrating a method of manufacturing the dye-sensitized photoelectric conversion element according to the fifth embodiment;
FIG. 17 is a sectional view for illustrating a method of manufacturing a dye-sensitized photoelectric conversion element according to a sixth embodiment of the present technology;
FIG. 18 is a sectional view showing a dye-sensitized photoelectric conversion element module according to a seventh embodiment of the present technology;
FIG. 19 is a sectional view for illustrating a method of manufacturing the dye-sensitized photoelectric conversion element module according to the seventh embodiment;
FIGS. 20A to 20C are each a sectional view for illustrating a method of manufacturing the dye-sensitized photoelectric conversion element module according to the seventh embodiment;
FIG. 21 is a sectional view for illustrating the method of manufacturing the dye-sensitized photoelectric conversion element module according to the seventh embodiment;
FIG. 22 is a sectional view for illustrating the method of manufacturing the dye-sensitized photoelectric conversion element module according to the seventh embodiment;
FIG. 23 is a sectional view showing a dye-sensitized photoelectric conversion element according to a tenth embodiment of the present technology;
FIGS. 24A to 24C are sectional views for illustrating a method of manufacturing the dye-sensitized photoelectric conversion element according to the tenth embodiment;
FIG. 25 is a schematic diagram showing the structural formula of Z991;
FIG. 26 is a schematic diagram showing current-voltage characteristic for dye-sensitized photoelectric conversion elements in Examples 8 and 9 and Comparative Examples 5 and 6;
FIG. 27 is a sectional view showing a dye-sensitized photoelectric conversion element module according to an eleventh embodiment of the present technology;
FIGS. 28A and 28B are sectional views for illustrating a method of manufacturing the dye-sensitized photoelectric conversion element module according to the eleventh embodiment;
FIGS. 29A and 29B are sectional views for illustrating the method of manufacturing the dye-sensitized photoelectric conversion element module according to the eleventh embodiment;
FIG. 30 is a schematic diagram showing the results of quantitative analysis of the amount of a photosensitizing dye adsorbed on a porous photoelectrode before and after cleaning of a carbon counter electrode in a method of manufacturing a dye-sensitized photoelectric conversion element according to a twelfth embodiment of the present technology;
FIG. 31 is a schematic diagram showing the relationship between the $pK_a$ of an additive and the photoelectric conversion efficiency of a dye-sensitized photoelectric conversion element in which the additive is added to an electrolyte solution, for various additives;
FIG. 32 is a schematic diagram showing the relationship between the $pK_a$ of an additive added to an electrolyte solution and the internal resistance of a dye-sensitized photoelectric conversion element in which the additive is added to the electrolyte solution, for various additives;
FIG. 33 is a schematic diagram showing dependency of the effect of an additive on the kind of solvent of the electrolyte solution;
FIG. 34 is a schematic diagram showing the results of TG-DTA measurement, for various solvents;
FIG. 35 is a schematic diagram showing the results of TG-DTA measurement, for various solvents;
FIG. 36 is a schematic diagram showing the results of TG-DTA measurement, for various solvents;
FIG. 37 is a schematic diagram showing the results of TG-DTA measurement, for various solvent;
FIG. 38 is a schematic diagram showing the results of measurement of the relationship between the content of EMImTCB, in a mixed solvent of EMImTCB and triglyme, and evaporation rate lowering ratio;
FIG. 39 is a schematic diagram showing the results of measurement of the relationship between the van der Waals volume of an anion in an ionic liquid and evaporation rate lowering ratio, for various ionic liquids;
FIG. 40 is a schematic diagram showing the manner in which a plurality of hydrogen bonds are formed between an ionic liquid having an electron pair acceptive functional group and an organic solvent having an electron pair donative functional group;

FIG. 41 is a schematic diagram showing the manner in which a plurality of hydrogen bonds are formed between an ionic liquid having an electron pair acceptive functional group and an organic solvent having a plurality of electron pair donative functional groups; and

FIG. 42 is a sectional view showing the configuration of a metal/metallic oxide particulate constituting a porous photoelectrode in a dye-sensitized photoelectric conversion element according to a fifteenth embodiment of the present technology.

DETAILED DESCRIPTION OF THE PREFERRED EMBODIMENTS

Now, modes for carrying out the present technology (the modes will hereinafter be referred to as "embodiments") will be described below. The description will be made in the following order.

1. First Embodiment (Dye-sensitized photoelectric conversion element and method of manufacturing the same)
2. Second Embodiment (Dye-sensitized photoelectric conversion element and method of manufacturing the same)
3. Third Embodiment (Dye-sensitized photoelectric conversion element and method of manufacturing the same)
4. Fourth Embodiment (Dye-sensitized photoelectric conversion element and method of manufacturing the same)
5. Fifth Embodiment (Dye-sensitized photoelectric conversion element and method of manufacturing the same)
6. Sixth Embodiment (Method of manufacturing dye-sensitized photoelectric conversion element)
7. Seventh Embodiment (Dye-sensitized photoelectric conversion element module and method of manufacturing the same)
8. Eighth Embodiment (Carbon electrode and method of manufacturing the same)
9. Ninth Embodiment (Dye-sensitized photoelectric conversion element and method of manufacturing the same)
10. Tenth Embodiment (Dye-sensitized photoelectric conversion element and method of manufacturing the same)
11. Eleventh Embodiment (Dye-sensitized photoelectric conversion element module and method of manufacturing the same)
12. Twelfth Embodiment (Method of manufacturing dye-sensitized photoelectric conversion element)
13. Thirteenth Embodiment (Dye-sensitized photoelectric conversion element and method of manufacturing the same)
14. Fourteenth Embodiment (Dye-sensitized photoelectric conversion element and method of manufacturing the same)
15. Fifteenth Embodiment (Dye-sensitized photoelectric conversion element and method of manufacturing the same)
16. Sixteenth Embodiment (Photoelectric conversion element and method of manufacturing the same)

<1. First Embodiment>

[Dye-sensitized photoelectric conversion element]

FIG. 1 is a sectional view showing a dye-sensitized photoelectric conversion element of a monolithic structure according to a first embodiment of the present technology.

As shown in FIG. 1, in this dye-sensitized photoelectric conversion element, transparent conductive layers 2a and 2b each having a predetermined plan view shape are provided on a principal surface of a transparent substrate 1, in the state of being separate from each other. A porous photoelectrode 3 is provided on the transparent conductive layer 2a. One kind or a plurality of kinds of photosensitizing dyes (not shown) are bonded to the porous photoelectrode 3. A porous insulating layer 4 is formed to extend in the manner of covering an upper surface and a side surface of the porous photoelectrode 3, and to make contact with the transparent substrate 1 in an area between the transparent conductive layers 2a and 2b. A carbon counter electrode 5 is provided to extend on the porous insulating layer 4, and is electrically connected to the transparent conductive layer 2b. At least the porous photoelectrode 3 and the porous insulating layer 4, preferably the porous photoelectrode 3, the porous insulating layer 4 and the carbon counter electrode 5, are impregnated with an electrolyte solution. A current collector 6 is adhered onto the carbon counter electrode 5 in the state of being electrically connected to the carbon counter electrode 5, by use of a conductive adhesive, for example. The current collector 6 is provided with a multiplicity of openings 6a in the plane thereof. The shape of the openings 6a is, for example, a circular shape, and may be other shape. The ratio of the total area of the openings 6a to the area of the current collector 6, or open area ratio, is preferably not less than 5% and less than $100_{\%}$ the ratio being selected as appropriate. The arrangement pattern of the openings 6a may be selected as appropriate; typically, the openings 6a are provided in an ordered arrangement and at regular intervals. The openings 6a may be different from each other in shape and/or size within the plane of the current collector 6. The current collector 6 is preferably formed from a metal or alloy; particularly preferably, a foil of a metal or alloy is used as the current collector 6.

Though omitted in the drawing, typically, a sealing material (not shown) is provided on the substrate 1 in such

a manner as to surround the peripheries of the porous photoelectrode 3, the porous insulating layer 4, the carbon counter electrode 5 and the current collector 6. In addition, a sealing plate, typically a transparent sealing plate, is mounted on the upper side of the carbon counter electrode 5. The porous photoelectrode 3, the porous insulating layer 4, the carbon counter electrode 5 and the current collector 6 are sealed by the sealing material and the sealing plate.

As the porous photoelectrode 3, typically, a porous semiconductor layer formed by sintering semiconductor particulates is used. The photosensitizing dye or dyes are adsorbed on the surfaces of the semiconductor particulates. As the material of the semiconductor particulates, there can be used elemental semiconductors represented by silicon, compound semiconductors, semiconductors having a perovskite structure, and the like. The semiconductor to be used here is preferably an n-type semiconductor in which conduction-band electrons serve as carriers under photoexcitation, to generate an anodic current. Specific examples of the semiconductors to be used here include titanium oxide ($TiO_2$) zinc oxide (ZnO), tungsten oxide ($WO_3$) , niobium oxide ($Nb_2O_5$), strontium titanate ($SrTiO_3$), and tin oxide ($SnO_2$). Among these semiconductors, preferred is $TiO_2$, particularly, anatase-type $TiO_2$. It should be noted here, however, that the kind of the semiconductor is not limited to the just-mentioned ones, and that two or more kinds of semiconductors may be used in the state of a mixture or a composite material, as appropriate. In addition, the form of the semiconductor particulates may be any of a particulate (granular) form, a tubular form, a rod-like form and the like.

The particle diameter of the semiconductor particulates is not particularly limited, and it is preferably 1 to 200 nm, particularly 5 to 100 nm, in terms of average particle diameter of primary particles. Besides, the semiconductor particulates may be admixed with particles greater than the semiconductor particulates in size so that incident light is scattered by the greater-sized particles, whereby quantum yield can be enhanced. In this case, the average size of the particles additionally mixed with the semiconductor particulates is preferably in the range of 20 to 500 nm, which is non-limitative.

In order that the amount of the photosensitizing dye(s) which can be bonded to the porous photoelectrode 3 is maximized or at least increased, the porous photoelectrode 3 is preferably large in actual surface area inclusive of the areas of the particulate surfaces fronting on pores in the inside of the porous semiconductor layer composed of the semiconductor particulates. Therefore, the actual surface area of the porous photoelectrode 3 in the state of being formed on the transparent conductive layer 2a is preferably at least 10 times, more preferably at least 100 times, the area of the outside surface of the porous photoelectrode 3 (the projected area of the photoelectrode 3). The ratio in this case does not have any particular upper limit; normally, however, the ratio is up to about 1000.

In general, as the thickness of the porous photoelectrode 3 increases and as the number of the semiconductor particulates contained in unit projected area increases, the actual surface area of the porous photoelectrode 3 increases, and the amount of the photosensitizing dye(s) which can be held per unit projected area increases, so that light absorbance is enhanced. On the other hand, as the thickness of the porous photoelectrode 3 increases, the distance over which the electrons transferred from the photosensitizing dye(s) to the porous photoelectrode 3 must diffuse until they reach the transparent conductive layer 2a increases, so that the loss of electrons due to recombination of electric charges in the porous photoelectrode 3 is also increased. Accordingly, in regard of the thickness of the porous photoelectrode 3, there exists a preferable range. The preferable thickness range is generally 0.1 to 100 $\mu$m, more preferably 1 to 50 $\mu$m, and particularly preferably 3 to 30 $\mu$m.

Examples of the electrolyte solution include a solution which contains an oxidation-reduction system (redox pair). Specific examples of the oxidation-reduction system to be used here include a combination of iodine ($I_2$) with an iodide of a metal or organic material, and a combination of bromine ($Br_2$) with a bromide of a metal or organic material. Examples of the cation constituting the metallic salt include lithium ($Li^+$), sodium ($Na^+$) potassium ($K^+$) , cesium ($Cs^+$), magnesium ($Mg^{2+}$), and calcium ($Ca^{2+}$). Preferable examples of the cation constituting the organic salt include quaternary ammonium ions such as tetraalkylammonium ions, pyridium ions, imidazolium ions, etc., which may be used either singly or in mixture of two or more of them.

The electrolyte solution is not limited to the above-mentioned ones. As the electrolyte solution, there can also be used metal complexes such as a combination of a ferrocyanate with a ferricyanate, a combination of ferrocene with ferricinium ion, etc., sulfur compounds such as polysodium sulfide, a combination of an alkylthiol with an alkyl disulfide, etc., viologen dyes, a combination of hydroquinone with quinone, and so on.

As the electrolyte in the electrolyte solution, a particularly preferred among the above-mentioned is an electrolyte obtained by combining iodine ($I_2$) with lithium iodide (LiI), sodium iodide (NaI), or a quaternary ammonium compound such as imidazolium iodide. The content of the electrolyte salt, based on the amount of the solvent, is preferably 0.05 to 10 M, more preferably 0.2 to 3 M. The concentration of iodine ($I_2$) or bromine ($Br_2$) is preferably 0.0005 to 1 M, more preferably 0.001 to 0.5 M.

Besides, for the purpose of improving an open-circuit voltage and a short-circuit current, various additives such as 4-tert-butylpyridine and benzimidazoliums may also be added to the electrolyte solution.

Examples of the solvent constituting the electrolyte solution, generally, include water, alcohols, ethers, esters, carbonic acid esters, lactones, carboxylic acid esters, phosphate triesters, heterocyclic compounds, nitriles, ketones, amides, nitromethane, halogenated hydrocarbons, dimethyl sulfoxide, sulfolane, N-methylpyrralidone, 1,3-dimethylimidazolidinone, 3-methyloxazolidinone, and hydrocarbons.

The transparent substrate 1 is not particularly restricted insofar as it has a material and a shape which permit easy transmission of light therethrough, and various substrate materials can be used; however, it is preferable to use a substrate material high in transmittance, especially visible-light transmittance. In addition, use is preferably made of a material which is high in barrier performance for inhibiting moisture or gases from externally intruding into the dye-sensitized photoelectric conversion element, and which is excellent in solvent resistance and weather resistance. Specific examples of the material for the transparent substrate 1 include transparent inorganic materials such as quartz, glass, etc., and transparent plastics such as polyethylene terephthalate, polyethylene naphthalate, polycarbonate, polystyrene, polyethylene, polypropylene, polyphenylene sulfide, polyvinylidene fluoride, acetyl cellulose, bromophenoxy resin, aramides, polyimides, polystyrene, polyarylates, polysulfones, polyolefins, etc. The thickness of the transparent substrate 1 is not particularly limited, and can be appropriately selected, taking into account the light transmittance and the performance of serving as barrier between the inside and the outside of the photoelectric conversion element.

The transparent conductive layers 2a and 2b provided on the transparent substrate 1 are more preferable as the sheet resistance thereof is lower. Specifically, the sheet resistance is preferably not more than 500 Ω/□ more preferably not more than 100 Ω/□. As the material for forming the transparent conductive layers 2a and 2b, known materials can be used after being appropriately selected, as appropriate. Specific examples of the material used to form the transparent conductive layers 2a and 2b include indium-tin composite oxide (ITO), fluorine-doped tin(IV) oxide $SnO_2$ (FTO), tin(IV) oxide $SnO_2$, zinc (II) oxide ZnO, and indium-zinc composite oxide (IZO). It is to be noted here that the material for forming the transparent conductive layers 2a and 2b is not limited to the just-mentioned materials; besides, the just-mentioned materials may also be used in combination of two or more of them.

The photosensitizing dye to be bonded to the porous photoelectrode 3 is not particularly limited, insofar as it shows a sensitizing action. However, it is preferable for the photosensitizing dye to have an acid functional group for adsorption on the surface of the porous photoelectrode 3. As the photosensitizing dye, in general, preferred are those which have a carboxyl group, a phosphate group or the like, and more preferable are those which have a carboxyl group. Specific examples of the photosensitizing dye to be used here include xanthene dyes such as Rhodamine B, Rose Bengale, eosine, erythrosine, etc., cyanine dyes such as merocyanine, quinocyanine, cryptocyanine, etc., basic dyes such as phenosafranine, Cabri blue, thiocine, Methylene Blue, etc., and porphyrin compounds such as chlorophyll, zinc porphyrin, magnesium porphyrin, etc. Other examples of the photosensitizing dye than the just-mentioned include azo dyes, phthalocyanine compounds, cumarin compounds, bipyridine complex compounds, anthraquinone dyes, and polycyclic quinone dyes. Among these photosensitizing dyes, preferred are those dyes which are complexes of at least one metal selected from the group consisting of Ru, Os, Ir, Pt, Co, Fe and Cu and in which the ligand includes a pyridine ring or an imidazolium ring, because of their high quantum yields. Particularly preferred are those dye molecules which have cis-bis(isothiocyanato)-N,N-bis(2,2'-dipyridyl-4,4'-dicarboxylic acid)-rhutenium(II) or tris(isothiocyanato)-rhutenium (II)-2,2':6',2"-terpyridine-4,4',4"-tricarboxylic acid as a basic skeleton, because of their wide absorption wavelength regions. It should be noted here, however, that the photosensitizing dye to be used is not limited to these exemplary dyes. As the photosensitizing dyes, typically, one of the just-mentioned dyes is used. However, two or more of the just-mentioned dyes may also be used in a mixed state. In the case where two or more photosensitizing dyes are used in a mixed state, the photosensitizing dyes preferably include an inorganic complex dye which is held on the porous photoelectrode 3 and which has a property of bringing about MLCT (Metal to Ligand Charge Transfer), and an organic molecule dye which is held on the porous photoelectrode 3 and which has a property of intramolecular CT (Charge Transfer). In this case, the inorganic complex dye and the organic molecule dye are adsorbed on the porous photoelectrode 3 in different conformations, respectively. The inorganic complex dye, preferably, has a carboxyl group or phosphono group as a functional group for bonding to the porous photoelectrode 3. Besides, the organic molecule dye preferably has both a carboxyl group or phosphono group and a cyano group, amino group, thiol group or thione group, on the same carbon atom, as the functional groups for bonding to the porous photoelectrode 3. The inorganic complex dye is, for example, a polypyridine complex. The organic molecule dye is, for example, an aromatic polycyclic conjugated molecule which has both an electron donative group and an electron acceptive group and which has a property of intramolecular CT.

The method for adsorbing the photosensitizing dye onto the porous photoelectrode 3 is not particularly restricted. For example, there can be adopted a method in which the above-mentioned photosensitizing dye(s) is dissolved in a solvent such as alcohols, nitrates, nitromethane, halogenated hydrocarbons, ethers, dimethyl sulfoxide, amides, N-methylpyrrolidone, 1,3-dimethylimidazolidinone, 3-methyloxazolidinone, esters, carbonic acid esters, ketones, hydrocarbons, water, etc., followed by immersing the porous photoelectrode 3 in the dye solution, or a method in which a solution containing the photosensitizing dye is applied onto the porous photoelectrode 3. Besides, deoxycholic acid or the like may be added to the dye solution, for the purpose of suppressing association between molecules of the photosensitizing dye. If necessary, a UV absorber may be used jointly.

After the photosensitizing dye(s) is adsorbed on the porous photoelectrode 3, the surface of the photoelectrode 3 may be treated by use of an amine, for the purpose of removing the photosensitizing dye(s) adsorbed in excess. Examples of the amine to be used here include 4-tert-butylpyridine and polyvinylpyridine. The amine may, when liquid,

be used as it is, or may be used after dissolved in an organic solvent.

The material of the porous insulating layer 4 is not specifically restricted insofar as it is a material that does not have electroconductivity. However, it is particularly desirable to use an oxide containing at least one element selected from the group consisting of Zr, Al, Ti, Si, Zn, W and Nb. Among others, zirconia, alumina, titania, silica or the like is desirably used. The oxide, typically, is used in the form of particulates. The porosity of the porous insulating layer 4 is preferably not less than 10%. There is no upper limit for the porosity. From the viewpoint of physical strength of the porous insulating layer 4, however, it is normally preferable for the porosity to be in the range of about 10 to 80%. If the porosity is less than 10%, it would influence the diffusion of the electrolyte, thereby conspicuously lowering the characteristics of the dye-sensitized photoelectric conversion element. In addition, the pore diameter of the porous insulating layer 4 is preferably 1 to 1000 nm. If the pore diameter is less than 1 nm, it would affect the diffusion of the electrolyte and/or the impregnation with the photosensitizing dye, thereby lowering the characteristics of the dye-sensitized photoelectric conversion element. The method for producing the porous insulating layer 4 is not particularly limited; however, it is preferable for the porous insulating layer 4 to be a sintered body of the above-mentioned oxide particles.

As the material for the sealing material, there is preferably used a material which has light fastness, insulating properties, moisture-proof properties or the like. Specific examples of the material for the sealing material include epoxy resin, UV-curing resins, acrylic resin, polyisobutylene resin, EVA (ethylene-vinyl acetate copolymer), ionomer resins, ceramics, and various fusible films.

[Method of manufacturing dye-sensitized photoelectric conversion element]

Now, a method of manufacturing the above-described dye-sensitized photoelectric conversion element will be described below.

First, a transparent conductive layer is formed on a principal surface of a transparent substrate 1 by sputtering or the like, and is patterned into predetermined shapes by etching, to form transparent conductive layers 2a and 2b.

Next, a porous photoelectrode 3 is formed on the transparent conductive layer 2a. The method for forming the porous photoelectrode 3 is not specifically restricted. Taking physical properties, convenience, production cost and the like into consideration, however, it is preferable to use a wet-type film forming method. A preferable example of the wet-type film forming method is a method in which a powder or sol of semiconductor particulates is uniformly dispersed in a solvent such as water to prepare a pasty dispersion, and the dispersion is applied onto the transparent conductive layer 2a on the transparent substrate 1 by a coating method or a printing method. The coating method or the printing method for application of the dispersion is not particularly limited, and known methods can be used. Specific examples of the coating method which can be used here include dipping method, spraying method, wire bar method, spin coating method, roller coating method, blade coating method, and gravure coating method. On the other hand, specific examples of the printing method which can be used here include relief printing method, offset printing method, gravure printing method, intaglio printing method, rubber plate printing method, and screen printing method.

In the case where anatase-type $TiO_2$ is used as the material of the semiconductor particulates, the anatase-type $TiO_2$ may be a marketed product in the form of powder, sol, or slurry. Or, alternatively, there may be used anatase-type $TiO_2$ prepared to have a predetermined particle diameter by a known method, such as a method in which a titanium oxide alkoxide is hydrolyzed. In the case of using a commercialized powder of anatase-type $TiO_2$, it is preferable to dispel agglomeration of particles. Therefore, it is preferable to pulverize the particles by use of a mortar, a ball mill or the like, at the time of preparing the pasty dispersion. In this instance, acetylacetone, hydrochloric acid, nitric acid, a surfactant, a chelate agent or the like may be added to the pasty dispersion, in order to prevent or at least impede re-agglomeration of the particles once released from agglomeration. Besides, in order to increase the viscosity of the pasty dispersion, any of various thickeners such as cellulose thickeners or polymers, e.g. polyethylene oxide or polyvinyl alcohol, etc. may be added to the pasty dispersion.

After the semiconductor particulates are applied onto the transparent conductive layer 2a by coating or printing, the porous photoelectrode 3 is preferably calcined in order to electrically connect the semiconductor particulates to one another, to enhance the mechanical strength of the porous photoelectrode 3, and to enhance the adhesion of the porous photoelectrode 3 to the transparent conductive layer 2a. The range of the calcination temperature is not particularly limited. If the temperature is too high, however, the electric resistance of the transparent conductive layer 2a and 2b would be raised and, further, the transparent conductive layers 2a and 2b may be melted. In view of this, normally, the calcination temperature is preferably 40 to 70n°C, more particularly, 40 to 650°C. In addition, the calcination time also is not specifically restricted; ordinarily, the calcination time is about 10 minutes to about 10 hours.

After the calcinations, a dipping treatment by use of, for example, an aqueous titanium tetrachloride solution or a sol of ultrafine titanium oxide particulates having a diameter of not more than 10 nm, may be carried out, for the purpose of increasing the surface areas of the semiconductor particulates or augmenting necking among the semiconductor particulates. In the case where a plastic substrate is used as the transparent substrate 1, a process may be adopted in which the porous photoelectrode 3 is formed on the transparent conductive layer 2a by use of a pasty

dispersion containing a binder, and the porous photoelectrode 3 is contact-bonded to the transparent conductive layer 2a by use of a hot press.

Subsequently, a porous insulating layer 4 is formed so as to cover an upper surface and a side surface of the porous photoelectrode 3.

Next, a paste containing a carbon powder, for example, is applied to the whole surface of the porous insulating layer 4 and an end portion of the transparent conductive layer 2b.

Subsequently a current collector 6 preliminarily formed with openings 6a is adhered onto the carbon powder-containing paste by use of a conductive adhesive or the like.

Next, the carbon powder-containing paste is calcined, to form a carbon counter electrode 5. In this manner, the carbon counter electrode 5 covering the porous insulating layer 4 and connected to the transparent conductive layer 2b is formed.

Subsequently, the transparent substrate 1 provided with the porous photoelectrode 3, the porous insulating layer 4, the carbon counter electrode 5 and the current collector 6 is immersed in a photosensitizing dye solution prepared by dissolving a photosensitizing dye in a predetermined solvent, whereby the photosensitizing dye is bonded to the porous photoelectrode 3.

Next, the transparent substrate 1 provided with the porous photoelectrode 3, the porous insulating layer 4, the carbon counter electrode 5 and the current collector 6 is taken out of the photosensitizing dye solution. Thereafter, a layer of a sealing material is formed in the peripheries of the porous photoelectrode 3, the porous insulating layer 4 and the carbon counter electrode 5. Further, a sealing plate is disposed on the upper side of the carbon counter electrode 5.

Thereafter, an electrolyte solution is poured in through a pouring hole preliminarily provided in the sealing plate, to impregnate the porous photoelectrode 3, the porous insulating layer 4 and the carbon counter electrode 5 with the electrolyte solution.

In the above-mentioned manner, the intended dye-sensitized photoelectric conversion element of a monolithic structure is manufactured.

[Operation of dye-sensitized photoelectric conversion element]

Now, operation of the dye-sensitized photoelectric conversion element manufactured as above will be described below.

The dye-sensitized photoelectric conversion element, upon incidence of light thereon, operates as a cell with the carbon counter electrode 5 as a positive electrode and with the transparent conductive layer 2a as a negative electrode. The principle of this operation is as follows. Incidentally, here, it is assumed that FTO is used as the material for the transparent conductive layer 2a, $TiO_2$ is used as the material for the porous photoelectrode 3, and an oxidation-reduction species of $I/I_3$ is used as the redox pair, but the assumption is non-limitative. Besides, it is assumed that one kind of photosensitizing dye is bonded to the porous photoelectrode 3.

when photons transmitted through the transparent substrate 1 and the transparent conductive layer 2a to be incident on the porous photoelectrode 3 are absorbed by the photosensitizing dye bonded to the porous photoelectrode 3, electrons in the photosensitizing dye are excited from a ground state (HOMO) to an excited state (LUMO). The thus excited electrons are drawn through the electrical coupling between the photosensitizing dye and the porous photoelectrode 3 into the conduction band of $TiO_2$ constituting the porous photoelectrode 3, and passes through the porous photoelectrode 3, to reach the transparent conductive layer 2a.

On the other hand, the photosensitizing dye having lost the electrons accepts electrons from a reducing agent, for example I, in the electrolyte solution by the following reaction, to produce an oxidizing agent, for example 13- (combined ion of $1_2$ and $I^-$), in the electrolyte solution.

$$2I^- \rightarrow I_2 + 2e^-$$

$$I_2 + I^- \rightarrow I_3^-$$

The oxidizing agent produced in this manner diffuses to reach the carbon counter electrode 5, and accepts electrons from the carbon counter electrode 5 by the reverse reaction of the above-mentioned reaction, to be thereby reduced to the original reducing agent.

$$I3- \rightarrow I_2 + I^-$$

$$I_2 + 2e^- \rightarrow 2I$$

The electrons sent out from the transparent conductive layer 2a into an external circuit performs an electrical

work in the external circuit, before returning to the carbon counter electrode 5. In this way, optical energy is converted into electrical energy, without leaving any change in the photosensitizing dye or the electrolyte solution.

Now, description will be made of operation of a dye-sensitized photoelectric conversion element in which two kinds of photosensitizing dyes are bonded to the porous photoelectrode 3. Here, it is presumed, as an example, that Z907 and Dye A are bonded to the porous photoelectrode 3, but this assumption is non-limitative. Dye A is 2-Cyano-3-[4- [4- (2,2-diphenylethyDphenyl] -l,2,3,3a,4,8b-hexahydrocyclopent[b]indol-7-yl]-2-propenoic acid. FIG. 2 is an energy diagram for illustrating the operation principle of this dye-sensitized photoelectric conversion element. This dye-sensitized photoelectric conversion element, upon incidence of light thereon, operates as a cell with the carbon counter electrode 5 as a positive electrode and with the transparent conductive layer 2a as a negative electrode. The principle of the operation is as follows. Incidentally, here, it is assumed that FTO is used as the material for the transparent conductive layer 2a, $TiO_2$ is used as the material for the porous photoelectrode 3, and an oxidation-reduction species of $I^-/I_3^-$ is used as the redox pair, but the assumption is non-limitative.

FIG. 3 shows the structural formula of Z907, and FIG. 4 shows the measurement results of IPCE (Incident Photon-to-current Conversion Efficiency) spectrum when Z907 alone is adsorbed on the surface of the porous photoelectrode 3. In addition, FIG. 5 shows the structural formula of Dye A, and FIG. 6 shows the measurement results of IPCE spectrum when Dye A alone is adsorbed on the surface of the porous electrode 3. As shown in FIGS. 4 and 6, Z907 can absorb rays with wavelengths in a wide range, but its light absorbance is insufficient in a short-wavelength region. In this short-wavelength region, Dye A having a high light absorbance in the short-wavelength region assists absorption of light. Thus, Dye A functions as a photosensitizing dye having a high absorbance in a short-wavelength region.

As shown in FIG. 3, Z907 has carboxyl groups (-COOH) as functional groups for strongly bonding to the porous photoelectrode 3, and these carboxyl groups are actually bonded to the porous photoelectrode 3. On the other hand, as shown in FIG. 5, Dye A has a structure in which a carboxyl group (-COOH) as a functional group for strong bonding to the porous photoelectrode 3 and a cyano group (-CN) as a functional group for weak bonding to the porous photoelectrode 3 are bonded to the same carbon atom. In addition, in Dye A, the carboxyl group and the cyano group bonded to the same carbon atom are bonded to the porous photoelectrode 3. Thus, Dye A is adsorbed on the porous photoelectrode 3 by the carboxyl group and the cyano group bonded to the same carbon atom; therefore, Dye A is adsorbed on the porous photoelectrode 3 in a conformation different from that of Z907, which is adsorbed on the porous photoelectrode 3 by only the carboxyl groups. Here, if a plurality of functional groups bonded to the same carbon atom in Dye A should be all functional groups for strong bonding to the porous photoelectrode 3, the conformation of Dye A adsorbed on the porous photoelectrode 3 would have a low degree of freedom, so that the advantageous effect of the presence of a plurality of functional groups bonded to the same carbon atom would be displayed with difficulty. In Dye A, on the other hand, the cyano group bonded weakly to the porous photoelectrode 3 functions in an auxiliary manner, and does not hamper the bonding to the porous photoelectrode 3 of the carboxyl group present for strong bonding. As a result, in Dye A, the effect of the bonding of both the carboxyl group and the cyano group to the same carbon atom is exhibited in an effective manner. Consequently, Dye A and Z907, even if present adjacently to each other on the surface of the porous photoelectrode 3, can coexist without showing any strong interaction therebetween, so that they do not spoil each other's photoelectric conversion performance. Meanwhile, Dye A is effectively present intermediately between the Z907 molecules bonded to the same surface of the porous photoelectrode 3, and restrains association between the Z907 molecules, thereby preventing useless electron transfer between the Z907 molecules. Therefore, excited electrons arising from Z907 having absorbed light are efficiently taken out into the porous photoelectrode 3, without useless transfer between Z907 molecules, so that the photoelectric conversion efficiency of Z907 is enhanced. Besides, excited electrons arising from Dye A having absorbed light are taken out into the porous photoelectrode 3 through the carboxyl groups strongly bonded to the porous photoelectrode 3, so that transfer of electric charges to the porous photoelectrode 3 takes place efficiently.

When photons transmitted through the transparent substrate 1, the transparent conductive layer 2a and the porous photoelectrode 3 are absorbed in the photosensitizing dyes bonded to the porous photoelectrode 3, namely, Z907 and Dye A, electrons in Z907 and Dye A are excited from the ground state (HOMO) to the excited state (LUMO). Ln this instance, since Z907 and Dye A are present as photosensitizing dye, rays in a wider wavelength region can be absorbed at a higher light absorption efficiency, as compared with the case of a dye-sensitized photoelectric conversion element wherein one dye is used as photosensitizing dye.

The electrons in the excited state are drawn out into the conduction band of the porous photoelectrode 3 through the electrical coupling between the photosensitizing dyes (namely, Z907 and Dye A) and the porous photoelectrode 3, and pass through the porous photoelectrode 3, to reach the transparent conductive layer 2a. In this case, Z907 and Dye A are sufficiently different from each other in minimum excitation energy, or HOMO-LUMO gap; besides, Z907 and Dye A are bonded to the porous photoelectrode 3 in different conformations. This ensures that useless transfer of electrons between Z907 and Dye A is unlikely to occur. Therefore, Z907 and Dye A do not lower each other's quantum yield, so that the photoelectric conversion functions of Z907 and Dye A are exhibited satisfactorily, and the amount of electric

current generated is much enhanced. In this system, besides, there are two kinds of paths through which the electrons in the excited state of Dye A are drawn out into the conduction band of the porous photoelectrode 3. One of the two kinds of paths is a direct path $P_1$ though which the electrons are drawn out directly from the excited state of Dye A into the conduction band of the porous photoelectrode 3. The other is an indirect path $P_2$ wherein the electrons in the excited state of Dye A are drawn out first into the excited state of Z907 having a lower energy level, and are thereafter drawn out from the excited state of Z907 into the conduction band of the porous photoelectrode 3. Due to the contribution of the indirect path P2, the photoelectric conversion efficiency of Dye A is enhanced in the system wherein Z907 is present in addition to Dye A.

On the other hand, Z907 and Dye A having lost electrons accept electrons from a reducing agent, for example I-, in the electrolyte solution by the following reaction, and produce an oxidizing agent, for example $I_3^-$ (a combined ion of $I_2$ and I) in the electrolyte solution.

$$2I^- \rightarrow I_2 + 2e^-$$

$$I_2 + I^- \rightarrow I_3^-$$

The oxidizing agent thus produced diffuses to reach the carbon counter electrode 5, where it accepts electrons from the carbon counter electrode 5, to be reduced to the original reducing agent, by the reverse reaction of the above-mentioned reaction.

$$I_3^- \rightarrow I_2 + I^-$$

$$I_2 + 2e^- \rightarrow 2I^-$$

The electrons sent out from the transparent conductive layer 2a into an external circuit perform an electrical work in the external circuit, before returning to the carbon counter electrode 5. In this manner, optical energy is converted into electrical energy, without leaving any change in the photosensitizing dyes (namely, Z907 and Dye A) or the electrolyte solution.

<Example 1>

A dye-sensitized photoelectric conversion element was manufactured as follows.

A pasty dispersion of $TiO_2$ as raw material for forming a porous photoelectrode 3 was prepared with reference to "Shikiso Zokan Taiyo Denchi No Saishin Gijutsu (The Latest Technologies of Dye-Seaisitized Solar Cells)" supervised by Hironori Arakawa, 2001, CMC Publishing Co., Ltd.) . Specifically, first, 125 ml of titanium isopropoxide was added dropwise to 750 ml of a 0.1 M aqueous solution of nitric acid with stirring at room temperature. After the dropwise addition, the admixture was transferred into a 80°C thermostat, and stirring was continued for eight hours, to obtain a milky white semi-transparent sol solution. The sol solution was let cool to room temperature, was filtered through a glass filter, and thereafter a solvent was added thereto until the volume of the solution became 700 ml. The sol solution thus obtained was transferred into an autoclave, a hydrothermal reaction was let proceed at 220°C for 12 hours, and then an ultrasonic treatment as a dispersing treatment was conducted for one hour. Next, the solution was concentrated at 40°C by use of an evaporator, to adjust the $TiO_2$ content to 20 wt%. The thus concentrated sol solution was admixed with polyethylene glycol (molecular weight: 500,000) in an amount corresponding to 20% of the mass of $TiO_2$ and anatase-type $TiO_2$ with a particle diameter of 200 nm in an amount corresponding to 30% of the mass of $TiO_2$, and the resulting admixture was uniformly blended by a stirrer-deaerator, to obtain a pasty dispersion of $Ti_{O2}$ having an increased viscosity.

The pasty dispersion of $TiO_2$ thus obtained was applied onto an FTO layer, formed as a transparent conductive layer 2a on a glass substrate, by a blade coating method, to form a particulate layer measuring 5 mm x 5 mm and 200 $\mu$m in thickness. Thereafter, the assembly was held at 500°C for 30 min, to sinter the $TiO_2$ particulates on the FTO layer. A 0.1 M aqueous solution of titanium(IV) chloride $TiCl_4$ was dropped onto the sintered $TiO_2$ film, then the assembly was held at room temperature for 15 hours, was washed, and was subjected again to calcination at 500°C for 30 min. Thereafter, the sintered $TiO_2$ body was irradiated with UV light for 30 minutesby use of a UV irradiation apparatus, whereby a treatment for removing impurities such as organic matter contained in the sintered $TiO_2$ body through oxidative decomposition by the photocatalytic action of $TiO_2$ was conducted, to obtain a porous photoelectrode 3.

Next, a zirconia paste for screen printing, prepared from a commercial zirconia dispersion by solvent replacement to terpineol and subsequent adjustment of viscosity to a predetermined viscosity by use of ethyl cellulose, was applied to the porous photoelectrode 3 in a length of 41 mm, a width of 5.5 mm and a thickness of 10 $\mu$m. The zirconia paste film thus obtained was dried, and was calcined in an electric furnace at 500 °C for 30 min. In this way, a porous

insulating layer 4 was formed.

Subsequently, a carbon paste containing a carbon powder was applied to the porous insulating layer 4.

Next, a 0.05 mm-thick, rectangular Ti foil provided with a multiplicity of circular openings in a matrix arrangement so as to have an open area ratio of 5% was adhered onto the carbon paste. An optical microphotograph of the Ti foil is shown in FIG- 7.

Subsequently, the carbon paste was calcined at 480°C, to form a carbon counter electrode 5.

In 50 ml of a mixed solvent prepared by mixing acetonitrile and tert-butanol in a volume ratio of 1:1, 23.8 mg of sufficiently purified Z907 as photosensitizing dye was dissolved, to prepare a photosensitizing dye solution.

Incidentally, in the case of using Z907 and Dye A as photosensitizing dyes, 23.8 mg of sufficiently purified Z907 and 2.5 mg of Dye A are dissolved in 50 ml of the mixed solvent prepared by mixing acetonitrile and tert-butanol in a volume ratio of 1:1, to thereby prepare a photosensitizing dye solution.

Next, in the photosensitizing dye solution prepared as above, the porous photoelectrode 3 was immersed at room temperature for 24 hours, to hold the photosensitizing dye(s) on the surfaces of $TiO_2$ particulates. Subsequently, the porous photoelectrode 3 was cleaned sequentially with an acetonitrile solution of 4-tert-butylpyridine and with acetonitrile, thereafter the solvents were evaporated off in a dark place, and the porous photoelectrode 3 was dried.

In 3 g of methoxyacetonitrile were dissolved 0.045 g of sodium iodide (NaI) , 1.11 g of I-propyl-2,3-dimethylimidazolium iodide, 0.11 g of iodine ($I_2$), and 0.081 g of 4-tert-butylpyridine, to prepare an electrolyte solution.

Subsequently, the glass substrate provided with the porous photoelectrode 3, the porous insulating layer 4, the carbon counter electrode 5 and the current collector 6 was immersed in the thus prepared electrolyte solution, to impregnate the porous photoelectrode 3, the porous insulating layer 4 and the carbon counter electrode 5 with the electrolyte solution.

<Example 2>

A dye-sensitized photoelectric conversion element was manufactured in the same manner as in Example 1, except that an oblique grating-formed Ti expanded metal as shown in FIG. 8 was used as the current collector 6, the Ti expanded metal having an open area ratio of 80%.

<Comparative Example 1>

A dyes-sensitized photoelectric conversion element was manufactured in the same manner as in Example 1, except that no current collector 6 was formed on the carbon counter electrode 5.

FIG. 9 shows current-voltage characteristic, for the dye-sensitized photoelectric conversion elements obtained in Examples 1 and 2 and Comparative Example 1. Measurement was carried out by irradiating the dye-sensitized photoelectric conversion element with pseudo-sunlight (artificial, or simulated, solar radiation) (AM 1.5, 100 $mW/cm^2$) . Table 1 shows open-circuit voltage $V_{oc}$, current density $J_{sc}$, fill factor (FF), photoelectric conversion efficiency Eff and internal resistance $R_s$, for these dye-sensitized photoelectric conversion elements. From Table 1 it is seen that the photoelectric conversion efficiencies attained in Examples 1 and 2 are higher by not less than about 0.55%, as compared with that attained in Comparative Example 1, in which no current collector 6 was formed on the carbon counter electrode 5. It is also seen that the internal resistances in Examples 1 and 2 are lower by not less than 12 Ω, as compared with that in Comparative Example 1. The reason why such lower internal resistances were obtained in Examples 1 and 2 resides in that, since the current collector 6 was formed on the carbon counter electrode 5, the substantial sheet resistance of the carbon counter electrode 5 was reduced by about 10 Ω. Incidentally, the reason why the current value in Example 1 was lower as shown in FIG. 9 is considered to lie in that permeation of the photosensitizing dye solution was somewhat reduced because the permeation of the photosensitizing dye was permitted to take place through the openings 6a formed in the current collector 6.

[Table 1]

| Sample | Voc (V) | Jsc ($mA/cm^2$) | FF (%) | Eff (%) | Rs (Ω) |
|---|---|---|---|---|---|
| Example 1 | 0.702 | 16.59 | 67.6 | 7.88 | 38.66 |
| Example 2 | 0.701 | 17.06 | 67.3 | 8.05 | 37.17 |
| Comp.Ex. 1 | 0.701 | 17.20 | 60.8 | 7.33 | 51.16 |

Thus, according to the first embodiment, the current collector 6 is formed on the carbon counter electrode 5 and, therefore, the substantial sheet resistance of the carbon counter electrode 5 can be greatly reduced. Accordingly,

the internal resistance of the dye-sensitized photoelectric conversion element can be largely lowered, and a high photoelectric conversion efficiency can be obtained.

<2. Second Embodiment>

[Dye-sensitized photoelectric conversion element]

FIG. 10 is a major-part sectional view showing a dye-sensitized photoelectric element of a monolithic structure according to a second embodiment of the present technology.

As shown in FIG. 10, in this dye-sensitized photoelectric conversion element, transparent conductive layers 2a and 2b each having a predetermined plan view shape are provided on a principal surface of a transparent substrate 1, in the state of being separate from each other. A porous photoelectrode 3 is provided on the transparent conductive layer 2a. One kind or a plurality of kinds of photosensitizing dyes (not shown) are bonded to the porous photoelectrode 3. A porous insulating layer 4 is formed to extend in the manner of covering an upper surface and a side surface of the porous photoelectrode 3, and to make contact with the transparent substrate 1 in an area between the transparent conductive layers 2a and 2b. A carbon counter electrode 5 is provided on the porous insulating layer 4. At least the porous photoelectrode 3 and the porous insulating layer 4, preferably the porous photoelectrode 3, the porous insulating layer 4 and the carbon counter electrode 5, are impregnated with an electrolyte solution. A current collector 6 is adhered onto the carbon counter electrode 5 in the state of being electrically connected to the carbon counter electrode 5. The current collector 6 is bent in the vicinity of side surfaces of the carbon counter electrode 5 and the porous photoelectrode 3, extends on the transparent conductive layer 2b, and is electrically connected to the transparent conductive layer 2b by being adhered to the transparent conductive layer 2b with a conductive adhesive 7. The current collector 6 is preferably formed from a metal or alloy; particularly preferably, a foil of a metal or alloy is used as the current collector 6.

Though omitted in the drawing, typically, a sealing material (not shown) is provided on the substrate 1 in the manner of surrounding the peripheries of the porous photoelectrode 3, the porous insulating layer 4, the carbon counter electrode 5 and the current collector 6, and a transparent sealing plate is mounted on the upper side of the carbon counter electrode 5. The porous photoelectrode 3, the porous insulating layer 4, the carbon counter electrode 5 and the current collector 6 are sealed by the sealing material and the sealing plate.

[Method of manufacturing dye-sensitized photoelectric conversion element]

Now, a method of manufacturing this dye-sensitized photoelectric conversion element will be described below.

First, a process is progressed in the same manner as in the first embodiment to form the components up to the porous insulating layer 4, as shown in FIG. 11A. On the transparent conductive layer 2b is formed a layer of a conductive adhesive 7.

Next, the transparent substrate 1 provided with the porous photoelectrode 3 and the porous insulating layer 4 is immersed in a photosensitizing dye solution prepared by dissolving a photosensitizing dye(s) in a predetermined solvent, to bond the photosensitizing dye(s) to the porous photoelectrode 3.

On the other hand, an assembly wherein a current collector 6 is formed on a surface on one side of a carbon counter electrode 5 is prepared. The current collector 6 is larger than the carbon counter electrode 5, and is protruding to the outside of the carbon counter electrode 5.

Subsequently, as shown in FIG. 11B, the carbon counter electrode 5 side of the assembly having the current collector 6 formed on the surface on one side of the carbon counter electrode 5 is adhered to the porous insulating layer 4.

Next, as shown in FIG. 10, that portion of the current collector 6 which is protruding to the outside of the carbon counter electrode 5 is bent, and a tip part of the portion is adhered to the transparent conductive layer 2b with the conductive adhesive 7. Bending of the current collector 6 can be carried out, for example, by a method in which that portion of the current collector 6 which is protruding to the outside of the carbon counter electrode 5 is pressed from above by use of a jig (not shown) or the like.

Thereafter, sealing and impregnation with an electrolyte solution and the like are performed in the same manner as in the first embodiment.

In this manner, the desired dye-sensitized photoelectric conversion element of the monolithic structure is manufactured.

<Example 3>

A 50 $\mu$m-thick Ti foil was used as a current collector 6, and a carbon paste was applied thereto, to form a carbon counter electrode 5. As a conductive adhesive 7, a UV curing resin loaded with Ti powder was used. Then, that portion of the current collector 6 which was protruding to the outside of the carbon counter electrode 5 was bent, and a

tip part of the portion was adhered to the conductive adhesive 7. In this condition, the assembly was irradiated with UV rays from the back side of a glass substrate prepared as a transparent substrate 1, to cure the conductive adhesive 7. In the same manner as in Example 1 except for the just-mentioned points, a dye-sensitized photoelectric conversion element was manufactured.

<Comparative Example 2>

A dye-sensitized photoelectric conversion element was manufactured in the same manner as in Example 3, except that no current collector 6 is formed on the carbon counter electrode 5.

The dye-sensitized photoelectric conversion elements obtained in Example 3 and Comparative Example 2 were put to measurement of current-voltage characteristic. The measurement was carried out by irradiating the dye-sensitized photoelectric conversion element with pseudo-sunlight (AM 1.5, 100 mW/cm$^2$). Table 2 shows open-circuit voltage $V_{oc}$, current density $J_{sc}$, fill factor (FF) , photoelectric conversion efficiency Eff and internal resistance $R_s$, for these dye-sensitized photoelectric conversion elements. From Table 2 it is seen that the photoelectric conversion efficiency attained in Example 3 is higher by not less than about 0.7%, as compared with that attained in Comparative Example 2, in which no current collector 6 was formed on the carbon counter electrode 5. It is also seen that the internal resistance in Example 3 is lower by not less than about 15 Ω, as compared with that in Comparative Example 2. The reason why the lower internal resistance was obtained in Example 3 resides in that, since the current collector 6 was formed on the carbon counter electrode 5, the substantial sheet resistance of the carbon counter electrode 5 was reduced by about 10 Ω.

[Table 2]

| Sample | Voc (V) | Jsc (mA/cm$^2$) | FF (%) | Eff (%) | Rs (Ω) |
|---|---|---|---|---|---|
| Example 3 | 0.698 | 15.50 | 68.2 | 7.38 | 40.23 |
| Comp.Ex. 2 | 0.689 | 15.57 | 61.9 | 6.63 | 54.79 |

Thus, according to the second embodiment, the current collector 6 is adhered onto the carbon counter electrode 5 in the state of being electrically connected to the carbon counter electrode 5, and, therefore, the substantial sheet resistance of the carbon counter electrode 5 can be greatly reduced. Accordingly, the internal resistance of the dye-sensitized photoelectric conversion element can be largely lowered, and a high photoelectric conversion efficiency can be obtained. In addition, since the current collector 6 is adhered to the transparent conductive layer 2b with the conductive adhesive 7, the bond strength between the current collector 6 and the transparent conductive layer 2b is high, so that the dye-sensitized photoelectric conversion element is high in life and reliability. Further, since the adsorption of the photosensitizing dye(s) onto the porous photoelectrode 3 can be performed prior to the formation of the carbon counter electrode 5, adsorption of the photosensitizing dye(s) onto the carbon counter electrode 5 can be obviated, which promises enhancement of the photoelectric conversion efficiency of the dye-sensitized photoelectric conversion element.

<3. Third Embodiment>

[Dye-sensitized photoelectric conversion element]

FIG. 12 is a major-part sectional view showing a dye-sensitized photoelectric conversion element of a monolithic structure according to a third embodiment of the present technology.

As shown in FIG. 12, in this dye-sensitized photoelectric conversion element, transparent conductive layers 2a and 2b each having a predetermined plan view shape are provided on a principal surface of a transparent substrate 1, in the state of being separate from each other. A porous photoelectrode 3 is provided on the transparent conductive layer 2a. Once kind of or a plurality of kinds of photosensitizing dyes (not shown) are bonded to the porous photoelectrode 3. A porous insulating layer 4 is formed to extend in the manner of covering an upper surface and a side surface of the porous photoelectrode 3, and to make contact with the transparent substrate 1 in an area between the transparent conductive layers 2a and 2b. A carbon counter electrode 5 is provided to extend in such a manner as to cover an upper surface and a side surface of the porous insulating layer 4. At least the porous photoelectrode 3 and the porous insulating layer 4, preferably the porous photoelectrode 3, the porous insulating layer 4 and the carbon counter electrode 5, are impregnated with an electrolyte solution. A current collector 6 is provided integrally on the carbon counter electrode 5 over the range from an upper surface to a side surface of the carbon counter electrode 5 and in the state of being electrically connected to the carbon counter electrode 5. An end portion of the current collector 6 extends onto the transparent conductive layer 2b, and is electrically connected to the transparent conductive layer 2b by being adhered

to the latter with a conductive adhesive 7. The current collector 6 is preferably formed of a metal or alloy; particularly preferably, a foil of a metal or alloy is used as the current collector 6.

Though omitted in the drawing, typically, a sealing material (not shown) is provided on the substrate 1 in the manner of surrounding the peripheries of the porous photoelectrode 3, the porous insulating layer 4, the carbon counter electrode 5 and the current collector 6, and a transparent sealing plate is mounted on the upper side of the carbon counter electrode 5. The porous photoelectrode 3, the porous insulating layer 4, the carbon counter electrode 5 and the current collector 6 are sealed by the sealing material and the sealing plate.

[Method of manufacturing dye-sensitized photoelectric conversion element]

Now, a method of manufacturing this dye-sensitized photoelectric conversion element will be described below.

First, a process is progressed in the same manner as in the first embodiment, to form the components up to the porous insulating layer 4, as shown in FIG. 13A. On the transparent conductive layer 2b is formed a layer of a conductive adhesive 7.

Next, the transparent substrate 1 provided with the porous photoelectrode 3 and the porous insulating layer 4 is immersed in a photosensitizing dye solution prepared by dissolving a photosensitizing dye(s) in a predetermined solvent, to bond the photosensitizing dye(s) to the porous photoelectrode 3.

On the other hand, an assembly wherein a current collector 6 is formed on a surface on one side of a carbon counter electrode 5 is prepared. The current collector 6 is larger than the carbon counter electrode 5, and is protruding to the outside of the carbon counter electrode 5. FIG. 13B shows a plan view of the assembly wherein the current collector 6 is formed on the surface on one side of the carbon counter electrode 5.

Subsequently, the carbon counter electrode 5 side of the assembly having the current collector 6 formed on the surface on one side of the carbon counter electrode 5 is adhered to the porous insulating layer 4, and the current collector 6 is pressed so as to deform the carbon counter electrode 5 and the current collector 6 in such a manner as to cover an upper surface and a side surface of the porous insulating layer 4. Then, that portion of the current collector 6 which is protruding to the outside of the carbon counter electrode 5 is adhered to the transparent conductive layer 2b with a conductive adhesive 7.

Thereafter, sealing and impregnation with an electrolyte solution and the like are performed in the same manner as in the first embodiment.

In this manner, the desired dye-sensitized photoelectric conversion element of the monolithic structure is manufactured.

<Example 4>

A 50 μm-thick Ti foil was used as a current collector 6, and a carbon paste was adhered thereto, to form a carbon counter electrode 5. As a conductive adhesive 7, a UV curing resin loaded with Ti powder was used. Then, that portion of the current collector 6 which was protruding to the outside of the carbon counter electrode 5 was bent, and a tip part of the portion was adhered to the conductive adhesive 7. In this condition, the assembly was irradiated with UV rays from the back side of a glass substrate prepared as a transparent substrate 1, to cure the conductive adhesive 7. In the same manner as in Example 1 except for the just-mentioned points, a dye-sensitized photoelectric conversion element was manufactured.

<Comparative Example 3>

A dye-sensitized photoelectric conversion element was manufactured in the same manner as in Example 4, except that no current collector 6 is formed on the carbon counter electrode 5.

The dye-sensitized photoelectric conversion elements obtained in Example 4 and Comparative Example 3 were put to measurement of current-voltage characteristic. The measurement was carried out by irradiating the dye-sensitized photoelectric conversion element with pseudo-sunlight (AM 1.5, 100 $mW/cm^2$). Table 3 shows open-circuit voltage $V_{oc}$, current density $J_{sc}$, fill factor (FF), photoelectric conversion efficiency Eff and internal resistance $R_s$, for these dye-sensitized photoelectric conversion elements. From Table 3 it is seen that the photoelectric conversion efficiency attained in Example 4 is higher by not less than 1%, as compared with that attained in Comparative Example 3, in which no current collector 6 was formed on the carbon counter electrode 5. It is also seen that the internal resistance in Example 4 is lower by not less than about 15 S2, as compared with that in Comparative Example 3. The reason why the lower internal resistance was obtained in Example 4 lies in that, since the current collector 6 was formed on the carbon counter electrode 5, the substantial sheet resistance of the carbon counter electrode 5 was reduced by about 10 Ω.

[Table 3]

| Sample | Voc (V) | Jsc (mA/cm$^2$) | FF (%) | Eff (%) | Rs (Ω) |
|---|---|---|---|---|---|
| Example 4 | 0.623 | 15.23 | 57.3 | 5.44 | 60.36 |
| Comp.Ex. 3 | 0.574 | 15.20 | 49.1 | 4.28 | 75.49 |

Thus, according to the third embodiment, the current collector 6 is adhered onto the carbon counter electrode 5 in the state of being electrically connected to the carbon counter electrode 5, and, therefore, the substantial sheet resistance of the carbon counter electrode 5 can be greatly reduced. Accordingly, the internal resistance of the dye-sensitized photoelectric conversion element can be largely lowered, and a high photoelectric conversion efficiency can be obtained. Besides, since the current collector 6 is adhered to the transparent conductive layer 2b with the conductive adhesive 7, the bond strength between the current collector 6 and the transparent conductive layer 2b is high, so that the dye-sensitized photoelectric conversion element is high in life and reliability. Furthermore, since the adsorption of the photosensitizing dye(s) onto the porous photoelectrode 3 can be performed prior to the formation of the carbon counter electrode 5, adsorption of the photosensitizing dye(s) onto the carbon counter electrode 5 can be avoided, which promises enhancement of the photoelectric conversion efficiency of the dye-sensitized photoelectric conversion element.

<fourth Embodiment>

[Dye-sensitized photoelectric conversion element]

FIG. 14 is a major-part sectional view showing a dye-sensitized photoelectric conversion element of a monolithic structure according to a fourth embodiment of the present technology.

As shown in FIG. 14, in this dye-sensitized photoelectric conversion element, transparent conductive layers 2a and 2b each having a predetermined plan view shape are provided on a principal surface of a transparent substrate 1, in the state of being separate from each other. A porous photoelectrode 3 is provided on the transparent conductive layer 2a. One kind or a plurality of kinds of photosensitizing dyes (not shown) are bonded to the porous photoelectrode 3. A porous insulating layer 4 is formed to extend in the manner of covering an upper surface and a side surface of the porous photoelectrode 3, and to make contact with the transparent substrate 1 in an area between the transparent conductive layers 2a and 2b. A carbon counter electrode 5 is provided to extend in such a manner as to cover an upper surface and a side surface of the porous insulating layer 4, and is electrically connected to the transparent conductive layer 2b. At least the porous photoelectrode 3 and the porous insulating layer 4, preferably the porous photoelectrode 3, the porous insulating layer 4 and the carbon counter electrode 5, are impregnated with an electrolyte solution. A current collector 6 is provided integrally on the carbon counter electrode 5 in the state of being electrically connected to the carbon counter electrode 5. The current collector 6 is preferably formed from a metal or alloy; particularly preferably, a foil of a metal or alloy is used as the current collector 6.

Though omitted in the drawing, typically, a sealing material (not shown) is provided on the transparent substrate 1 in such a manner as to surround the peripheries of the porous photoelectrode 3, the porous insulating layer 4, the carbon counter electrode 5 and the current collector 6. In addition, a transparent sealing plate (not shown) is mounted on the upper side of the carbon counter electrode 5. The porous photoelectrode 3, the porous insulating layer 4, the carbon counter electrode 5 and the current collector 6 are sealed by the sealing material and the sealing plate.

[Method of manufacturing dye-sensitized photoelectric conversion element]

Now, a method of manufacturing this dye-sensitized photoelectric conversion element will be described below.

First, a process is progressed in the same manner as in the first embodiment to form the components up to the carbon counter electrode 5, as shown in FIG. 14.

Next, a current collector 6 is adhered to an upper surface of the carbon counter electrode 5.

Thereafter, adsorption of a photosensitizing dye(s) onto the porous photoelectrode 3, sealing, impregnation with an electrolyte solution and the like are performed in the same manner as in the first embodiment.

In this manner, the desired dye-sensitized photoelectric conversion element of the monolithic structure is manufactured.

<Example 5>

A dye-sensitized photoelectric conversion element was manufactured in the same manner as in Example 1,

except that a 50 μm-thick Ti foil was used as the current collector 6.

<Comparative Example 4>

A dye-sensitized photoelectric conversion element was manufactured in the same manner as in Example 5, except that no current collector 6 was formed on the carbon counter electrode 5.

The dye-sensitized photoelectric conversion elements obtained in Example 5 and Comparative Example 4 were put to measurement of current-voltage characteristic. The measurement was carried out by irradiating the dye-sensitized photoelectric conversion element with pseudo-sunlight (AM 1.5, 100 $mW/cm^2$) . Table 4 shows open-circuit voltage $V_{oc}$, current density Jsc fill factor (FF) , photoelectric conversion efficiency Eff and internal resistance $R_s$, for these dye-sensitized photoelectric conversion elements. From Table 4 it is seen that the photoelectric conversion efficiency attained in Example 5 is higher by not less than 0.2%, as compared with that attained in Comparative Example 4, in which no current collector 6 was formed on the carbon counter electrode 5. It is also seen that the internal resistance in Example 5 is lower by not less than about 7 Ω, as compared with that in Comparative Example 4. The reason why the lower internal resistance was obtained in Example 5 lies in that, since the current collector 6 was formed on the carbon counter electrode 5, the substantial sheet resistance of the carbon counter electrode 5 was reduced by about 10 Ω.

[Table 4]

| Sample | Voc (V) | Jsc ($mA/cm^2$) | FF (%) | Eff (%) | Rs (Ω) |
|---|---|---|---|---|---|
| Example 5 | 0.701 | 14.66 | 59.2 | 6.07 | 65.56 |
| Example 6 | 0.700 | 14.68 | 60.6 | 6.23 | 62.21 |
| Comp.Ex. 4 | 0.705 | 14.79 | 56.5 | 5.89 | 73.00 |

Thus, according to the fourth embodiment, the current collector 6 is adhered onto the carbon counter electrode 5, and, therefore, the substantial sheet resistance of the carbon counter electrode 5 can be greatly reduced. Accordingly, the internal resistance of the dye-sensitized photoelectric conversion element can be largely lowered, and a high photoelectric conversion efficiency can be obtained.

<5. Fifth Embodiment>

[Dye-sensitized photoelectric conversion element]

FIG. 15 is a major-part sectional view showing a dye-sensitized photoelectric conversion element of a monolithic structure according to a fifth embodiment of the present technology.

As shown in FIG. 15, in this dye-sensitized photoelectric conversion element, transparent conductive layers 2a and 2b each having a predetermined plan view shape are provided on a principal surface of a transparent substrate 1, in the state of being separate from each other. A porous photoelectrode 3 is provided on the transparent conductive layer 2a. One kind or a plurality of kinds of photosensitizing dyes (not shown) are bonded to the porous photoelectrode 3. A porous insulating layer 4 is formed to extend in the manner of covering an upper surface and a side surface of the porous photoelectrode 3, and to make contact with the transparent substrate 1 in an area between the transparent conductive layers 2a and 2b. A carbon counter electrode 5 is provided to extend in such a manner as to cover an upper surface and a side surface of the porous insulating layer 4, and is electrically connected to the transparent conductive layer 2b. At least the porous photoelectrode 3 and the porous insulating layer 4, preferably the porous photoelectrode 3, the porous insulating layer 4 and the carbon counter electrode 5, are impregnated with an electrolyte solution.

A sealing material 8 is provided on the transparent substrate 1 in such a manner as to surround the peripheries of the porous photoelectrode 3, the porous insulating layer 4 and the carbon counter electrode 5, and a sealing plate 9, which is preferably transparent, is mounted on the upper side of the sealing material 8. A current collector 6 is provided on that surface of the sealing plate 9 which is on the side of the carbon counter electrode 5. The current collector 6 is in contact with the carbon counter electrode 5. The current collector 6 is preferably formed from a metal or alloy; particularly preferably, a foil of a metal or alloy is used as the current collector 6. The porous photoelectrode 3, the porous insulating layer 4, the carbon counter electrode 5 and the current collector 6 are sealed by the sealing material 8 and the sealing plate 9.

[Method of manufacturing dye-sensitized photoelectric conversion element]

Now, a method of manufacturing this dye-sensitized photoelectric conversion element will be described below.
First, a process is progressed in the same manner as in the first embodiment to form the components up to the carbon counter electrode 5, as shown in FIG. 16, and further to effect adsorption of a dye-sensitizing dye(s) onto the porous photoelectrode 3.
On the other hand, an assembly wherein a current collector 6 is formed on a surface on one side of a sealing plate 9 is prepared. The current collector 6 can be formed by a method in which a foil of a metal or alloy is adhered to a surface on one side of the sealing plate 9, or a method in which a film of a metal or alloy is formed on a surface on one side of the sealing plate 9 by vacuum evaporation, sputtering or the like.
Next, the current collector 6 side of the assembly having the current collector 6 formed on the surface on one side of the sealing plate 9 is mounted on a sealing material 8, to conduct sealing, and the current collector 6 is adhered to the carbon counter electrode 5.
Thereafter, impregnation with an electrolyte solution and the like are performed in the same manner as in the first embodiment.
In this manner, the desired dye-sensitized photoelectric conversion element of the monolithic structure is manufactured.

<Example 6>

A 50 μm-thick Ti foil was used as a current collector 6, and the Ti foil was adhered to a surface on one side of a transparent glass plate. A layer of a sealing material 8 was formed in such a manner as to surround the peripheries of a porous photoelectrode 3, a porous insulating layer 4 and a carbon counter electrode 5. Thereafter, the assembly having the Ti foil adhered to the surface on one side of the transparent glass plate was mounted the sealing material 8, to perform sealing, and the Ti foil is put into contact with the carbon counter electrode 5. In the same manner as in Example 1 except for the just-mentioned points, a dye-sensitized photoelectric conversion element was manufactured.
The dye-sensitized photoelectric conversion element obtained in Example 6 was put to measurement of current-voltage characteristic. The measurement was carried out by irradiating the dye-sensitized photoelectric conversion element with pseudo-sunlight (AM 1.5, 100 mW/cm$^2$) - Table 4 shows open-circuit voltage $V_{oc}$, current density $J_{sc}$, fill factor (FF), photoelectric conversion efficiency Eff and internal resistance $R_s$, of this dye-sensitized photoelectric conversion element. From Table 4 it is seen that the photoelectric conversion efficiency attained in Example 6 is higher by not less than 0.3%, as compared with that attained in Comparative Example 4, in which no current collector 6 was formed on the carbon counter electrode 5. It is also seen that the internal resistance in Example 6 is lower by not less than about 10 Ω, as compared with that in Comparative Example 4. The reason why the lower internal resistance was obtained in Example 6 lies in that, since the current collector 6 was formed on the carbon counter electrode 5, the substantial sheet resistance of the carbon counter electrode 5 was reduced by about 10 Ω.
Thus, according to the fifth embodiment, the current collector 6 formed on the surface on one side of the sealing plate 9 is put in contact with the carbon counter electrode 5, and, therefore, the substantial sheet resistance of the carbon counter electrode 5 can be greatly reduced. Accordingly, the internal resistance of the dye-sensitized photoelectric conversion element can be largely lowered, and a high photoelectric conversion efficiency can be obtained.

<6. Sixth Embodiment>

[Method of manufacturing dye-sensitized photoelectric conversion element]

A method of manufacturing a dye-sensitized photoelectric conversion element of a monolithic structure according to a sixth embodiment of the present technology will be described.
First, a process is progressed in the same manner as in the first embodiment to form the components up to the carbon counter electrode 5, as shown in FIG. 17, and further to effect adsorption of a photosensitizing dye(s) onto the porous photoelectrode 3. A layer of a conductive adhesive 7 is formed on the transparent conductive layer 2b.
Next, a current collector 6 is prepared. The current collector 6 is greater than the carbon counter electrode 5. The current collector 6 is adhered to the carbon counter electrode 5. Subsequently the current collector 6 is bent and is electrically connected to the transparent conductive layer 2b through the conductive adhesive 7.
Thereafter, sealing, impregnation with an electrolyte solution and the like are carried out in the same manner as in the first embodiment.
In this manner, the desired dye-sensitized photoelectric conversion element of the monolithic structure is manufactured.
According to the sixth embodiment, the current collector 6 is formed on the carbon counter electrode 5, and,

therefore, the substantial sheet resistance of the carbon counter electrode 5 can be reduced greatly. Accordingly, the internal resistance of the dye-sensitized photoelectric conversion element can be largely reduced, and a high photoelectric conversion efficiency can be obtained.

<7. Seventh Embodiment>

[Dye-sensitized photoelectric conversion element module]

FIG. 18 is a major-part sectional view showing a dye-sensitized photoelectric conversion element module of a monolithic structure according to a seventh embodiment of the present technology.

As shown in FIG. 18, in this dye-sensitized photoelectric conversion element module, a plurality of transparent conductive layers 2 each having a predetermined plan view shape are provided respectively in a plurality of regions on a principal surface of a transparent substrate 1,in the state of being separate from one another. For instance, transparent conductive layers 2 in striped plan view shape are formed in parallel to one another. A porous photoelectrode 3, a porous insulating layer 4 and a carbon counter electrode 5 are sequentially layered on a part, on one lateral side, of each of the transparent conductive layers 2, to constitute a dye-sensitizing photoelectric conversion element. The porous photoelectrode 3 has one kind or a plurality of kinds of photosensitizing dyes (not shown) bonded thereto. At least the porous photoelectrodes 3 and the porous insulating layers 4, preferably the porous photoelectrodes 3, the porous insulating layers 4 and the carbon counter electrodes 5, are impregnated with an electrolyte solution. A current collector 6 is adhered onto each of the carbon counter electrodes 5 in the state of being electrically connected to the carbon counter electrode 5. The current collectors 6 are preferably formed from a metal or alloy; particularly preferably, foils of a metal or alloy are used as the current collectors 6. Each of the current collectors 6 is bent at a corner portion of the carbon counter electrode 5, and is electrically connected to one end portion of a part, on one lateral side where none of the porous photoelectrode 3 and the porous insulating layer 4 and the carbon counter electrode 5 is formed, of the transparent conductive layer 2 adjacent to the transparent conductive layer 2 provided thereon with the carbon counter electrode 5. The current collector 6 is adhered to the transparent conductive layer 2 through a conductive adhesive, and is thereby electrically connected to the transparent conductive layer 2. Thus, the carbon counter electrode 5 of each dye-sensitized photoelectric conversion element is connected to the transparent conductive layer 2 of the adjacent dye-sensitized photoelectric conversion element. In this manner, the plurality of dye-sensitized photoelectric conversion elements are electrically connected in series with one another. The number of the dye-sensitized photoelectric conversion elements connected in series is selected, as appropriate.

In FIG. 18, there is established a relationship of $a > b+c$, where a is the spacing between one set of the porous photoelectrode 3, the porous insulating layer 4 and the carbon counter electrode 5 formed over the transparent conductive layer 2 and the adjacent set; b is the total thickness of the porous photoelectrode 3, the porous insulating layer 4 and the carbon counter electrode 5; and c is the width of bonding between the current collector 6 and the transparent conductive layer 2. Typically, the values of b and c are selected, for example, so that $b > 0.02a$ and $c > 0.05a$, but these are non-limitative.

Though omitted in the drawing, typically, a sealing material (not shown) is provided in such a manner as to surround the peripheries of the porous photoelectrode 3, the porous insulating layer 4, the carbon counter electrode 5 and the current collector 6 of each of the dye-sensitized photoelectric conversion elements. In addition, a sealing plate (not shown), which is preferably transparent, is mounted on the upper side of each of the carbon counter electrodes 5. The porous photoelectrode 3, the porous insulating layer 4, the carbon counter electrode 5 and the current collector 6 are sealed by the sealing material and the sealing plate.

[Method of manufacturing dye-sensitized photoelectric conversion element module]

Now, a method of manufacturing this dye-sensitized photoelectric conversion element module will be described below.

First, as shown in FIG. 19, a structure having porous photoelectrodes 3, porous insulating layers 4 and carbon counter electrodes 5 sandwiched (in this order from the side of a transparent substrate 1) between a transparent conductive layer 2 formed on the transparent substrate 1 and a foil-formed current collector 6, is formed. This structure can be formed by any of various methods. For example, in a first method, as shown in FIG. 20A, a current collector 6 is adhered to an assembly in which porous photoelectrodes 3, porous insulating layers 4 and carbon counter electrodes 5 are sequentially layered over transparent conductive layers 2 formed on a transparent substrate 1. In a second method, as shown in FIG. 20B, the porous photoelectrode 3 side of an assembly in which carbon counter electrodes 5, porous insulating layers 4 and porous photoelectrodes 3 are sequentially layered on a surface on one side of a current collector 6 is adhered to transparent conductive layers 2 formed on a transparent substrate 1. In a third method, as shown in FIG. 20C, porous insulating layers 4 of an assembly in which porous photoelectrodes 3 and the porous insulating layers 4

are sequentially layered over transparent conductive layers 2 formed on a transparent substrate 1 and carbon counter electrodes 5 formed on a surface on one side of a current collector 6 are adhered to each other.

Next, as shown in FIG. 21, cutting of the current collector 6 (laser scribing) is conducted by radiating a laser beam to the current collector 6 at each position corresponding to a one-side surface of each set of the carbon counter electrode 5, the porous insulating layer 4 and the porous photoelectrode 3. As shown in FIG. 22, upon the laser scribing, the cut portions of the current collector 6 become free ends of the current collectors 6, which are in a cantilever state, and needless portions of the current collector 6 are removed.

Subsequently, that portion of each of the current collectors 6 which is protruding to the outside of the carbon counter electrode 5 is bent, and is connected to the transparent conductive layer 2 with a conductive adhesive.

Next, the transparent substrate 1 provided with the porous photoelectrodes 3, the porous insulating layers 4, the carbon counter electrodes 5 and the current collectors 6 is immersed in a photosensitizing dye solution prepared by dissolving a photosensitizing dye(s) in a predetermined solvent, to bond the photosensitizing dye(s) to the porous photoelectrodes 3.

Subsequently, a layer of a sealing material is formed so as to surround the peripheries of the porous photoelectrode 3, the porous insulating layer 4, the carbon counter electrode 5 and the current collector 6 of each of the dye-sensitized photoelectric conversion elements, and, in addition, a sealing plate (which is preferably transparent) is mounted on the upper side of the carbon counter electrode 5, to perform sealing.

Thereafter, an electrolyte solution is poured into the resulting assembly via a pouring hole preliminarily formed in the sealing plate, to impregnate the porous photoelectrodes 3, the porous insulating layers 4 and the carbon counter electrodes 5 with the electrolyte solution.

In this manner, the desired dye-sensitized photoelectric conversion element module of the monolithic structure is manufactured.

<Example 7>

In the same manner as in Example 1, porous photoelectrodes 3 each composed of sintered body of $TiO_2$ and porous insulating layers 4 each composed of zirconia were sequentially formed over FTO layers each formed as a transparent conductive layer 2 on a glass substrate. Films of a Ti powder-loaded. UV curing resin were formed in predetermined areas on the transparent conductive layer 2.

On the other hand, a 50 $\mu$m-thick Ti foil was used as a current collector 6, and a carbon paste was applied thereto, to form carbon counter electrodes 5.

Then, the porous insulating layers 4 and the carbon counter electrodes 5 were disposed to face each other, and the porous insulating layers 4 and the carbon counter electrodes 5 were adhered to each other.

Next, a laser beam 10 of $CO_2$ laser was radiated onto the current collector 6 at each position corresponding to one side surface of each set of the carbon counter electrodes 5, the carbon counter electrode 4 and the porous photoelectrode 3, thereby cutting the current collector 6.

Subsequently, that portion of each current collector 6 which was protruding to the outside of the carbon counter electrode 5 was bent, and was adhered to the conductive adhesive. In this condition, the conductive adhesive was cured by irradiating it with UV rays from the back side of the glass substrate serving as a transparent substrate 1.

In the same manner as in Example 1 except for the just-mentioned points, a dye-sensitized photoelectric conversion element module was manufactured.

Thus, according to the seventh embodiment, the current collector 6 is adhered to the carbon counter electrode 5 in the state of being electrically connected to the carbon counter electrode 5, and, therefore, the substantial sheet resistance of the carbon counter electrode 5 can be much reduced. Accordingly, the internal resistance of the dye-sensitized photoelectric conversion element module can be reduced greatly, and a high photoelectric conversion efficiency can be obtained. In addition, since the current collector 6 is adhered to the transparent conductive layer 2 with the conductive adhesive 7, the bond strength between the current collector 6 and the transparent conductive layer 2b is high, and the dye-sensitized photoelectric conversion element module is high in life and reliability.

<8. Eighth Embodiment>

[Carbon electrode]

A carbon electrode according to an eighth embodiment of the present technology contains a carbon powder, and metallic oxide particulates having a particle diameter comparable to that of the carbon powder, specifically, a particle diameter of 1 to 50 nm, preferably 25 to 50 nm, the content of the metallic oxide particulates being preferably not less than 20 at% and less than 100 at%. The metallic oxide particulates, for example, contains at least one metallic element selected from the group consisting of Ti, Sn, Sb, Zn and Al. The carbon powder contains at least one of carbon black,

carbon fiber, graphite and the like. Here, carbon black and graphite are materials which have an effect to enhance the catalytic activity for a reduction reaction of an electrolyte, principally. On the other hand, the carbon fiber has an effect to contribute to enhancement of conductivity and enhancement of film strength. Among the above-mentioned various carbon powders, joint use of carbon black and carbon fiber is desirable, from the viewpoint of enhancement of catalytic activity and enhancement of conductivity. In this case, the mixing ratio of carbon black to carbon fibers ($W_1/W_2$, where $W_1$ is the weight of carbon black, and $W_2$ is the weight of carbon fibers) is preferably selected within the range of $0.4 < W_1/W_2 \leq 1$. This ensures that the catalytic activity of the carbon electrode can be enhanced, and ensures that, in the case where the carbon electrode is formed on a transparent conductive substrate such as an FTO substrate, the carbon electrode can be prevented from peeling from the transparent conductive substrate. Besides, the addition amount (weight) $W_3$ of the above-mentioned metallic oxide particulates is generally selected within the range of $0.2 < W_3/(W_1+W_2) < 0.5$, though the amount varies depending on the mixing ratio of carbon black to carbon fiber. This ensures that a carbon electrode excellent in mechanical strength and catalytic activity can be obtained. Besides, as the metallic oxide particulates, anatase-type $TiO_2$ is used most preferably.

[Method of manufacturing carbon electrode]

Now, a method of manufacturing the carbon electrode will be described below.

First, the carbon powder and the above-mentioned metallic oxide particulates are mixed with a binder, ,o prepare a carbon paste. In this case, the carbon powder and the metallic oxide particulates are comparable in particle diameter, which enables more uniform dispersion of the carbon powder and the metallic oxide particulates. As the binder, various known ones can be used, after being appropriately selected, as appropriate.

Next, the thus prepared carbon paste is applied to a substrate, followed by calcinations. In this case, since the carbon powder and the metallic oxide particulates can be uniformly dispersed as above-mentioned, effective binding occurs during the calcinations, whereby an enhanced binding strength can be achieved. Particularly, , the case where metallic oxide particulates having a particle diameter of 25 to 50 nm is used, a greatly enhanced binding strength can be attained, as compared with the case where metallic oxide particulates having a particle diameter of less than 20 nm is used.

In this manner, the desired carbon electrode is manufactured.

A specific example of the composition of the carbon paste is as follows.

- Carbon black: 6.7 to 7.6 wt%
- Carbon fibers: 6.7 to 7.6 wt%
- $TiO_2$ particles: 5.0 to 5.4 wt%
- Ethyl cellulose: 3.5 to 3.8 wt%
- Terpineol: 70.3 to 88.3 wt%

The temperature of calcination carried out after application of the carbon paste is, for example, 450 to 500°C.

According to the eighth embodiment, it is possible to obtain a carbon electrode which is high in catalytic activity and is comparable in performance to the platinum electrodes according to the related art.

< 9 . Ninth Embodiment>

[Dye-sensitized photoelectric conversion element]

In a dye-sensitized photoelectric conversion element according to a ninth embodiment of the present technology, a dye-sensitized photoelectric conversion element according to any of the first to sixth embodiments above is adopted and manufactured in the same manner as in any of the first to sixth embodiments, except that the carbon electrode according to the eighth embodiment is used as the carbon counter electrode 6.

[Method of manufacturing dye-sensitized photoelectric conversion element]

In a method of manufacturing this dye-sensitized photoelectric conversion element, the dye-sensitized photoelectric conversion element is manufactured in the same manner as in the method of manufacturing the dye-sensitized photoelectric conversion element according to any of the first to sixth embodiment, , except that the carbon counter electrode 6 is produced in the same manner as the carbon electrode according to the eighth embodiment.

According to the ninth embodiment, since the catalytic activity of the carbon electrode used as the carbon counter electrode 6 is high, it is possible to realize a dye-sensitized photoelectric conversion element having a high photoelectric conversion efficiency.

<10. Tenth Embodiment>

[Dye-sensitized photoelectric conversion element]

FIG. 23 is a major-part sectional view showing a dye-sensitized photoelectric conversion element of a monolithic structure according to a tenth embodiment of the present technology.

As shown in FIG. 23, in this dye-sensitized photoelectric conversion element, transparent conductive layers 2a and 2b each having a predetermined plan view shape are provided on a principal surface of a transparent substrate 1, in the state of being separate from each other. A porous photoelectrode 3 is provided on the transparent conductive layer 2a. One kind or a plurality of kinds of photosensitizing dyes (not shown) are bonded to the porous photoelectrode 3. A porous insulating layer 4 is formed to extend in the manner of covering an upper surface and a side surface of the porous photoelectrode 3, and to make contact with the transparent substrate 1 in an area between the transparent conductive layers 2a and 2b. On the other hand, a conductive member 11 is provided on an end portion, on the porous insulating layer 4 side, of the transparent conductive layer 2b. The sectional shape of the conductive member 11 is, for example, a rectangle, which is non-limitative. The conductive member 11 is formed from a conductive material such as, for example, carbon. The conductive member 11 is preferably provided to have the same height as the upper surface of the porous insulating layer 4. The width of the conductive member 11 is appropriately selected as appropriate, and is, for example, in the range of 0.5 to 1 mm. A plate-shaped carbon counter electrode 5 is adhered onto the porous insulating layer 4 and the conductive member 11, in the state of being electrically connected to the conductive member 11, by use of a conductive adhesive or the like, if necessary. The carbon counter electrode 5 is electrically connected to the transparent conductive layer 2b through the conductive member 11. In the case where the carbon counter electrode 5 is adhered to the conductive member 11 by use of a conductive adhesive, a variety of adhesives can be used as the conductive adhesive, through appropriate selection, as appropriate. As the conductive adhesive, one that is excellent in resistance to electrolyte solutions is preferably used. For instance, a conductive protective coating material, an anisotropic Au paste, an Ni sheet and the like can be used. The conductive adhesive is typically provided on the conductive member 11. A current collector 6 is provided on the carbon counter electrode 5, in the state of being united with the carbon counter electrode 5. The current collector 6 is preferably formed from a metal or alloy; particularly preferably, a foil of a metal or alloy is used as the current collector 6. The size of the current collector 6 is typically selected to be equal to the size of the carbon counter electrode 5, but this is not limitative. At least the photoelectrode 3 and the porous insulating layer 4, preferably the porous photoelectrode 3, the porous insulating layer 4 and the carbon counter electrode 5, are impregnated with an electrolyte solution.

Though omitted in the drawing, typically, a sealing material (not shown) is provided on the substrate 1 in such a manner as to surround the peripheries of the porous photoelectrode 3, the porous insulating layer 4, the carbon counter electrode 5 and the current collector 6. In addition, a sealing plate, typically a transparent sealing plate, is mounted on the upper side of the current collector 6. The porous photoelectrode 3, the porous insulating layer 4, the carbon counter electrode 5 and the current collector 6 are sealed by the sealing material and the sealing plate.

[Method of manufacturing dye-sensitized photoelectric conversion element]

Now, a method of manufacturing this dye-sensitized photoelectric conversion element will be described below.

First, a process is progressed in the same manner as in the first embodiment to form the components up to the porous insulating layer 4, as shown in FIG. 24A.

Next, a conductive member 11 composed of a carbon powder-containing paste or the like is formed on the transparent conductive layer 2b by coating, printing or the like. If necessary, a layer of a conductive adhesive is formed on the conductive member 11.

Subsequently the transparent substrate 1 provided with the porous photoelectrode 3, the porous insulating layer 4 and the conductive member 11 is immersed in a photosensitizing dye solution prepared by dissolving a photosensitizing dye(s) in a predetermined solvent, whereby the photosensitizing dye(s) is bound to the porous photoelectrode 3.

On the other hand, as shown in FIG. 24B, an assembly wherein a current collector 6 is formed on a surface on one side of a carbon counter electrode 5 is prepared.

Next, as shown in FIG. 24C, the carbon counter electrode 5 side of the assembly having the current collector 6 formed on the surface on one side of the carbon counter electrode 5 is adhered onto the porous insulating layer 4 and the conductive member 11. The adhesion may be carried out, for example, ,y thermocompression bonding. If necessary, a layer of a conductive adhesive or the like is preliminarily formed on each of the porous insulating layer 4 and the conductive member 11. By this, the carbon counter electrode 5 is electrically joined to the conductive member 11.

In this manner, the desired dye-sensitized photoelectric conversion element of the monolithic structure is manufactured.

<Example 8>

In the same manner as in Example 1, a porous photoelectrode 3 and a porous insulating layer 4 were formed on an FTO layer formed as a transparent conductive layer 2a on a glass substrate.

A carbon paste was applied to the FTO layer formed as the transparent conductive layer 2b on the glass substrate, whereby a conductive member 11 was formed. The conductive member 11 was formed to have the same height as the porous insulating layer 4.

In 50 ml of a mixed solvent prepared by mixing acetonitrile with tert-butanol in a volume ratio of 1:1, was dissolved 23.8 mg of sufficiently purified Z991 as a photosensitizing dye, to prepare a photosensitizing dye solution. FIG. 25 shows the structural formula of Z991. As shown in FIG. 25, Z991 has a carboxyl group (-COOH) as a functional group for strong bonding to the porous photoelectrode 3, and the carboxyl group is bonded to the porous photoelectrode 3.

Next, the porous photoelectrode 3 was immersed in the photosensitizing dye solution prepared as above-mentioned at room temperature for 24 hours, so as to hold the photosensitizing dye on the surfaces of the $TiO_2$ particulates. Subsequently, the porous photoelectrode 3 was cleaned sequentially with an acetonitrile solution of 4-tert-butylpyridine and with acetonitrile, and thereafter the solvents were evaporated off in a dark place, followed by drying.

A 20 μm-thick Ti foil was used as a current collector 6, and a carbon paste was applied thereto, to form a carbon counter electrode 5.

Next, the carbon counter electrode 5 provided with the current collector 6 was adhered onto the porous insulating layer 4 and the conductive member 11.

In the same manner as in Example 1 except for the just-mentioned points, a dye-sensitized photoelectric conversion element was manufactured.

<Example 9>

For comparison with Example 8, a dye-sensitized photoelectric conversion element was manufactured which has a configuration similar to that in the fourth embodiment but in which a 20 μm-thick calcined Ti sheet was adhered onto the carbon counter electrode 5. As the photosensitizing dye, Z991 was used.

<Comparative Example 5>

A dye-sensitized photoelectric conversion element was manufactured in the same manner as in Example 1, except that no current collector 6 was formed on the carbon counter electrode 5 and that Z991 was used as the photosensitizing dye to be bound to the porous photoelectrode 3.

<Comparative Example 6>

A dye-sensitized photoelectric conversion element was manufactured in the same manner as in Example 1, except that no current collector 6 was formed on the carbon counter electrode 5 and that Z907 was used as the photosensitizing dye to be bound to the porous photoelectrode 3.

FIG. 26 shows current-voltage characteristics of the dye-sensitized photoelectric conversion elements obtained in Examples 8 and 9 and comparative Examples 5 and 6. The measurement was carried out by irradiating each dye-sensitized photoelectric conversion element with pseudo-sunlight (AM 1.5, 100 mW/$cm^2$). Table 5 shows open-circuit voltage $V_{oc}$, current density $J_{SC}$, fill factor (FF), photoelectric conversion efficiency Eff and internal resistance $R_S$, for these dye-sensitized photoelectric conversion elements. From Table 5 it is seen that the photoelectric conversion efficiency attained in Comparative Example 5 (in which Z991 was used as the photosensitizing dye) is lower than the photoelectric conversion efficiency attained in Comparative Example 6 (in which Z907 was used as the photosensitizing dye), but the photoelectric conversion efficiency obtained in Example 8 (in which Z991 was used as the photosensitizing dye) is higher than the photoelectric conversion efficiency attained in Comparative Example 6 by about 2.5%. The reason for this result is considered as follows.

According to the present inventors' finding, the adsorption force of Z991 on carbon is so strong that when the porous photoelectrode 3 is immersed in the photosensitizing dye solution containing Z991 after the formation of the carbon counter electrode 5, most of Z991 would be adsorbed on the carbon counter electrode 5. As a result, in this case, the amount of Z991 adsorbed onto the porous photoelectrode 3 is small. On the other hand, Z907 is weaker than Z991 in adsorption force on carbon, so that the amount of Z907 adsorbed on the carbon counter electrode 5 is smaller and, accordingly, the amount of Z907 adsorbed on the porous photoelectrode 3 is larger. This is why the photoelectric conversion efficiency attained in Comparative Example 5, in which Z991 was used as the photosensitizing dye, is lower than the photoelectric conversion efficiency attained in Comparative Example 6, in which Z907 was used as the photosensitizing dye. On the other hand, in Example 8, the carbon counter electrode 5 was mounted after the adsorption of

Z991 on the porous photoelectrode 3, so that this case is intrinsically free of the problem of adsorption of Z991 onto the carbon counter electrode 5; accordingly, a sufficient amount of Z991 can be adsorbed onto the porous photoelectrode 3. This is why the photoelectric conversion efficiency attained in Example 8, in which Z991 was used as the photosensitizing dye, is much increased as compared with the photoelectric conversion efficiency attained in Comparative Example 6.

[Table 5]

| Example | Voc (V) | JSC (mA/cm$^2$) | FF (%) | Eff (%) | Rs (Ω) |
|---|---|---|---|---|---|
| Example 8 | 0.675 | 17.94 | 66.3 | 8.03 | 37.39 |
| | 0.668 | 17.51 | 65.0 | 7.60 | 38.79 |
| | 0.675 | 18.08 | 66.5 | 8.12 | 36.06 |
| Example 9 | 0.607 | 17.28 | 54.0 | 5.67 | 61.55 |
| | 0.609 | 16.31 | 56.7 | 5.63 | 58.05 |
| | 0.608 | 16.62 | 57.5 | 5.81 | 54.59 |
| Comp.Ex. 5 | 0.614 | 17.30 | 52.7 | 5.60 | 65.35 |
| | 0.615 | 17.24 | 55.4 | 5.87 | 58.68 |
| | 0.613 | 16.74 | 56.2 | 5.76 | 58.49 |
| Comp.Ex. 6 | 0.690 | 16.47 | 59.2 | 6.72 | 55.68 |
| | 0.697 | 16.15 | 59.1 | 6.65 | 56.02 |
| | 0.697 | 16.12 | 57.9 | 6.51 | 61.55 |

Thus, according to the tenth embodiment, the carbon counter electrode 5 is formed after the adsorption of the photosensitizing dye on the porous photoelectrode 3, and, therefore, a sufficient amount of Z991 can be adsorbed on the porous photoelectrode 3 notwithstanding the use of Z991, which is liable to be adsorbed on carbon, as the photosensitizing dye. Accordingly, the performance of Z991, which originally is superior to Z907, can be displayed sufficiently and a greatly enhanced photoelectric conversion efficiency can be attained. In addition, since the current collector 6 is adhered to the carbon counter electrode 5 in the state of being electrically connected to the carbon counter electrode 5, the substantial sheet resistance of the carbon counter electrode 5 can be largely reduced, and a high photoelectric conversion efficiency can be obtained.

<11. Eleventh Embodiment>

[Dye-sensitized photoelectric conversion element module]

FIG. 27 is a major-part sectional view showing a dye-sensitized photoelectric conversion element module of a monolithic structure according to an eleventh embodiment of the present technology.

As shown in FIG. 27, in this dye-sensitized photoelectric conversion element module, a plurality of transparent conductive layers 2 each having a predetermined plan view shape are provided on a principal surface of a transparent substrate 1, in the state of being separate from one another. For example, transparent conductive layers 2 in striped plan view shape are provided in parallel to one another. A porous photoelectrode 3 is provided on a portion, on one lateral side, of each of the transparent conductive layers 2. One kind or a plurality of kinds of photosensitizing dyes (not shown) are bonded to each of the porous photoelectrodes 3. A porous insulating layer 4 is formed to extend in the manner of covering an upper surface and a side surface of each of the porous photoelectrodes 3, and to make contact with the transparent substrate 1 in an area between the transparent conductive layers 2. On the other hand, a conductive member 11 is provided on a portion, on the porous insulating layer 4 side, of each of the transparent conductive layers 2. The sectional shape of the conductive member 11 is, for example, a rectangle, which is non-limitative. The conductive members 11 are formed from a conductive material such as, for example, carbon. The conductive members 11 are preferably provided to have the same height as the upper surfaces of the porous insulating layers 4. The width of the conductive member 11 is appropriately selected as appropriate, and is in the range of 0.5 to 1 mm, for example. A plate-formed carbon counter electrode 5 is adhered onto the porous insulating layer 4 and the conductive member 11, in the state of being electrically connected to the conductive member 11, by use of a conductive adhesive or the like, as

appropriate. The carbon counter electrode 5 is electrically connected to the transparent conductive layers 2 through the conductive member 11. In the case where the carbon counter electrode 5 is adhered to the conductive member 11 by use of a conductive adhesive, any of various conductive adhesives can be used as the conductive adhesive, by being appropriately selected as appropriate. As the conductive adhesive, one that is excellent in resistance to electrolyte solutions is preferably used. For example, a conductive protecting coating material, an anisotropic Au paste, a Ni sheet and the like can be used. The conductive adhesive is typically provided on the conductive member 11. A current collector 6 is provided on the carbon counter electrode 5, in the state of being united with the carbon counter electrode 5. The current collector 6 is preferably formed from a metal or alloy; particularly preferably, a foil of a metal or alloy is used as the current collector 6. The size of the current collector 6 is typically selected to be equal to the size of the carbon counter electrode 5, but this is not limitative. At least the photoelectrodes 3 and the porous insulating layers 4, preferably the porous photoelectrodes 3, the porous insulating layers 4 and the carbon counter electrodes 5, are impregnated with an electrolyte solution. The porous photoelectrode 3, the porous insulating layer 4, the carbon counter electrode 5 and the current collector 6, which are sequentially layered, constitute one dye-sensitized photoelectric conversion element. In this case, the carbon counter electrode 5 of one dye-sensitized photoelectric conversion element is connected through the conductive member 11 to the transparent conductive layer 2 on which the adjacent dye-sensitized photoelectric conversion element is formed. By this configuration, the plurality of dye-sensitized photoelectric conversion elements are connected in series with one another. The number of the dye-sensitized photoelectric conversion elements thus connected in series is appropriately selected, as appropriate.

Sealing members 8 are provided in such a manner as to surround the peripheries of the porous photoelectrode 3, the porous insulating layer 4, the carbon counter electrode 5 and the current collector 6 of each dye-sensitized photoelectric conversion element, and a sealing plate 9, which is preferably transparent, is mounted on the current collectors. The porous photoelectrode 3, the porous insulating layer 4, the carbon counter electrode 5 and the current collector 6 are sealed by the sealing materials 8 and the sealing plate 9. The sealing plate 9 may be a glass plate, a film or the like, or may be a plate-shaped member formed by application of a sealing material or the like.

[Method of manufacturing dye-sensitized photoelectric conversion element module]

Now, a method of manufacturing this dye-sensitized photoelectric conversion element module will be described below.

First, as shown in FIG. 28A, a process is progressed in the same manner as in the tenth embodiment, whereby the porous photoelectrodes 3 and the porous insulating layers 4 are sequentially layered over the transparent conductive layers 2 formed on the transparent substrate 1.

Next, conductive members 11 composed of a carbon powder-containing paste or the like are formed on the transparent conductive layers 2 by coating or printing or the like, and thereafter layers of a conductive adhesive 12 are formed on the conductive members 11.

Subsequently, the transparent substrate 1 provided with the porous photoelectrodes 3, the porous insulating layers 4 and the conductive members 11 is immersed in a photosensitizing dye solution prepared by dissolving a photosensitizing dye(s) in a predetermined solvent, so as to bind the photosensitizing dye(s) to the porous photoelectrodes 3.

On the other hand, as shown in 28B, the carbon counter electrode 5 side of each of assemblies each having a current collector 6 formed on a surface on one side of a carbon counter electrode 5 is adhered onto the porous insulating layer 4 and the conductive member 11. The adhesion may be carried out, for example, by thermocompression bonding or the like. By this, the carbon counter electrodes 5 are electrically joined to the conductive members 11, respectively.

Next, as shown in FIG. 29A, a layer of a sealing material 8 is formed on the transparent conductive layer 2 in each area between the dye-sensitized photoelectric conversion elements, by coating or the like.

Subsequently, as shown in FIGS. 29A and 29B, a sealing plate 9 is prepared, and the sealing plate 9 is joined onto the current collectors 6.

Thereafter, an electrolyte solution is poured into the space defined by the sealing materials 8 and the sealing plates 9 via an electrolyte solution feed hole(s) formed in the transparent substrate 11 or the sealing plate 9.

In this manner, the desired dye-sensitized photoelectric conversion element module of the monolithic structure is manufactured.

According to the eleventh embodiment, the same advantages as in the tenth embodiment can be obtained in the dye-sensitized photoelectric conversion element module.

<12. Twelfth Embodiment>

[Method of manufacturing dye-sensitized photoelectric conversion element]

In a twelfth embodiment of the present technology, the method of manufacturing the dye-sensitized photoelectric conversion element according to any of the first, fourth to sixth, and tenth embodiments described above is carried out, wherein after the adsorption of the photosensitizing dye on the porous photoelectrode 3, a needless portion of the photosensitizing dye adsorbed on the carbon counter electrode 5 is removed by cleaning. Intrinsically, it suffices for the photosensitizing dye to be adsorbed only on the porous photoelectrode 3. In the case where immersion in the photosensitizing dye solution is conducted after the formation of the carbon counter electrode 5, however, the photosensitizing dye is adsorbed not only on the porous photoelectrode 3 but also on the carbon counter electrode 5. When the photosensitizing dye is thus adsorbed on the carbon counter electrode 5, the photoelectric conversion efficiency of the dye-sensitized photoelectric conversion element is lowered. Therefore, it is desirable to remove the unnecessary portion of the photosensitizing dye.

In view of this, in the twelfth embodiment, after the immersion in the photosensitizing dye solution for the purpose of supporting the photosensitizing dye on the porous photoelectrode 2, the dye-sensitized photoelectric conversion element is taken out of the photosensitizing dye solution, and the dye-sensitized photoelectric conversion element provided with the carbon counter electrode 5 is cleaned with acetonitrile. Next, the dye-sensitized photoelectric conversion element provided with the carbon counter electrode 5 is cleaned by immersing it in a cleaning liquid having 3-methoxypropionitrile (MPN). The 3-methoxypropionitrile is preferably heated to a temperature of 50 to 90°C, particularly a temperature of, for example, 80°C. The cleaning time is preferably in the range from five minutes to one hour, for example, 15 minutes.

Now, the results of quantitative analysis of the amount of a photosensitizing dye on a carbon counter electrode 5 will be described. Evaluation was conducted by use of microwave pressure acidolysis-inductively coupled plasma Auger electron spectroscopy (ICP-AES). The photosensitizing dye is Z907 (see FIG. 3). Specifically, the amount of the photosensitizing dye adsorbed on the carbon counter electrode 5 was evaluated by the amounts of Ru detected before and after the cleaning of the carbon counter electrode 5. The cleaning was conducted by use of a cleaning liquid having 3-methoxypropionitrile and having been much used after preparation thereof (used cleaning liquid), and by use of a cleaning liquid having 3-methoxypropionitrile and being in the state immediately after preparation thereof (fresh cleaning liquid) . Use was made of the following Samples 1 to 4, which differed in the kind of cleaning liquid (used cleaning liquid, fresh cleaning liquid) and/or in the presence/absence of the cleaning (with cleaning, without cleaning). Each of Samples 1 to 4 was prepared in two specimens.

[Table 6 ]

| | Used cleaning liquid | Fresh cleaning liquid |
|---|---|---|
| with cleaning | Sample 1 | Sample 3 |
| Without cleaning | Sample 2 | Sample 4 |

The results of the quantitative analysis are shown in Table 7 and FIG. 30.

[Table 7]

| | | (μg/piece) |
|---|---|---|
| | | Ru |
| Sample 1 | NO1 | 0.74 |
| | NO2 | 0.77 |
| Sample 2 | NO5 | 1.3 |
| | NO6 | 1.4 |
| Sample 3 | NO9 | 1.3 |
| | NO10 | 1.4 |
| Sample 4 | NO13 | 2.9 |
| | NO14 | 3.2 |

(continued)

| (μg/piece) | |
|---|---|
| | Ru |
| Minimum limit of determination | 0.5 |

As shown in Table 7 and FIG. 30, the amount of Ru detected decreases both in the cases where the used cleaning liquid is used and in the cases where the fresh cleaning liquid is used. However, the amount of Ru detected is halved in the cases where the fresh cleaning liquid is used, and the amount of Ru detected is small in the cases where the used cleaning liquid is used. From this it is seen that the use of the fresh cleaning liquid is preferable for removal of the photosensitizing dye adsorbed on the carbon counter electrode 5.

In the next place, for Samples 1 to 4, analysis of surface composition was conducted by applying X-ray photoelectron spectroscopy (XPS) to $TiO_2$ used as the porous photoelectrode 3. The results are shown in Table 8. In Table 8, all of Ru, S and N are considered to be arising from the photosensitizing dye. There is observed no tendency that the photosensitizing dye might be released from the $TiO_2$ surface due to the cleaning.

[Table 8]

| | C1s (0.314) | N1s (0.499) | O1s (0.733) | P2p (0.525) | S2p (0.717) | Ti2p (2.077) | Ru3d5 (2.705) | I3d5 (6.302) |
|---|---|---|---|---|---|---|---|---|
| Sample 1 | 33.27 | 4.71 | 41.48 | 0.04 | 0.78 | 19.19 | 0.50 | 0.03 |
| Sample 2 | 33.23 | 4.62 | 41.68 | 0.00 | 0.75 | 19.22 | 0.50 | 0.00 |
| Sample 3 | 32.97 | 3.45 | 42.66 | 0.94 | 0.67 | 18.90 | 0.38 | 0.03 |
| Sample 4 | 33.65 | 3.46 | 42.18 | 0.88 | 0.61 | 18.80 | 0.39 | 0.03 |

<Example 10>

A titanium oxide paste with an average particle diameter of about 15 nm was applied, by screen printing, to an FTO glass substrate (10 Ω/□) having been etched to form eight line-shaped areas with a width of 0.2 mm. After the titanium oxide paste was dried, a paste prepared by admixing the titanium oxide paste with scattering particles was applied to the dried titanium oxide paste layers, followed by drying. Thereafter, calcination was conducted at 500°C for 30 min, to obtain a titanium oxide electrodes (average film thickness: 10 μm).

Next, a titanium oxide paste with a particle diameter of about 200 nm was applied to the titanium oxide electrodes, and calcined at 500°C for 30 min, to form porous insulating layers 4.

Subsequently, a carbon paste was applied to the porous insulating layers 4 by printing, and calcined at 450°C for 30 minutes, to form carbon counter electrodes 5 composed of porous carbon.

Next, the dye-sensitized photoelectric conversion element module thus formed was immersed in a 0.3 mM solution of Z907 for 15 hours, to adsorb Z907 onto the titanium oxide electrodes.

Subsequently, the dye-sensitized photoelectric conversion element module was taken out of the Z907 solution, and was cleaned with acetonitrile, followed by drying. Thereafter, the dye-sensitized photoelectric conversion element module was immersed for 20 minutesin 3-methoxypropionitrile having preliminarily been warmed in a thermostat set at 85°C, so as to clean away the Z907 adsorbed on the carbon counter electrodes 5. During this cleaning, 3-methoxypropionitrile was dyed, as a result of the release of the photosensitizing dye, having been adsorbed on the carbon counter electrodes 5, into the 3-methoxypropionitrile.

Next, the dye-sensitized photoelectric conversion element module was taken out of 3-methoxypropionitrile, and a UV curing resin was applied to the periphery of the cell-type dye-sensitized photoelectric conversion element module by use of a dispenser. Then, the assembly was covered with a cover glass, and the UV curing resin was cured by irradiation with UV rays.

Thereafter, an electrolyte solution was poured into the dye-sensitized photoelectric conversion element module, and end sealing was conducted using a UV curing resin, to complete the dye-sensitized photoelectric conversion element module.

<Comparative Example 7>

A dye-sensitized photoelectric conversion element module was completed in the same manner as in Example

10, except that the cleaning using 3-methoxypropionitrile for removal of the photosensitizing dye adsorbed on the carbon counter electrodes 5 was omitted.

The dye-sensitized photoelectric conversion element modules completed in Example 10 and Comparative Example 7 were put to measurement of current-voltage characteristic. The measurement was conducted by irradiating each of the dye-sensitized photoelectric conversion element modules with pseudo-sunlight (AM 1.5, 100 $mW/cm^2$). Table 8 shows open-circuit voltage $V_{oc}$, current density $J_{sc}$, fill factor (FF) and photoelectric conversion efficiency Eff.

[Table 9]

| | Voc (V) | Jsc ($mA/cm^2$) | FF (%) | FF (%) |
|---|---|---|---|---|
| Example 10 (with cleaning) | 5.811 | 1.76 | 60.7 | 6.22 |
| Comp.Ex. 7 (without cleaning) | 5.912 | 1.64 | 60.9 | 5.92 |

From Table 9 it is seen that the dye-sensitized photoelectric conversion element module of Example 10 wherein the photosensitizing dye adsorbed on the carbon counter electrodes 5 was removed by cleaning is higher in photoelectric conversion efficiency than that of Comparative Example 7 by about 0.3%.

According to the twelfth embodiment, it is possible to realize a dye-sensitized photoelectric conversion element module which is higher in photoelectric conversion efficiency, as compared with those obtained according to the related art.

<13. Thirteenth Embodiment>

[Dye-sensitized photoelectric conversion element]

In a dye-sensitized photoelectric conversion element according to a thirteenth embodiment of the present technology, an additive(s) satisfying the condition of 6.04 $\leq pK_a \leq$ 7.3 is added to an electrolyte solution with which a porous photoelectrode 3 and a porous insulating layer 4 are impregnated or with which the porous photoelectrode 3, the porous insulating layer 4 and a carbon counter electrode 5 are impregnated. Examples of such an additive include pyridine additives, and additives having a heterocyclic ring. Specific examples of the pyridine additives include 2-NH2-Py, 4-MeO-Py, and 4-Et-Py. Specific examples of the additives having a heterocyclic ring include MIm, 24-Lu, 25-Lu, 26-Lu, 34-Lu, and 35-Lu. Besides, as the solvent of the electrolyte solution, there is used a solvent which has a molecular weight of not less than 47.36. Examples of such a solvent include 3-methoxypropionitrile (MPN) , methoxyacetonitrile (MAN) , and a mixture of acetonitrile (AN) with valeronitrile (VN).. In other points than the just-mentioned, the dye-sensitized photoelectric conversion element of the thirteenth embodiment is the same as the dye-sensitized photoelectric conversion element of any of the first to sixth, ninth, and tenth embodiments described above.

[Method of manufacturing dye-sensitized photoelectric conversion element]

This dye-sensitized photoelectric conversion element can be manufactured by a method which is the same as the method of manufacturing the dye-sensitized photoelectric conversion element according to any of the first to six, ninth, and tenth embodiment above, except that an additive satisfying the condition of 6.04 ≤ pKa ≤ 7.3 is added to an electrolyte solution and that a solvent having a molecular weight of not less than 47.36 is used as the solvent of the electrolyte solution.

<Example 11>

A dye-sensitized photoelectric conversion element was manufactured in the same manner as in Example 1, except that 1.0 g of 1-propyl-3-methylimidazolium iodide, 0.10 g of iodine ($I_2$), and 0.054 g of 2-NH2-Py as an additive were dissolved in 2.0 g of 3-methoxypropionitrile (MPN), to prepare an electrolyte solution.

Incidentally, in the case where both Z907 and Dye A are used as photosensitizing dye, the electrolyte solution is prepared, for example, by a method in which 0.030 g of sodium iodide (NaI) , 1.0 g of 1-propyl-2, 3-dimethyli.midazalium iodide, 0.10 g of iodine $I_2$, and 0.054 g of 2-NH2-Py as an additive are dissolved in 2.0 g of 3-methoxypropionitrile (MPN).

<Example 12>

A dye-sensitized photoelectric conversion element was manufactured in the same manner as in Example 1, except that 4-MeO-Py was used as an additive in preparing an electrolyte solution.

<Example 13>

A dye-sensitized photoelectric conversion element was manufactured in the same manner as in Example 1, except that 4-Et-Py was used as an additive in preparing an electrolyte solution.

<Example 14>

A dye-sensitized photoelectric conversion element was manufactured in the same manner as in Example 1, except that MIm was used as an additive in preparing an electrolyte solution.

<Example 15>

A dye-sensitized photoelectric conversion element was manufactured in the same manner as in Example 1, except that 24-Lu was used as an additive in preparing an electrolyte solution.

<Example 16>

A dye-sensitized photoelectric conversion element was manufactured in the same manner as in Example 1, except that 25-Lu was used as an additive in preparing an electrolyte solution.

<Example 17>

A dye-sensitized photoelectric conversion element was manufactured in the same manner as in Example 1, except that 26-Lu was used as an additive in preparing an electrolyte solution.

<Example 18>

A dye-sensitized photoelectric conversion element was manufactured in the same manner as in Example 1, except that 34-Lu was used as an additive in preparing an electrolyte solution.

<Example 19>

A dye-sensitized photoelectric conversion element was manufactured in the same manner as in Example 1, except that 35-Lu was used as an additive in preparing an electrolyte solution.

<Comparative Example 8>

A dye-sensitized photoelectric conversion element was manufactured in the same manner as in Example 1, except that no additive was used in preparing an electrolyte solution.

<Comparative Example 9>

A dye-sensitized photoelectric conversion element was manufactured in the same manner as in Example 1, except that TBP was used as an additive in preparing an electrolyte solution.

<Comparative Example 10>

A dye-sensitized photoelectric conversion element was manufactured in the same manner as in Example 1, except that 4-picoline (4-pic) was used as an additive in preparing an electrolyte solution.

<Comparative Example 11>

A dye-sensitized photoelectric conversion element was manufactured in the same manner as in Example 1, except that methyl isonicotinate (4-COOMe-Py) was used as an additive in preparing an electrolyte solution.

<Comparative Example 12>

A dye-sensitized photoelectric conversion element was manufactured in the same manner as in Example 1,

except that 4-cyanopyridine (4-CN-Py) was used as an additive in preparing an electrolyte solution.

<Comparative Example 13>

A dye-sensitized photoelectric conversion element was manufactured in the same manner as in Example 1, except that 4-aminopyridine (4-NH2-Py) was used as an additive in preparing an electrolyte solution.

<Comparative Example 14> >

A dye-sensitized photoelectric conversion element was manufactured in the same manner as in Example 1, except that 4-(methylamino)pyridine (4-MeNH-Py) was used as an additive in preparing an electrolyte solution.

<Comparative Example 15>

A dye-sensitized photoelectric conversion element was manufactured in the same manner as in Example 1, except that 3-methoxypyridine (3-MeO-Py) was used as an additive in preparing an electrolyte solution.

<Comparative Example 16>

A dye-sensitized photoelectric conversion element was manufactured in the same manner as in Example 1, except that 2-methoxypyridine (2-MeO-Py) was used as an additive in preparing an electrolyte solution.

<Comparative Example 17>

A dye-sensitized photoelectric conversion element was manufactured in the same manner as in Example 1, except that methyl nicotinate (3-COOMe-Py) was used as an additive in preparing an electrolyte solution.

<Comparative Example 18>

A dye-sensitized photoelectric conversion element was manufactured in the same manner as in Example 1, except that pyridine (Py) was used as an additive in preparing an electrolyte solution.

<Comparative Example 19>

A dye-sensitized photoelectric conversion element was manufactured in the same manner as in Example 1, except that 3-bromopyridine (3-Br-Py) was used as an additive in preparing an electrolyte solution.

Comparative Example 20>

A dye-sensitized photoelectric conversion element was manufactured in the same manner as in Example 1, except that N-methylbenzimidazole (NMB) was used as an additive in preparing an electrolyte solution.

<Comparative Example 21>

A dye-sensitized photoelectric conversion element was manufactured in the same manner as in Example 1, except that pyrazine was used as an additive in preparing an electrolyte solution.

<Comparative Example 22>

A dye-sensitized photoelectric conversion element was manufactured in the same manner as in Example 1, except that thiazole was used as an additive in preparing an electrolyte solution.

<Comparative Example 23>

A dye-sensitized photoelectric conversion element was manufactured in the same manner as in Example 1, except that N-methylpyrazole (Me-pyrazole) was used as an additive in preparing an electrolyte solution.

<Comparative Example 24>

A dye-sensitized photoelectric conversion element was manufactured in the same manner as in Example 1, except that quinoline was used as an additive in preparing an electrolyte solution.

<Comparative Example 25>

A dye-sensitized photoelectric conversion element was manufactured in the same manner as in Example 1, except that isoquinoline was used as an additive in preparing an electrolyte solution.

<Comparative Example 26>

A dye-sensitized photoelectric conversion element was manufactured in the same manner as in Example 1, except that 2,2'-bipyridyl (bpy) was used as an additive in preparing an electrolyte solution.

comparative Example 27>

A dye-sensitized photoelectric conversion element was manufactured in the same manner as in Example 1, except that pyridazine was used as an additive in preparing an electrolyte solution.

<Comparative Example 28>

A dye-sensitized photoelectric conversion element was manufactured in the same manner as in Example 1, except that pyrimidine was used as an additive in preparing an electrolyte solution.

<Comparative Example 29>

A dye-sensitized photoelectric conversion element was manufactured in the same manner as in Example 1, except that acridine was used as an additive in preparing an electrolyte solution.

<Comparative Example 30>

A dye-sensitized photoelectric conversion element was manufactured in the same manner as in Example 1, except that 5,6-benzoquinoline was used as an additive in preparing an electrolyte solution.

Table 10 shows $pK_a$ (water), photoelectric conversion efficiency (Eff) and internal resistance ($R_s$) in Examples 11 to 13 and Comparative Examples 8 to 19 in which a pyridine additive was used. Table 11 shows $pK_a$ (water), photoelectric conversion efficiency (Eff) and internal resistance ($R_s$) in Examples 14 to 19 and Comparative Example 20 to 30 in which an additive having a heterocyclic ring was used. From Tables 10 and 11, it is seen that in each of Examples 11 to 19 in which an additive satisfying the condition of 6.04 s pKa $\leq$7.3 was used, the photoelectric conversion efficiency (Eff) is equal or higher and the internal resistance ($R_s$) is lower, as compared with Comparative Example 9 in which 4-tert-butylpyridine was used. FIG. 31 shows a diagram in which the values of photoelectric conversion efficiency (Eff) obtained in Examples 11 to 19 and Comparative Examples 8 to 30 are plotted against $pK_a$. In addition, FIG. 32 shows a diagram in which the values of internal resistance ($R_s$) obtained in Examples 11 to 19 and Comparative Examples 8 to 30 are plotted against $pK_a$.

[Table 10]

| | Additive | $pK_a$ (water) | Eff [%] | $R_s$ [$\Omega$] |
|---|---|---|---|---|
| Example 11 | 2-NH2-Py | 6.86 | 8.3 | 29.5 |
| Example 12 | 4-MeO-Py | 6.62 | 8.4 | 31.0 |
| Example 13 | 4-Et-Py | 6.04 | 8.2 | 32.1 |
| Comp.Ex. 8 | nil | | 7.1 | 35.5 |
| Comp.Ex. 9 | TBP | 5.99 | 7.9 | 33.8 |
| Comp.Ex. 10 | 4-pic | 6.03 | 7.9 | 34.3 |
| Comp.Ex. 11 | 4-COOMe-Py. | 3.26 | 7.2 | 40.2 |

(continued)

| | Additive | $pK_a$ (water) | Eff [%] | $R_s$ [Ω] |
|---|---|---|---|---|
| Comp.Ex. 12 | 4-CN-Py | 1.9 | 6.7 | 41.3 |
| Comp.Ex. 13 | 4-NH2-Py | 9.17 | 7.1 | 41.7 |
| Comp.Ex. 14 | 4-MeNH-Py | 12.5 | 6.2 | 45.6 |
| Comp.Ex. 15 | 3-MeO-Py | 4.88 | 7.8 | 34.0 |
| Comp.Ex. 16 | 2-MeO-Py | 3.28 | 7.4 | 34.3 |
| Comp.Ex. 17 | 3-COOMe-Py | 3.13 | 7.2 | 39.5 |
| Comp.Ex. 18 | Py | 5.23 | 7.9 | 33.6 |
| Comp.Ex. 19 | 3-Br-Py | 2.84 | 7.3 | 36.9 |

[Table 11]

| | Additive | $PK_a$ (water) | Eff [%] | $R_s$ [Ω] |
|---|---|---|---|---|
| Example 14 | MIm | 7.3 | 8.0 | 33.0 |
| Example 15 | 24-Lu | 6.72 | 8.3 | 29.9 |
| Example 16 | 25-Lu | 6.47 | 8.3 | 30.5 |
| Example 17 | 26-Lu | 6.77 | 8.3 | 30.6 |
| Example 18 | 34-Lu | 6.52 | 8.0 | 31.9 |
| Example 19 | 35-Lu | 6.14 | 7.9 | 32.0 |
| Comp.Ex. 20 | NMB | 5.6 | 7.9 | 35.8 |
| Comp.Ex. 21 | pyrazine | 0.6 | 6.8 | 40.4 |
| Comp.Ex. 22 | thiazole | 2.5 | 7.5 | 32.5 |
| Comp.Ex. 23 | Me-pyrazole | 2.1 | 7.5 | 32.7 |
| Comp.Ex. 24 | quinoline | 4.97 | 7.6 | 32.9 |
| Comp.Ex. 25 | isoquinoline | 5.38 | 7.7 | 36.1 |
| Comp.Ex. 26 | bpy | 4.42 | 7.4 | 37.2 |
| Comp.Ex. 27 | pyridazine | 2.1 | 6.5 | 32.0 |
| Comp.Ex. 28 | pyrimidine | 1.1 | 7.2 | 35.5 |
| Comp.Ex. 29 | acridine | 5.6 | 7.3 | 31.3 |
| Comp.Ex. 30 | 56-benzoquinoline | 5.15 | 7.6 | 33.3 |

Now, dependency of the effect of the additive added to an electrolyte solution on the kind of solvent of the electrolyte solution will be described below.

The effects of the additives were examined on the basis of each of solvents differing in molecular weight. Here, 4-tert-butylpyridine (TBP) and 4-Et-Py (4-ethylpyridine) having respective $pK_a$ values comparably close to each other were selected as the additives to be compared. The method of evaluation is as follows. For each of the solvents, the photoelectric conversion efficiency (Eff(4-Et-Py)) of the dye-sensitized photoelectric conversion element manufactured using 4-Et-Py as the additive to the electrolyte solution and the photoelectric conversion efficiency (Eff(TBP)) of the dye-sensitized photoelectric conversion element manufactured using TBP as the additive to the electrolyte solution are measured. Then, the difference between these photoelectric conversion efficiencies, ΔEff = Eff(4-Et-Py) - Eff(TBP), is adopted as an index of the effect under consideration. As the solvent of the electrolyte solution, there were used four solvents, namely, acetonitrile (AN), a mixture of acetonitrile (AN) with 3-methoxypropionitrile (VN) , methoxyacetonitrile (MAN) , and 3-methoxypropionitrile MPN) . Table 12 shows Eff (4-Et-Py), Eff(TBP), and ΔEff, for each of the solvents. Here, in regard of the Eff (4-Et-Py), Eff (TBP) and ΔEff values for acetonitrile (AN), reference was made to the data

reported in Solar Energy Materials & Solar Cells, 2003, 80, 167. FIG. 33 shows a diagram in which the photoelectric conversion efficiency difference ΔEff was plotted against the molecular weight of solvent.

[Table 12]

| Solvent | Molecular weight | Eff (4-Et-Py) | Eff (TBP) | ΔEff |
|---|---|---|---|---|
| AN | 41.05 | 3.4 | 7.4 | -4 |
| AN/VN | 47.36 | 8.72 | 8.69 | 0.03 |
| MAN | 71.08 | 8.05 | 7.96 | 0.09 |
| MPN | 85.1 | 8.22 | 7.86 | 0.36 |

From Table 12 and FIG. 33, it is seen that the molecular weight range in which ΔEff > 0, namely, Eff(4-Et-Py) is greater than Eff (TBP), is the range of not less than 47.36 . It should be noted here that the value of 47.36 is an apparent molecular weight calculated from the mixing fraction, by volume, between acetonitrile (AN) and valeronitrile (VN) in the mixture of the two solvents.

This result shows that it can be said that, in the case where a solvent having a molecular weight of not less than 47.36 is used, the use of an additive satisfying the condition of $6.04 \leq pK_a \leq 7.3$ as the additive to the electrolyte solution is effective.

Thus, according to the thirteenth embodiment, an additive satisfying the condition of 6. a4 ≤ pKa < 7.3 is used as the additive to the electrolyte solution. This makes it possible to obtain a higher photoelectric conversion efficiency and a lower internal resistance and to thereby realize a dye-sensitizing photoelectric conversion element having superior photoelectric conversion characteristics, as compared with the dye-sensitized photoelectric conversion element according to the related art in which 4-tert-butylpyridine is used as the additive to the electrolyte solution. Besides, since there are a variety of additives which satisfy the condition of $6.04 \leq pK_a \leq 7.3$, an extremely broad choice of the additive is ensured.

<14. Fourteenth Embodiment>

[Dye-sensitized photoelectric conversion element]

A dye-sensitized photoelectric conversion element according to a fourteenth embodiment of the present technology differs from the dye-sensitized photoelectric conversion element according to the first embodiment in that a solvent containing at least an ionic liquid having an electron pair acceptive functional group and an organic solvent having an electron pair donative functional group is used as the solvent of the electrolyte solution.

Typically, the electron pair acceptive functional group is possessed by a cation constituting the ionic liquid. The cation of the ionic liquid is preferably an organic cation which has an aromatic amine cation having a quaternary nitrogen atom and which has a hydrogen atom in an aromatic ring. Non-limitative examples of the organic cation include imidazolium cation, pyridinium cation, thiazolium cation, and pyrazonium cation. As the anion of the ionic liquid, there is preferably used an anion having a van der Waals volume of not less than 76 $Â^3$, more preferably not less than 100 $A^3$.

Specific examples of the ionic liquid having an electron pair acceptive functional group include the following:

EMImTCB: 1-ethyl-3-methylimidazolium tetracyanoborate
EMImTFSI: 1-ethyl-3-methylimidazolium bis(trifluoromethanesulfone)imide
EMImFAP: 1-ethyl-3-methylimidazolium tris(pentafluoroethyl)trifluoraphosphate
. $EMImBF_4$: 1-ethyl-3-methylimidazolium tetrafluoroborate

Specific examples of the organic solvent having an electron pair donative functional group include the following:

MPN: 3-methoxypropionitrile
GBL: y-butyrolactone
DMF: N,N-dimethylformamide
diglyme: diethylene glycol dimethyl ether
triglyme: triethylene glycol dimethyl ether
tetraglyme: tetraethylene glycol dimethyl ether
PhOAN: phenoxyacetonitrile
Pc: propylene carbonate

aniline
DManiline: N,N-dimethylaniline
NBB: N-butylbenzimidazole
TBP: tert-butylpyridine

Specific examples of the organic solvent having a tertiary nitrogen atom include the solvents as set forth through classification into five kinds below.

(1) methylamine, dimethylamine, trimethylamine, ethylamine, diethylamine, triethylamine, ethylmethylamine, n-propylamine, iso-propylamine, dipropylamine, n-butylamine, sec-butylamine, tert-butylamine
(2) ethylenediamine
(3) aniline, N,N-dimethylaniline
(4) foramide, N-methylformamide, N,N-dimethylformamide, acetamide, N-methylacetamide, N,N-dimethylacetamide N-methylpyrrolidone Presenting the solvents of (1) to (4) above in a general formula, the solvents are those organic molecules having a molecular weight of not more than 1000 which have the following molecular skeleton:

[Chemical 1]

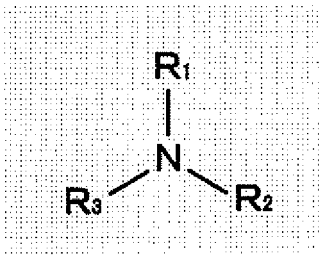

In the formula, $R_1$, $R_2$, $R_3$ are each a substituent group selected from the group consisting of H, CnHm (n = 1 to 20, m = 3 to 41), phenyl group, aldehyde group, and acetyl group.

[Method of manufacturing dye-sensitized photoelectric conversion element]

This dye-sensitized photoelectric conversion element can be manufactured by a method which is the same as the method of manufacturing the dye-sensitized photoelectric conversion element according to the first embodiment, except that a solvent containing at least an ionic liquid having an electron pair acceptive functional group and an organic solvent having an electron pair donative functional group is used as the solvent of the electrolyte solution.

<Example 20>

A dye-sensitized photoelectric conversion element was manufactured in the same manner as in Example 1, except that 1.0 g of 1-propyl-3-methylimidazolium iodide, 0.10 g of iodine ($I_2$), and 0.054 g of 2-NH2-Py as an additive were dissolved in a mixed solvent prepared by mixing EMImTCB with diglyme in a weight ratio of 1:1 to prepare an electrolyte solution.

Incidentally, in the case where both Z907 and Dye A are used as photosensitizing dye, the electrolyte solution is prepared, for example, by a method in which 0.030 g of sodium iodide (NaI), 1.0 g of 1-propyl-2,3-dimethylimidazolium iodine, 0.10 g of iodine ($I_2$) , and 0.054 g of 2-NH2-Py as an additive are dissolved in 2.0 g of the mixed solvent prepared by mixing EMImTCB with diglyme in a weight ratio of 1:1.

<Example 21>

A dye-sensitized photoelectric conversion element was manufactured in the same manner as in Example 20, except that a mixed solvent prepared by mixing EMImTCB with triglyme in a weight ratio of 1:1 was used to prepare an electrolyte solution.

<Example 22>

A dye-sensitized photoelectric conversion element was manufactured in the same manner as in Example 20,

except that a mixed solvent prepared by mixing EMImTCB with tetraglyme in a weight ratio of 1:1 was used to prepare an electrolyte solution.

<Example 23>

A dye-sensitized photoelectric conversion element was manufactured in the same manner as in Example 20, except that a mixed solvent prepared by mixing EMImTCB with MPN in a weight ratio of 1:1 was used to prepare an electrolyte solution.

<Example 24>

A dye-sensitized photoelectric conversion element was manufactured in the same manner as in Example 20, except that a mixed solvent prepared by mixing EMImTCB with PhOAN in a weight ratio of 1:1 was used to prepare an electrolyte solution.

<Example 25>

A dye-sensitized photoelectric conversion element was manufactured in the same manner as in Example 20, except that a mixed solvent prepared by mixing EMImTCB with GBL in a weight ratio of 1:1 was used to prepare an electrolyte solution.

<Example 26>

A dye-sensitized photoelectric conversion element was manufactured in the same manner as in Example 20, except that a mixed solvent prepared by mixing EMImTCB with PC in a weight ratio of 1:1 was used to prepare an electrolyte solution.

<Example 27>

A dye-sensitized photoelectric conversion element was manufactured in the same manner as in Example 11, except that a mixed solvent prepared by mixing EMImTCB with aniline in a weight ratio of 1:1 was used to prepare an electrolyte solution.

<Example 28>

A dye-sensitized photoelectric conversion element was manufactured in the same manner as in Example 20, except that a mixed solvent prepared by mixing EMImTCB with DMF in a weight ratio of 1:1 was used to prepare an electrolyte solution.

<Example 29>

A dye-sensitized photoelectric conversion element was manufactured in the same manner as in Example 20, except that a mixed solvent prepared by mixing EMImTCB with DManiline in a weight ratio of 1:1 was used to prepare an electrolyte solution.

<Example 30>

A dye-sensitized photoelectric conversion element was manufactured in the same manner as in Example 20, except that a mixed solvent prepared by mixing EMImTCB with NBB in a weight ratio of 1:1 was used to prepare an electrolyte solution.

<Example 31>

A dye-sensitized photoelectric conversion element was manufactured in the same manner as in Example 20, except that a mixed solvent prepared by mixing EMImTCB with TBP in a weight ratio of 1:1 was used to prepare an electrolyte solution.

<Example 32>

A dye-sensitized photoelectric conversion element was manufactured in the same manner as in Example 20, except that a mixed solvent prepared by mixing EMImTFSI with triglyme in a weight ratio of 1:1 was used to prepare an electrolyte solution.

<Example 33>

A dye-sensitized photoelectric conversion element was manufactured in the same manner as in Example 20, except that a mixed solvent prepared by mixing EMInFAPwith triglyme in a weight ratio of 1:1 was used to prepare an electrolyte solution.

<Comparative Example 31>

A dye-sensitized photoelectric conversion element was manufactured in the same manner as in Example 20, except that diglyme was used as a solvent in preparing an electrolyte solution.

<Comparative Example 32>

A dye-sensitized photoelectric conversion element was manufactured in the same manner as in Example 20, except that EMImTCB was used as a solvent in preparing an electrolyte solution.

<Comparative Example 33>

A dye-sensitized photoelectric conversion element was manufactured in the same manner as in Example 20, except that MPN was used as a solvent in preparing an electrolyte solution.

<Comparative Example 34>

A dye-sensitized photoelectric conversion element was manufactured in the same manner as in Example 20, except that a mixed solvent prepared by mixing EMImTCB with PAN (phenylacetonitrile) in a weight ratio of 1:1 was used as a solvent in preparing an electrolyte solution.

<Comparative Example 35>

A dye-sensitized photoelectric conversion element was manufactured in the same manner as in Example 20, except that a mixed solvent prepared by mixing $EMImBF_4$ (1-ethyl-3-methylimidazolium tetrafluoroborate) with triglyme in a weight ratio of 1:1 was used as a solvent in preparing an electrolyte solution-

<Comparative Example 36>

A dye-sensitized photoelectric conversion element was manufactured in the same manner as in Example 20, except that a mixed solvent prepared by mixing EMImOTf (1-ethyl-3-methylimidazolium trifluoromethanesulfonate) with triglyme in a weight ratio of 1:1 was used as a solvent in preparing an electrolyte solution.

<Comparative Example 37>

A dye-sensitized photoelectric conversion element was manufactured in the same manner as in Example 20, except that a mixed solvent prepared by mixing $P_{222}$MOMTFSI (triethyl(methoxymethyl)phosphonium bis(trifluoromethylsulfonyl)imide) with triglyme in a weight ratio of 1:1 was used as a solvent in preparing an electrolyte solution.

Table 13 shows the results of determination of evaporation rate lowering ratio $z_{vapar}$ of the mixed solvent of the ionic liquid and the organic solvent, in each of Examples 20 to 33 and Comparative Examples 34 to 37. It is to be noted here that the weight percentage of the organic solvent in the mixed solvent is 50 wt%. The evaporation rate lowering ratio $z_{vapor}$ is defined as: $Z_{vapor}$ (%) = [1 - (Weight percentage of organic solvent in mixed solvent) x ($k_{mixture}/k_{neat}$)] x 100, where $k_{neat}$ is the evaporation rate of the organic solvent alone, and $k_{mixture}$ is the evaporation rate of the mixed solvent of the ionic liquid and the organic solvent. Both of the evaporation rates $k_{neat}$ and $k_{mixture}$ can be determined by TG (Thermo Gravimetry)-DTA (Differential Thermal Analysis) measurement. A higher value of $z_{vapor}$ indicates that the volatility of the organic solvent component in the mixed solvent is lowered by a larger value, as compared with the

volatility of the organic solvent being used alone.

[Table 13]

| | Ionic liquid | Organic solvent | $Z_{vapor}$ |
|---|---|---|---|
| Example 20 | EMImTCB | diglyme | 50 |
| Example 21 | EMImTCB | triglyme | 59 |
| Example 22 | EMImTCB | tetraglyme | 78 |
| Example 23 | EMImTCB | MPN | 12 |
| Example 24 | EMImTCB | PhOAN | 11 |
| Example 25 | EMImTCB | GBL | 14 |
| Example 26 | EMImTCB | PC | 9 |
| Example 27 | EMImTCB | aniline | 31 |
| Example 28 | EMImTCB | DMF | 39 |
| Example 29 | EMImTCB | DManiline | 8 |
| Example 30 | EMImTCB | NBB | 6 |
| Example 31 | EMImTCB | TBP | 7 |
| Example 32 | EMImTFSI | triglyme | 37 |
| Example 33 | EMImFAP | triglyme, | 25 |
| Comp.Ex. 34 | EMImTCB | PhAN | 0 |
| Comp.Ex. 35 | $EMImBF_4$ | triglyme, | -12 |
| Comp.Ex. 36 | EMImOTf | triglyme | -2 |
| Comp.Ex. 37 | $P_{222}$MOMTFSI | triglyme | -9 |

From Table 13 it is seen that, in Examples 20 to 33, $Z_{vapor}$ has a great positive value, indicating that the volatility of the organic solvent component is lowered by mixing of the ionic liquid with the organic solvent. On the other hand, in Comparative Examples 34 to 37, $Z_{vapor}$ has a value of 0 or a negative value, indicating that the volatility of the organic solvent is not lowered by the mixing of the ionic liquid with the organic solvent.

FIG. 34 shows TG-DTA curves for various solvents. As seen from FIG. 34, in the case where a mixed solvent of EMImTCB and MPN (weight percentage of EMImTCB: 50 wt%) is used (Example 23, Curve (4)), the weight loss is much smaller than that in the case where MPN alone is used (Curve (5)). It is also seen that in the case where a mixed solvent of EMImTCB with GBL (weight percentage of EMImTCB: 50 wt%) is used (Example 25, Curve (2)), the weight loss is smaller than that in the case where GBL alone is used (Curve (3)).

FIG. 35 shows TG-DTA curves obtained respectively in the case where a mixed solvent of EMImTCB and diglyme (weight percentage of EMImTCB: 50 wt%) was used, the case where EMImTCB alone was used, and the case where diglyme alone was used. From FIG. 35 it is seen that in the case where the mixed solvent of EMImTCB and diglyme is used, the weight loss is extremely small, as compared with the case of using diglyme alone, and the weight loss is suppressed to a level close to that in the case of using EMImTCB alone-

FIG. 36 shows TG-DTA curves obtained respectively in the case where a mixed solvent of EMImTCB and triglyme (weight percentage of EMImTCB: 50 wt%) was used (Example 21), the case where EMImTCB alone is used, and the case where triglyme alone was used. As seen from FIG. 36, in the case where the mixed solvent of EMImTCB and triglyme is used, the weight loss is extremely small as compared with the case of using triglyme alone, and the weight loss is suppressed to a level comparable to that in the case of using EMImTCB alone.

FIG. 37 shows TG-DTA curves obtained respectively in the case where a mixed solvent of EMImTCB and tetraglyme (percentage of EMImTCB: 50 wt%) was used (Example 22), the case where EMImTCB alone was used, and the case where tetraglyme alone was used. As seen from FIG. 37, in the case where the mixed solvent of EMImTCB and tetraglyme is used, the weight loss is extremely small, as compared with the case of using tetraglyme alone, and the weight loss is suppressed to a level close to that in the case of using EMImTCB alone.

FIG. 38 shows the examination results of the relationship between the content of EMImTCB in a mixed solvent of EMITCB with diglyme and evaporation rate lowering ratio, in the case where the mixed solvent was used as the solvent

of the electrolyte solution. It is seen from FIG. 37 that a lowering in evaporation rate is observed where the content of EMImTCB is not less than 15 wt%.

Now, the structures of a preferable cation and a preferable anion of an ionic liquid will be described. In the first place, the cation is preferably an organic cation which has an aromatic amine cation having a quaternary nitrogen atom and which has a hydrogen atom in an aromatic ring. Examples of such an organic cation include imidazolium cation, pyridinium cation, thiazolium cation, and pyrazonium cation. The preferable anion can be defined by use of van der Waals volume (the size of electron cloud) of the anion calculated in a computation-scientific manner. FIG. 39 shows a diagram wherein evaporation rate lowering ratio is plotted against van der Waals volumes of some anions (TCB, TFSI, OTf, $BF_4^-$) . As to the values of van der Waals volume of the anions, reference was made to Journal of The Electrochemical Society 002, 149(10), A1385-A1388 (2002). As the van der Waals volume of the TCM anion, the van der Waals volume of $(C2Hs)_4B^-$ anion having a structure similar to that of the TCB anion was used. These data were put to fitting with a linear function. Let van der Waals volume be x, and let evaporation rate lowering ratio be y, then the fitting equation is $y = 0.5898x - 44.675$. It is considered from FIG. 39 that a lowering in evaporation rate occurs when the anion used has a van der Waals volume is not less than 76 $A^3$, preferably not less than 100 $A^3$.

Now, the results of consideration of the principle of lowering in evaporation rate, which occurs in a mixed solvent containing both an ionic liquid having an electron pair acceptive functional group and an organic solvent having an electron pair donative functional group, will be described below.

In such a mixed solvent, a hydrogen bond is formed between the electron acceptive functional group possessed by the ionic liquid and the electron donative functional group (ether group, amino group, etc.) possessed by the organic solvent. FIG. 40 shows one example of this. In this example, as shown in FIG. 40, a hydrogen bond (indicated by broken line) is formed between the electron acceptive functional group (acidic proton) possessed by the imidazolium cation of the ionic liquid and the ether group (-O-) present in the diglyme molecule. Thus, it can be considered that in such a mixed solvent, a hydrogen bond is formed between the ionic liquid and the organic solvent, leading to thermal stabilization and, hence, to a lowering in evaporation rate.

Especially, when the number of electron pair donative functional groups in one molecule of the organic solvent is increased, the evaporation rate lowering ratio is increased. For example, FIG. 41 shows an example in which the organic solvent is triglyme. In this example, a total of two hydrogen bonds are formed respectively between the two electron pair acceptive functional groups (acidic protons) possessed by the imidazolium cation of the ionic liquid and the two ether groups possessed by triglyme, resulting in thermal stabilization. In this case, besides, when a hydrogen bond is formed between one electron pair acceptive functional group of the imidazolium cation of the ionic liquid and one ether group of triglyme, another ether group of the triglyme approaches another electron acceptive functional group of the imidazolium cation of the ionic liquid. In other words, triglyme enrolls the imidazolium cation therein. Therefore, another electron pair acceptive functional group of the imidazolium ion of the ionic liquid and another ether group of triglyme become more liable to interact with each other, so that a hydrogen bond is easily formed therebetween.

According to the fourteenth embodiment, the following merits can be obtained, in addition to the same merits as those according to the first embodiment. Specifically, in the fourteenth embodiment, a mixed solvent of an ionic liquid having an electron pair acceptive functional group and an organic solvent having an electron pair donative functional group is used as the solvent of the electrolyte solution. Therefore, volatilization of the electrolyte solution can be suppressed effectively. In addition, the mixed solvent has a low viscosity coefficient and, therefore, the viscosity coefficient of the electrolyte solution can be lowered. Accordingly, it is possible to obtain a dye-sensitized photoelectric conversion element having excellent photoelectric conversion characteristics.

<15. Fifteenth Embodiment>

[Dye-sensitized photoelectric conversion element]

In a dye-sensitized photoelectric conversion element of a monolithic structure according to a fifteenth embodiment of the present technology, a porous photoelectrode 3 has metal/metallic oxide particulates, and, typically, is composed of a sintered body of the metal/metallic oxide particulates. Detailed structure of the metal/metallic oxide particulate is shown in FIG. 42. The metal/metallic oxide particulate 13 has a core/shell structure which includes a spherical core 13a formed from a metal and a shell 13b formed from a metallic oxide and surrounding the periphery of the core 13a. The metal/metallic oxide particulate 13 is accompanied by one kind or a plurality of kinds of photosensitizing dyes bonded to (or adsorbed on) the surface of the shell 13b of the metallic oxide thereof.

Examples of the metallic oxide for forming the shells 13b of the metal/metallic oxide particulates 13 include titanium oxide (Ti,02), tin oxide ($SnO_2$), niobium oxide ($Nb_2O_s$), and zinc oxide (ZnO). Among these metallic oxide, preferred is $TiO_2$, and particularly preferred is anatase-type $TiO_2$. It is to be noted, however, that the kind of the metallic oxide applicable here is not limited to the just-mentioned; besides, two or more of these metallic oxides may be used in the state of mixture or composite material, as appropriate. Further, the form of the metal/metallic oxide particulates 13

may be any of a tubular form, a rod-like form, etc.

The particle diameter of the metal/metallic oxide particulates 13 is not particularly limited. The particulate diameter, in terms of average particle diameter of primary particles, is generally 1 to 500 nm, preferably 1 to 200 nm, and particularly preferably 5 to 100 nm. The grain diameter of the cores 13a of the metal/metallic oxide particulates 13, in general, is 1 to 200 nm.

The other points in this embodiment are the same as in the first embodiment above.

[Method of manufacturing dye-sensitized photoelectric conversion element]

Now, a method of manufacturing this dye-sensitized photoelectric conversion element will be described below.

First, transparent conductive layers 2a and 2b are formed on a principal surface of a transparent substrate 1 by sputtering or the like.

Next, a porous photoelectrode 3 having metal/metallic oxide particulates 13 is formed on the transparent conductive layer 2a.

The porous photoelectrode 3 is preferably formed by a method in which after the metal/metallic oxide particulates 13 are applied onto the transparent conductive layer 2a by coating or printing, calcination is conducted so as to make the metal/metallic oxide particles 13 be electrically connected together, to enhance the mechanical strength of the porous photoelectrode 3, and to enhance the adhesion between the porous photoelectrode 3 and the transparent conductive layer 2a.

Thereafter, a process is progressed in the same manner as in the first embodiment, whereby the desired dye-sensitized photoelectric conversion element is manufactured.

The metal/metallic oxide particulates 13 for forming the porous photoelectrode 3 can be prepared by a known method (see, for example, Jpn- J. Appl. Phys., Vol. 46, No. 4B, 2007, pp. 2567-2570). As an example, a method for preparation of metal/metallic oxide particulates 13 having cores 13a of Au and shells 13b of $TiO_2$ will be briefly described as follows. First, dehydrated trisodium citrate is mixed into 500 mL of a heated $5x10^{-4}$ M solution of $HAuCl_4$, and the resulting mixture is stirred. Next, mercaptoundecanoic acid is added to an aqueous ammonia solution in an addition amount of 2.5 wt%, followed by stirring, and the stirred liquid is added to the dispersed solution of Au nanoparticles, followed by warmth retaining for two hours. Subsequently, 1 M HCl is added to the thus obtained solution so as to adjust the pH of the solution to 3. Next, titanium isopropoxide and triethanolamine are added to the Au colloid solution in a nitrogen atmosphere. In this manner, metal/metallic oxide particulates 13 having cores 13a of Au and shells 13b of $TiO_2$ are prepared.

[Operation of dye-sensitized photoelectric conversion element]

Now, operation of this dye-sensitized photoelectric conversion element will be described below.

The dye-sensitized photoelectric conversion element, upon incidence of light thereon, operates as a cell with the carbon counter electrode 5 as a positive electrode and with the transparent conductive layer 2a as a negative electrode. The principle of the operation is as follows. Incidentally, it is assumed here that FTO is used as the material for the transparent conductive layer 2a, Au is used as the material for the cores 13a of the metal/metallic oxide particulates 13 constituting the porous photoelectrode 3, while $TiO_2$ is used as the material for the shells 13b, and an oxidation-reduction species of $I^-/I_3^-$ is used as the redox pair. This assumption, however, is non-limitative.

When photons transmitted through the transparent substrate 1 and the transparent conductive layer 2a to be incident on the porous photoelectrode 3 is absorbed by the photosensitizing dye(s) bound to the porous photoelectrode 3, electrons in the photosensitizing dye(s) are excited from a ground state (HOMO) to an excited state (LUMO). The thus excited electrons are drawn out through the electrical coupling between the photosensitizing dye(s) and the porous photoelectrode 3 into the conduction band of $TiO_2$ constituting the shells 13b of the metal/metallic oxide particulates 13 constituting the porous photoelectrode 3, and pass through the porous phatoelectrode 3, to reach the transparent conductive layer 2a. In addition, the incidence of the light on the surfaces of the Au cores 13a of the metal/metallic oxide particulates 13 causes excitation of localized surface plasmon, whereby an electric field intensifying effect can be obtained. Then, by the thus intensified electric field, a large amount of electrons are excited into the conduction band of $TiO_2$ constituting the shells 13b, and the thus excited electrons pass through the porous photoelectrode 3, to reach the transparent conductive layer 2a. Thus, upon incidence of light on the porous photoelectrode 3, not only the electrons generated by excitation of the photosensitizing dye(s) arrive at the transparent conductive layer 2a, but also the electrons excited into the conduction band of $TiO_2$ constituting the shells 13b of the metal/metallic oxide particulates 13 owing to excitation of localized surface plasmon at the surfaces of the cores 13a reach the transparent conductive layer 2a. Consequently, a high photoelectric conversion efficiency can be obtained.

On the other hand, the photosensitizing dye(s) having lost the electrons accepts electrons from a reducing agent, for example $I^-$, in the electrolyte solution with which the porous photoelectrode 3 and the like have been impregnated, by the following reaction, to produce an oxidizing agent, for example, $I_3^-$ (a combined ion of $I_2$ and $I^-$), in the electrolyte solution.

$$2I^- \rightarrow I_2 + 2e^-$$

$$I_2 + I^- \rightarrow I_3^-$$

The thus produced oxidizing agent diffuses to reach the carbon counter electrode 5, where it accepts electrons from the carbon counter electrode 5 by the reverse reaction of the above-mentioned reaction, to be reduced to the original reducing agent.

$$I_3^- \rightarrow I_2 + I^-$$

$$I_2 + 2e^- \rightarrow 2I^-$$

Electrons sent out from the transparent conductive layer 2a into an external circuit performs an electrical work in the external circuit, before returning to the carbon counter electrode 5. In this manner, optical energy is converted into electrical energy, without leaving any change in the photosensitizing dye(s) or the electrolyte solution.

According to the fifteenth embodiment, the following merits can be obtained, in addition to the same merits as those obtained in the first embodiment above. Tie porous photoelectrode 3 has the metal/metallic oxide particulates 13 which have the core/shell structure including the spherical core 13 of a metal and the shell 13b of a metallic oxide surrounding the periphery of the core 13a. Therefore, when the porous photoelectrode 3 and the like are impregnated with the electrolyte solution, the electrolyte in the electrolyte solution does not make contact with the metal cores 13a of the metal/metallic oxide particulates 13, so that the porous photoelectrode 3 can be prevented from being dissolved by the electrolyte. Therefore, a metal having a great surface plasmon resonance effect, such as gold, silver, copper, etc. can be used as the metal for constituting the cores 13a of the metal/metallic oxide particulates, so that the effect of surface plasmon resonance can be obtained sufficiently. In addition, an iodine electrolyte can be used as the electrolyte of the electrolyte solution. Consequently, it is possible to obtain a dye-sensitized photoelectric conversion element which is high in photoelectric conversion efficiency. Besides, by use of this excellent dye-sensitized photoelectric conversion element, a high-performance electronic apparatus can be realized.

<16. Sixteenth Embodiment>

[Photoelectric conversion element]

A photoelectric conversion element of a monolithic conversion element according to a sixteenth embodiment of the present technology will be described, which has the same configuration as that of the dye-sensitized photoelectric conversion element according to the fifteenth embodiment above, except that no photosensitizing dye is bound to the metal/metallic oxide particulates 13 constituting the porous photoelectrode 3.

[Method of manufacturing photoelectric conversion element]

This dye-sensitized photoelectric conversion element can be manufactured by a method which is the same as the method of manufacturing the dye-sensitized photoelectric conversion element according to the fifteenth embodiment, except that no photosensitizing dye is adsorbed on the porous photoelectrode 3.

operation of photoelectric conversion element]

Now, operation of this photoelectric conversion element will be described below.

The photoelectric conversion element, upon incidence of light thereon, operates as a cell with the carbon counter electrode 5 as a positive electrode and with the transparent conductive layer 2a as a negative electrode. The principle of the operation is as follows. Incidentally, it is assumed here that FTO is used as the material for the transparent conductive layer 2a, Au is used as the material for the cores 13a of the metal/metallic oxide particulates 13 constituting the porous photoelectrode 3, while $TiO_2$ is used as the material of the shells 13b, and an oxidation-reduction species of $I^-/I_3^-$ is used as the redox pair. This assumption, however, is non-limitative.

When light transmitted through the transparent substrate 1 and the transparent conductive layer 2a, is incident

on the surfaces of the Au cores 13a of the metal/metallic oxide particulates 13 constituting the porous photoelectrode 3, excitation of localized surface plasmon is brought about, whereby an electric field intensifying effect can be obtained. Then, by the thus excited electric field, a large amount of electrons are excited into the conduction band of $TiO_2$ constituting the shells 13b, and the thus excited electrons pass through the porous photoelectrode 3, to reach the transparent conductive layer 2a.

On the other hand, the porous photoelectrode 3 having lost the electrons accepts electrons from a reducing agent, for example $I^-$, in the electrolyte solution with which the porous photoelectrode 3 and the like have been impregnated, by the following reaction, to produce an oxidizing agent, for example $I_3^-$ (a combined ion of $I_2$ and $I^-$), in the electrolyte solution.

$$2I^- \rightarrow I_2 + 2e^-$$

$$I_2 + I^- \rightarrow I_3^-$$

The thus produced oxidizing agent diffuses to reach the carbon counter electrode 5, where it accepts electrons from the carbon counter electrode 5 by the reverse reaction of the above-mentioned reaction, to be reduced to the original reducing agent.

$$I_3^- \rightarrow I_2 + I^-$$

$$I_2 + 2e^- \rightarrow 2I^-$$

Electrons sent out from the transparent conductive layer 2a into an external circuit performs an electrical work in the external circuit, before returning to the carbon counter electrode 5. In this manner, optical energy is converted into electrical energy, without leaving any change in the photosensitizing dye(s) or the electrolyte solution.

According to the sixteenth embodiment, the same merits as those according to the first embodiment can be obtained.

While some embodiments and examples of the present technology have been specifically described above, the present technology is not limited to the above-described embodiments and examples, and various modifications are possible based on the technical thought of the present technology.

For instance, the numerical values, structures, configurations, shapes, materials, etc. mentioned in the embodiments and examples above are mere examples, and, therefore, numerical values, structures, configurations, shapes, materials, etc. different from the above-mentioned may be adopted, as appropriate..

Besides, if necessary, two or more of the first to sixteenth embodiments described above may be used in combination.

The present disclosure contains subject matter related to that disclosed in Japanese Priority Patent Application JP 2010-147257 filed in the Japan Patent Office on June 29, 2010.

It should be understood by those skilled in the art that various modifications, combinations, sub-combinations and alterations may occur depending on design requirements and other factors in so far as they are within the scope of the appended claims or the equivalents thereof.

Various preferred features are set out in the following numbered paragraphs.

1. A photoelectric conversion element wherein a porous photoelectrode, a porous insulating layer and a counter electrode are sequentially layered over a substrate, and a current collector is provided over the counter electrode.
2. A method of manufacturing a photoelectric conversion element, comprising
adhering a counter electrode having a current collector onto a porous insulating layer and a conductive member which are components of a body having a porous photoelectrode and the porous insulating layer sequentially layered over a substrate, the body having the conductive member formed over the substrate in an area different from the areas of the porous photoelectrode and the porous insulating layer.
3. A photoelectric conversion element wherein a porous photoelectrode, a porous insulating layer, a counter electrode and a current collector are sequentially layered over a substrate, and the substrate and the counter electrode are electrically connected to each other through a conductive member at a portion of the substrate different from portions corresponding to the porous photoelectrode and the porous insulating layer.
4. A method of manufacturing a photoelectric conversion element module, comprising
adhering a counter electrode having a current collector onto a porous insulating layer and a conductive member which are components of a body having a porous photoelectrode and the porous insulating layer sequentially layered

in each of a plurality of regions over a substrate, the body having the conductive member at a portion of the substrate different from portions corresponding to the porous photoelectrode and the porous insulating layer.

5. A photoelectric conversion element module wherein a porous photoelectrode, a porous insulating layer, a counter electrode and a current collector are sequentially layered in each of a plurality of regions over a substrate, and the substrate and the counter electrode are electrically connected to each other through a conductive member at a portion of the substrate different from portions corresponding to the porous photoelectrode and the porous insulating layer.

## Claims

**1.** A method of manufacturing a photoelectric conversion element, comprising:

adhering a counter electrode having a current collector onto a porous photoelectrode and a porous insulating layer which are sequentially layered over a substrate; and
bending the current collector and joining the current collector to the substrate.

**2.** The method of manufacturing the photoelectric conversion element according to claim 1, wherein the substrate has an insulating substrate with a first conductive layer and a second conductive layer provided thereover, the first conductive layer and the second conductive layer being separate from each other, the porous photoelectrode is formed over the first conductive layer, the porous insulating layer is formed so as to extend along an upper surface and a side surface of the porous photoelectrode and to make contact with the insulating substrate in an area between the first conductive layer and the second conductive layer, and the current collector is bent and electrically connected to the second conductive layer.

**3.** The method of manufacturing the photoelectric conversion element according to claim 2, wherein the current collector has a conductor plate joined to a surface, on the side opposite to the counter electrode side, of the porous insulating layer.

**4.** The method of manufacturing the photoelectric conversion element according to claim 3, wherein the conductor plate is a foil having a metal or alloy.

**5.** The method of manufacturing the photoelectric conversion element according to claim 4, wherein the counter electrode has a carbon electrode.

**6.** The method of manufacturing the photoelectric conversion element according to claim 5, wherein the current collector is electrically connected to the second conductive layer by use of a conductive adhesive.

**7.** The method of manufacturing the photoelectric conversion element according to claim 6, further comprising impregnating at least the porous photoelectrode and the porous insulating layer with an electrolyte solution.

**8.** A photoelectric conversion element wherein a counter electrode having a current collector is adhered onto a porous photoelectrode and a porous insulating layer which are sequentially layered over a substrate, and the current collector is bent and joined to the substrate.

**9.** The photoelectric conversion element according to claim 8, wherein the substrate has an insulating substrate with a first conductive layer and a second conductive layer provided thereover, the first conductive layer and the second conductive layer being separate from each other, the porous photoelectrode is formed over the first conductive layer, the porous insulating layer is formed so as to extend along an upper surface and a side surface of the porous photoelectrode and to make contact with the insulating substrate in an area between the first conductive layer and the second conductive layer, and the current collector is bent and electrically connected to the second conductive layer.

**10.** The photoelectric conversion element according to claim 9, wherein the counter electrode has a carbon electrode.

**11.** A method of manufacturing a photoelectric conversion element module, comprising:

forming, in each of a plurality of areas between a substrate and a conductor plate, a structure having a porous

photoelectrode, a porous insulating layer and a counter electrode which are sandwiched between the substrate and the conductor plate in the state of being disposed in this order from the substrate side toward the conductor plate side;
cutting the conductor plate of the structure along a side surface of the counter electrode; and
bending, after the cutting of the conductor plate, a conductor plate portion on the side of a free end of the cut conductor plate and joining the conductor plate portion to the substrate.

**12.** The method of manufacturing the photoelectric conversion element module according to claim 11, wherein the substrate has an insulating substrate with conductive layers provided respectively in a plurality of regions over the insulating substrate, the porous photoelectrode, the porous insulating layer and the counter electrode are sandwiched between the conductive layer and the conductor plate, and the conductor plate is bent and electrically connected to the conductive layer.

**13.** A photoelectric conversion element module wherein a counter electrode having a current collector is adhered onto a porous photoelectrode and a porous insulating layer which are sequentially layered in each of a plurality of regions over a substrate, and the conductor plate is bent and joined to the substrate.

**14.** The photoelectric conversion element module according to claim 13, wherein the substrate has an insulating substrate with conductive layers provided respectively in a plurality of regions over the insulating substrate, the porous phatoelectrode, the porous insulating layer and the counter electrode are formed over the conductive layer, and the conductor plate is bent and electrically connected to the conductive layer.

**15.** A method of manufacturing a photoelectric conversion element, comprising
forming a current collector over a porous photoelectrode, a porous insulating layer and a counter electrode which are sequentially layered over a substrate.

FIG. 1

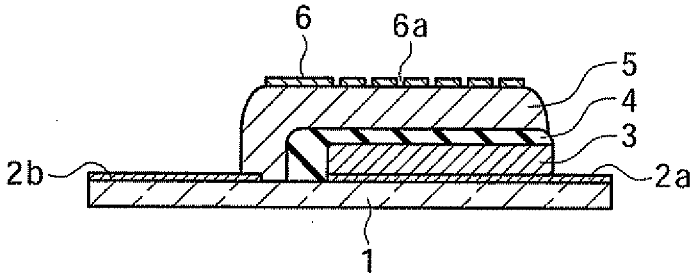

FIG. 2

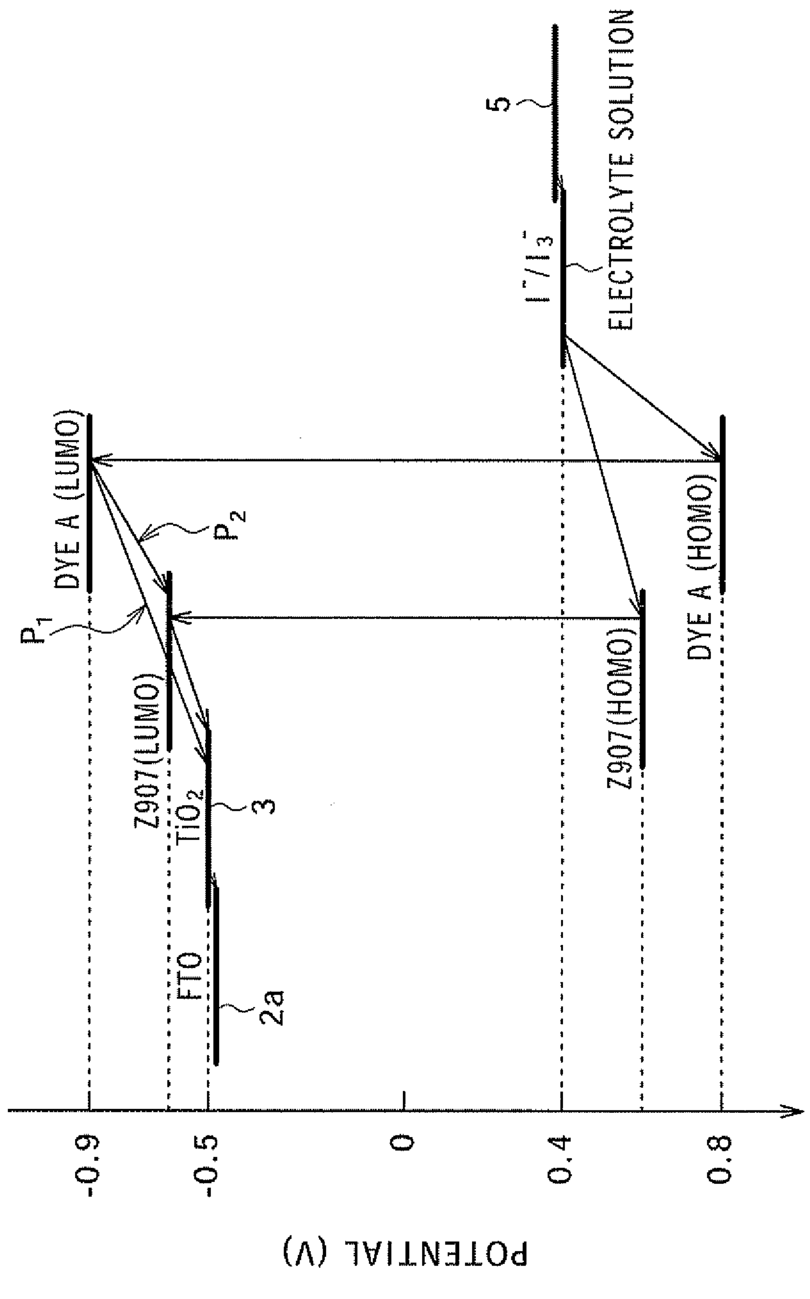
DYE A (LUMO)
P1
P2
Z907(LUMO)
TiO2
3
FTO
2a
I⁻/I3⁻
ELECTROLYTE SOLUTION
5
Z907(HOMO)
DYE A (HOMO)
-0.9
-0.5
0
0.4
0.8
POTENTIAL (V)

FIG. 3

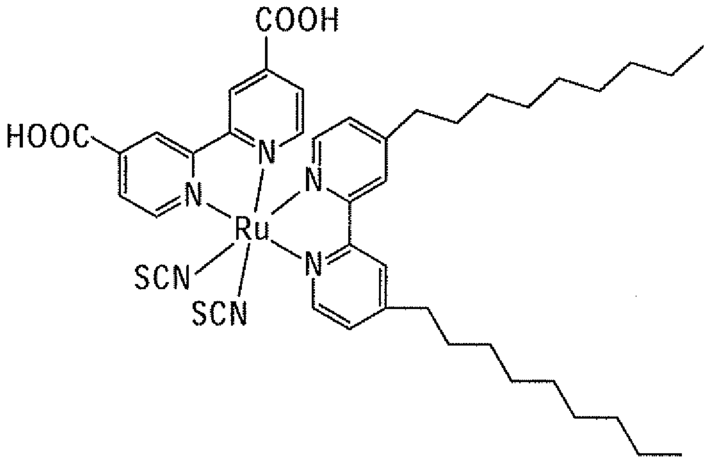

FIG. 4

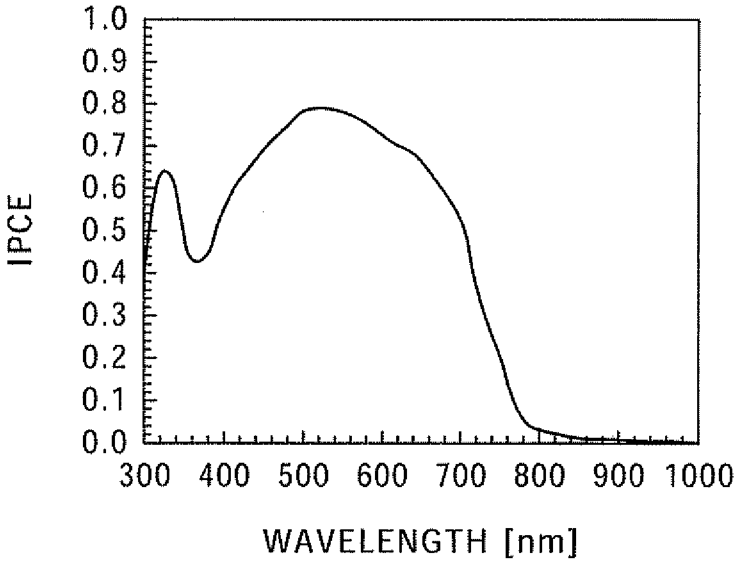
1.0
0.9
0.8
0.7
0.6
0.5
0.4
0.3
0.2
0.1
0.0
IPCE
300
400
500
600
700
800
900
1000
WAVELENGTH [nm]

FIG. 5

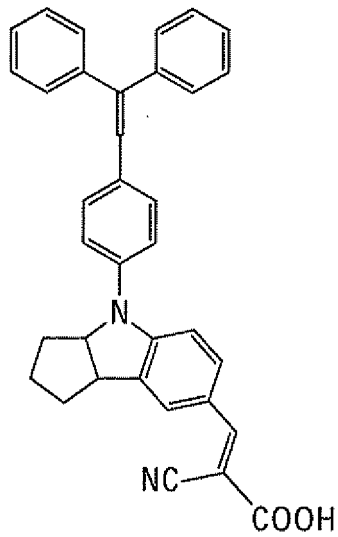

FIG. 6

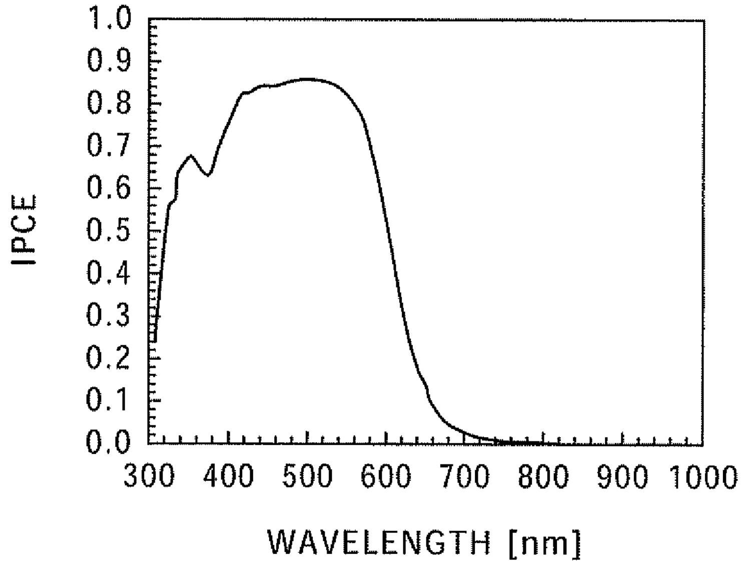
1.0
0.9
0.8
0.7
0.6
0.5
0.4
0.3
0.2
0.1
0.0
IPCE
300 400 500 600 700 800 900 1000
WAVELENGTH [nm]

FIG. 7

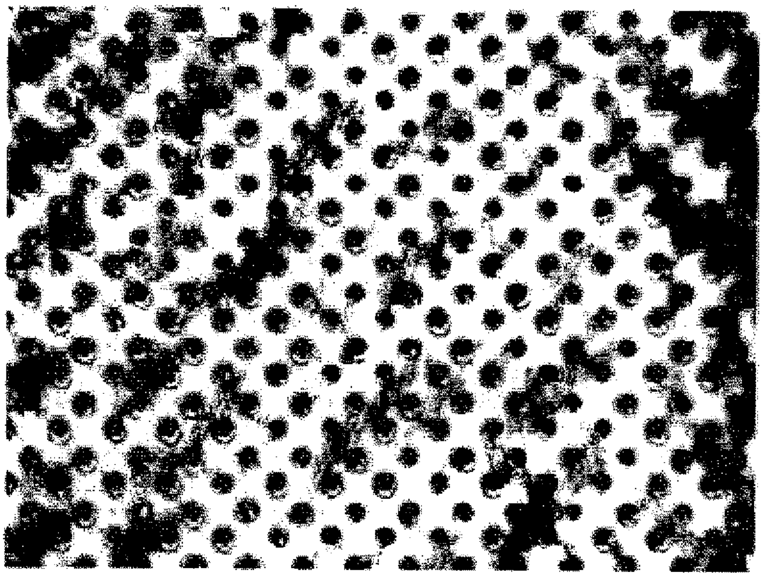

FIG. 8

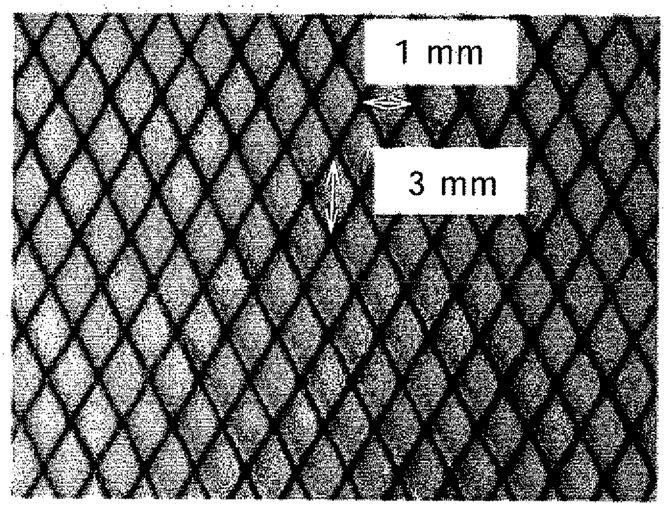

FIG. 9

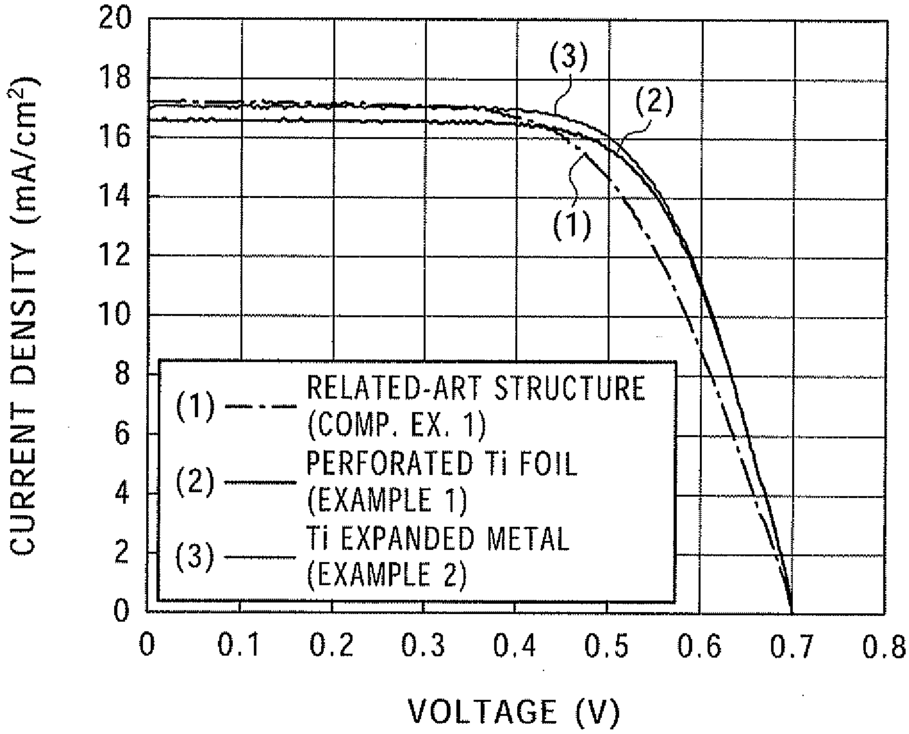
20
18
16
14
12
10
8
6
4
2
0
CURRENT DENSITY (mA/cm2)
0
0.1
0.2
0.3
0.4
0.5
0.6
0.7
0.8
VOLTAGE (V)
(3)
(2)
(1)
(1) RELATED-ART STRUCTURE (COMP. EX. 1)
(2) PERFORATED Ti FOIL (EXAMPLE 1)
(3) Ti EXPANDED METAL (EXAMPLE 2)

FIG. 10

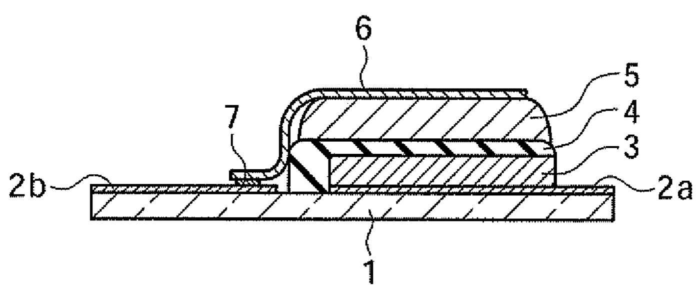
6
5
4
3
7
2b
2a
1

FIG.11A

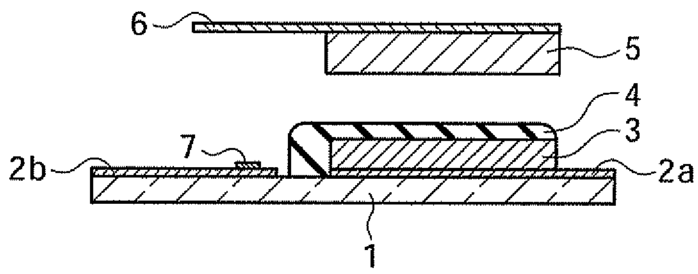


FIG.11B

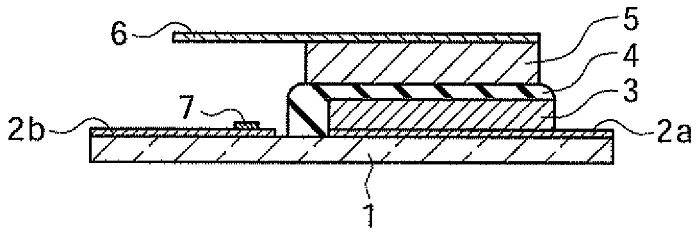


FIG.12

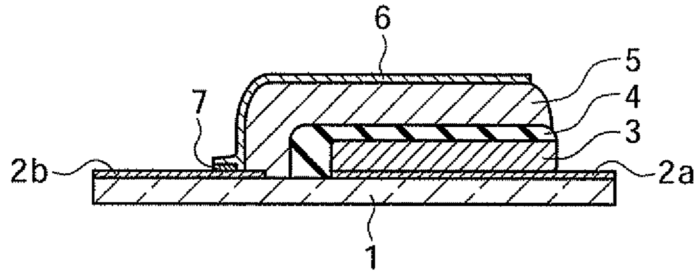

FIG.13A

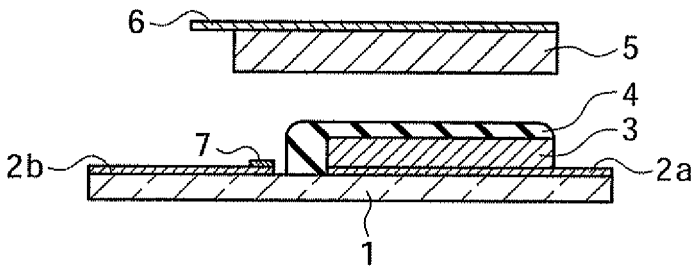


FIG.13B

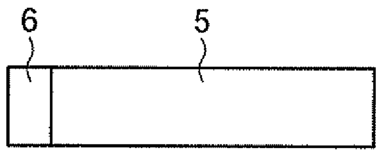


FIG.14

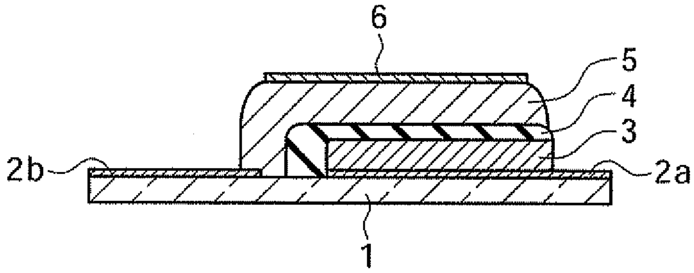

FIG.15

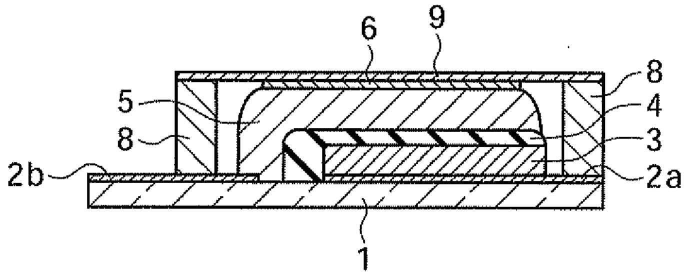


FIG.16

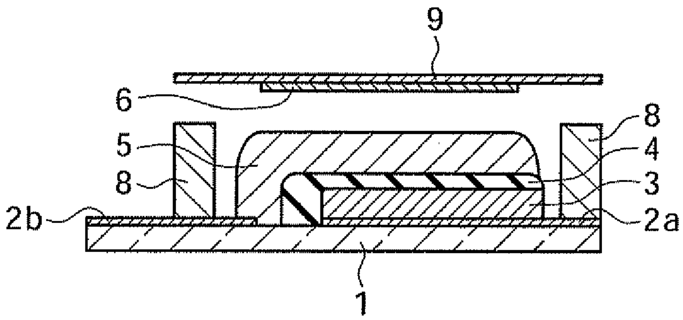


FIG.17

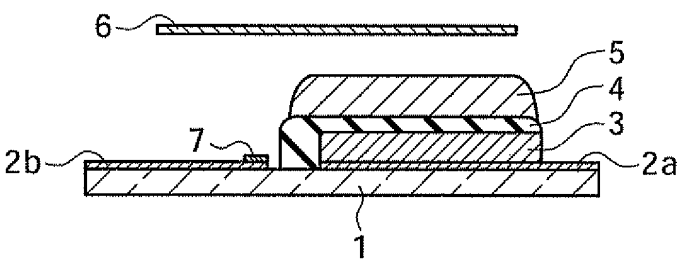

FIG.18

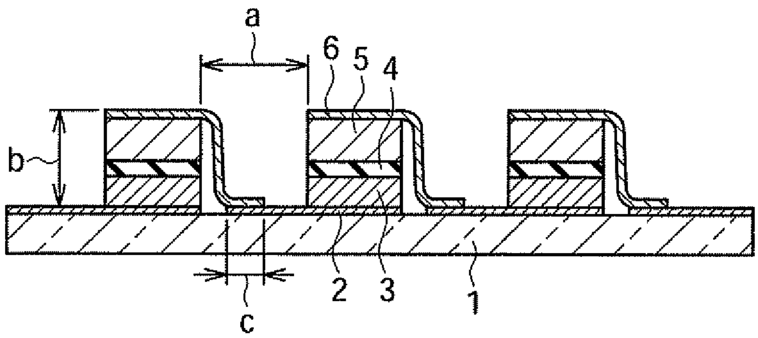


FIG.19

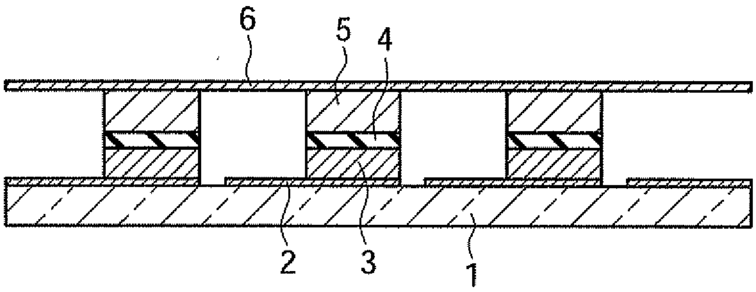

FIG.20A

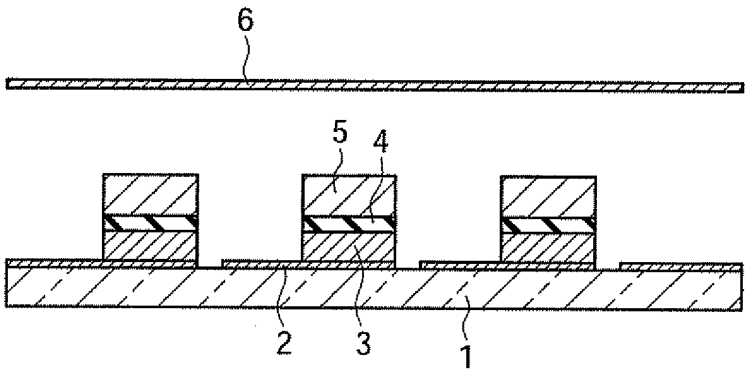


FIG.20B

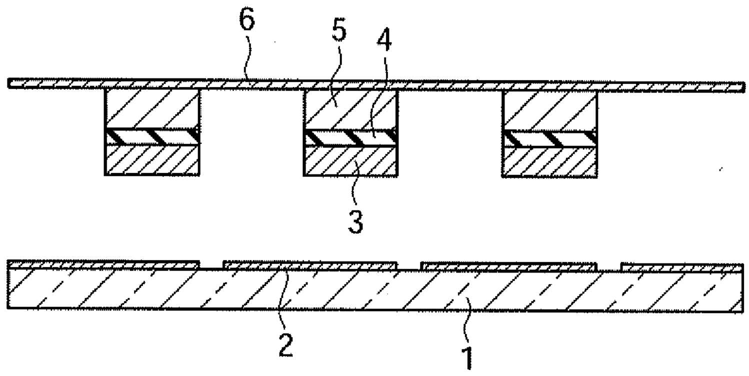


FIG.20C

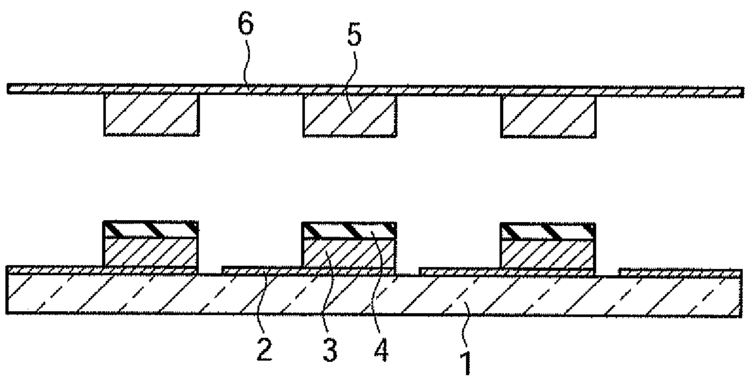

FIG.21

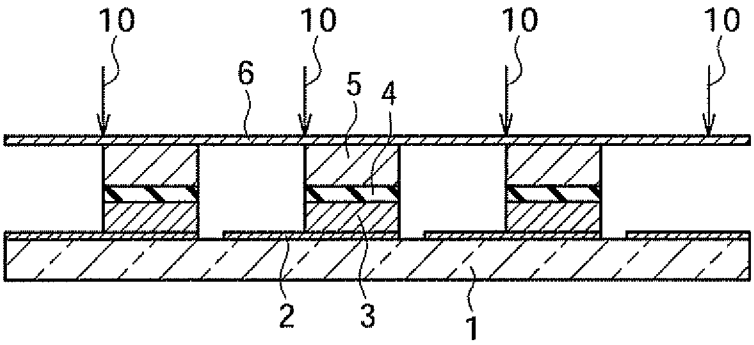


FIG.22

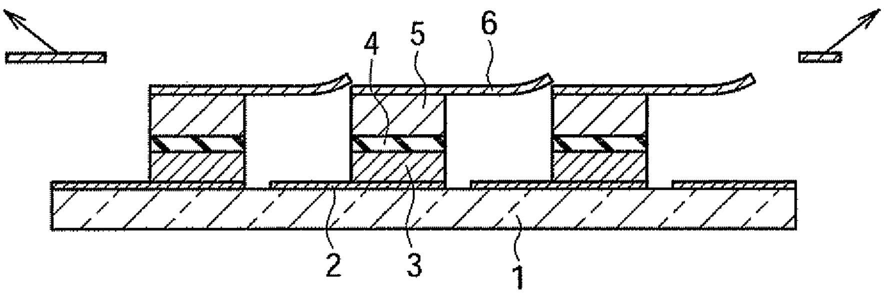

FIG.23

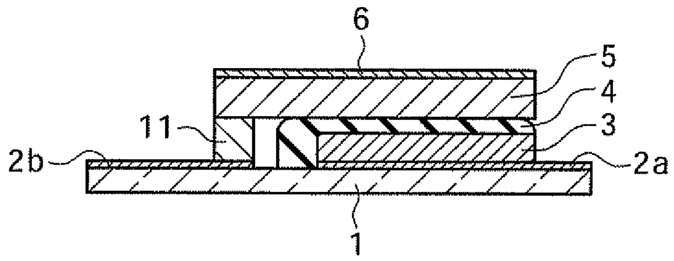


FIG.24A

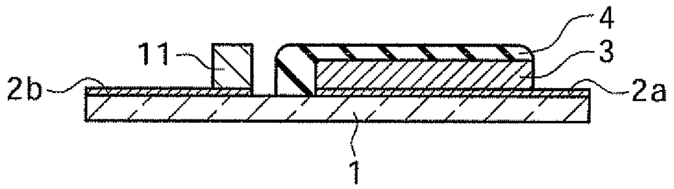


FIG.24B

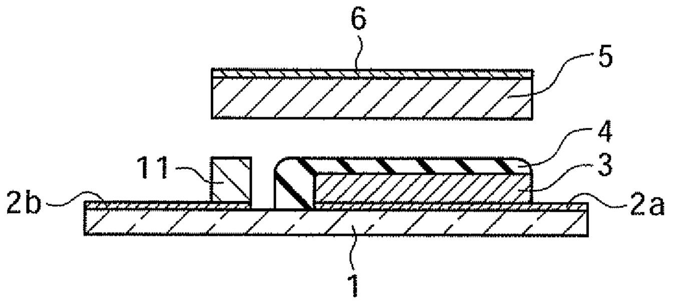


FIG.24C

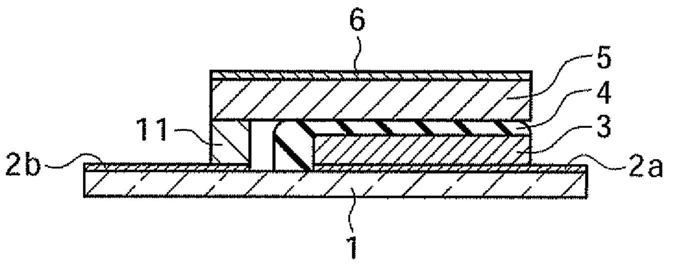

FIG.25

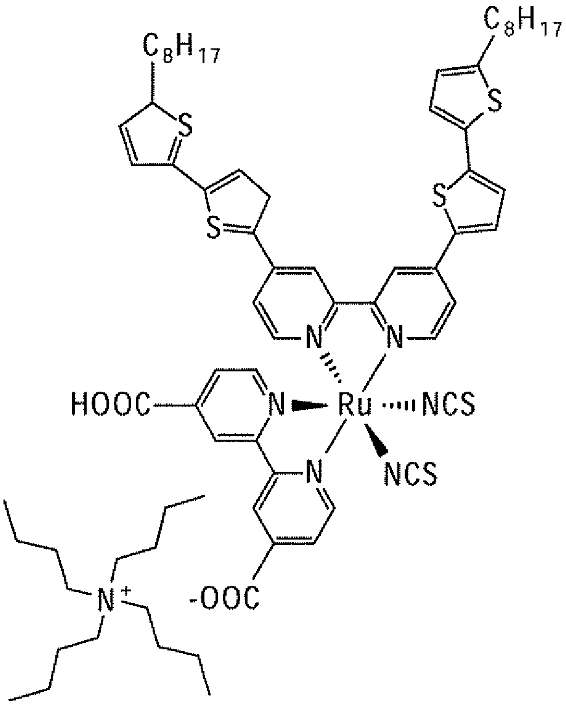

FIG.26

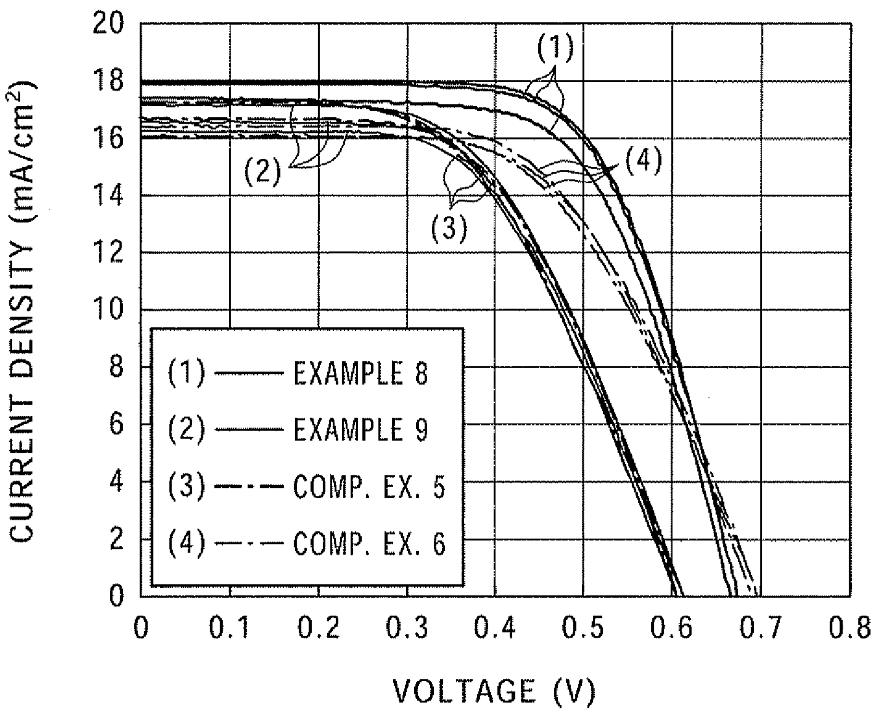
CURRENT DENSITY (mA/cm2)
VOLTAGE (V)
0
2
4
6
8
10
12
14
16
18
20
0
0.1
0.2
0.3
0.4
0.5
0.6
0.7
0.8
(1)
(2)
(3)
(4)
(1) EXAMPLE 8
(2) EXAMPLE 9
(3) COMP. EX. 5
(4) COMP. EX. 6

FIG. 27

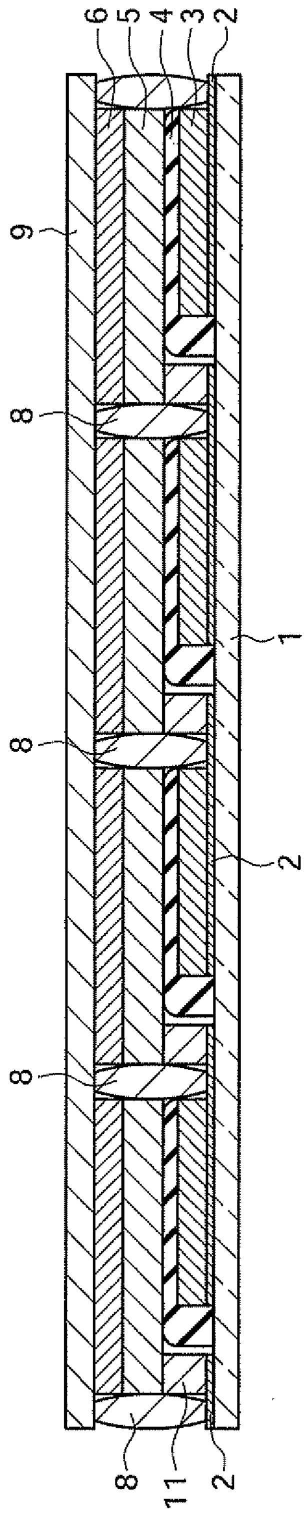

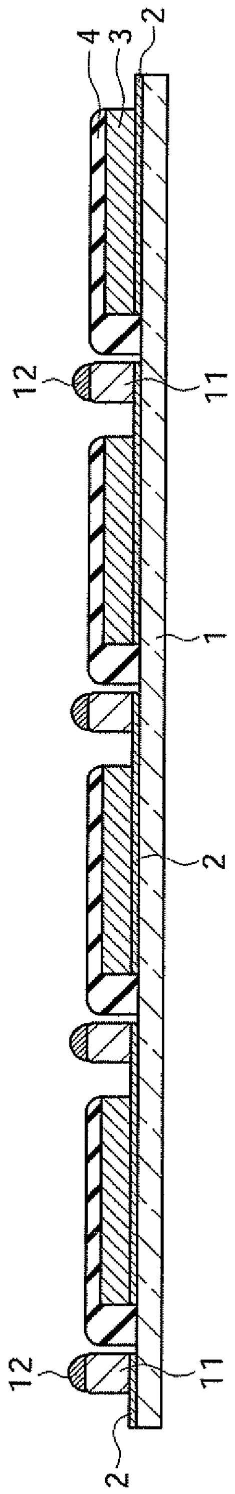

FIG. 28A

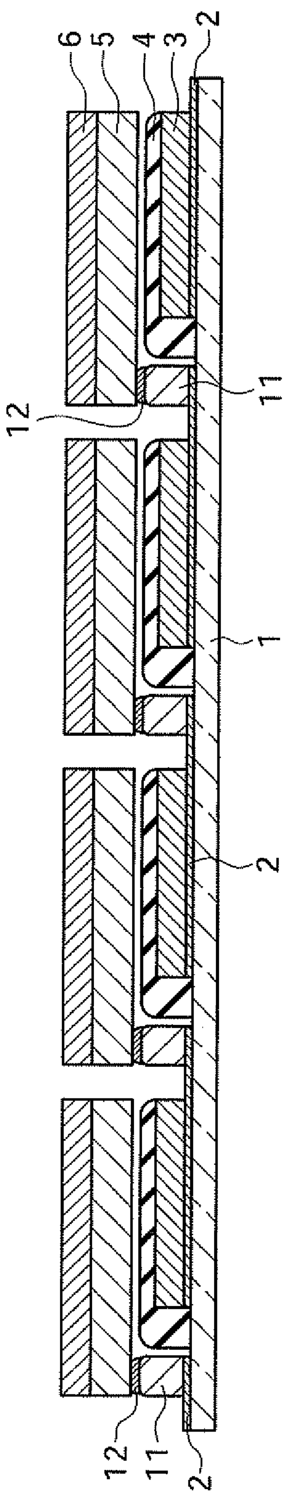

FIG. 28B

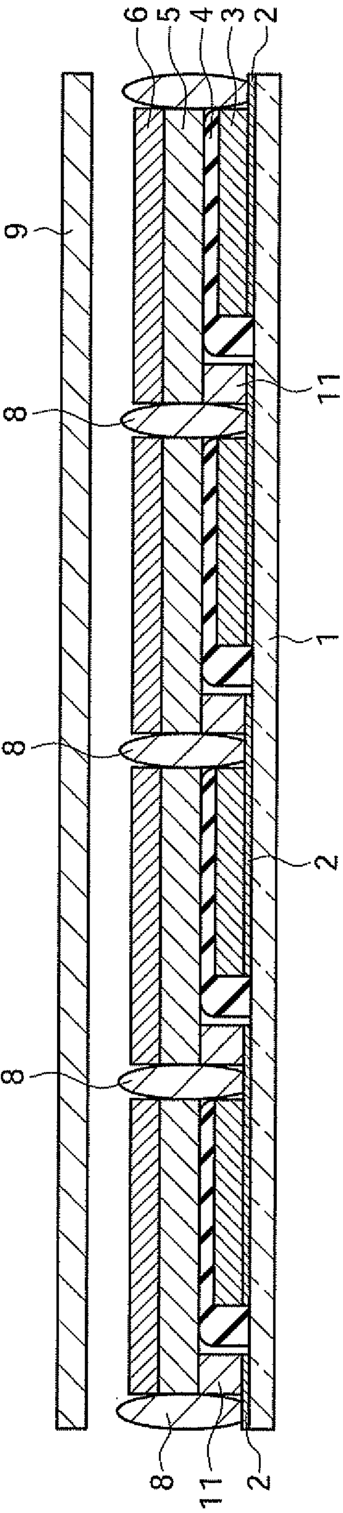

FIG. 29A

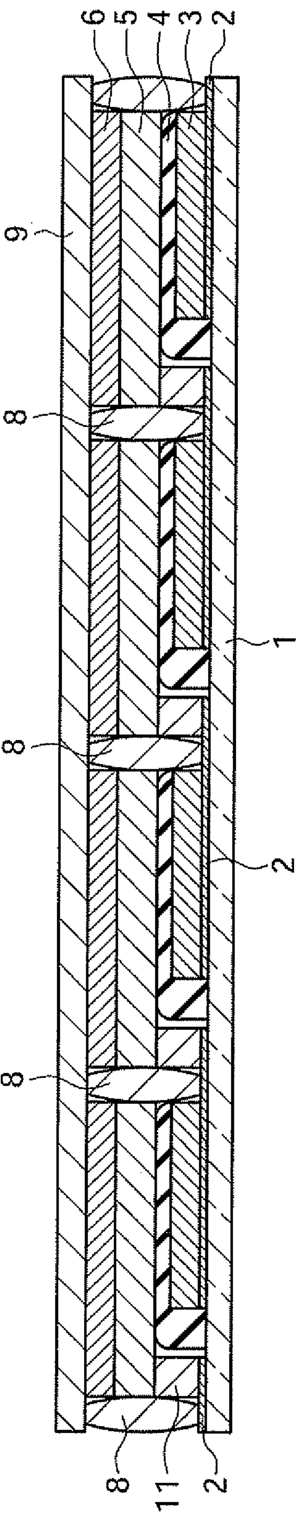

FIG. 29B

FIG.30

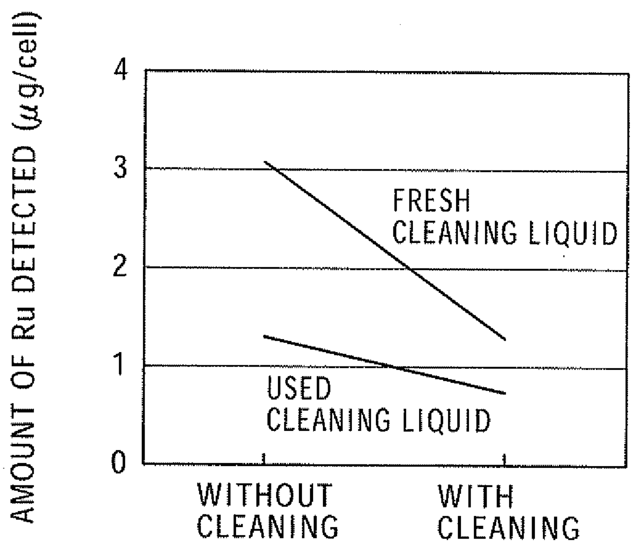
AMOUNT OF Ru DETECTED (μg/cell)
4
3
2
1
0
FRESH
CLEANING LIQUID
USED
CLEANING LIQUID
WITHOUT
CLEANING
WITH
CLEANING

FIG.31

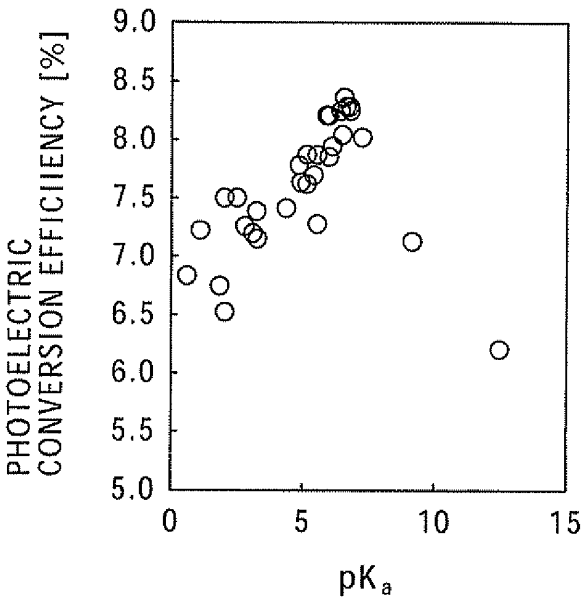
PHOTOELECTRIC
CONVERSION EFFICIIENCY [%]
9.0
8.5
8.0
7.5
7.0
6.5
6.0
5.5
5.0
0
5
10
15
pKa

FIG.32

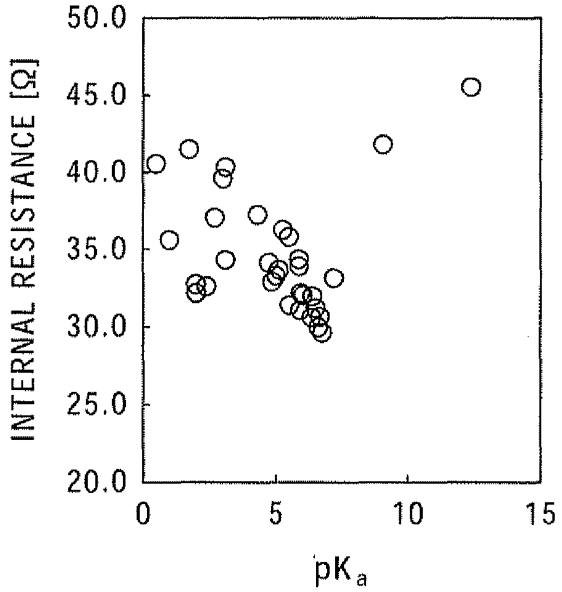
50.0
45.0
40.0
35.0
30.0
25.0
20.0
INTERNAL RESISTANCE [Ω]
0
5
10
15
pK a

FIG.33

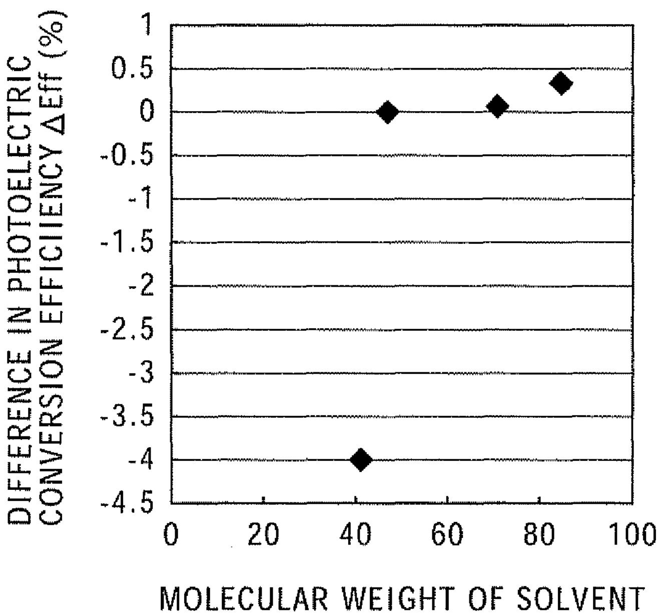
1
0.5
0
-0.5
-1
-1.5
-2
-2.5
-3
-3.5
-4
-4.5
DIFFERENCE IN PHOTOELECTRIC CONVERSION EFFICIIENCY ΔEff (%)
0
20
40
60
80
100
MOLECULAR WEIGHT OF SOLVENT

FIG.34

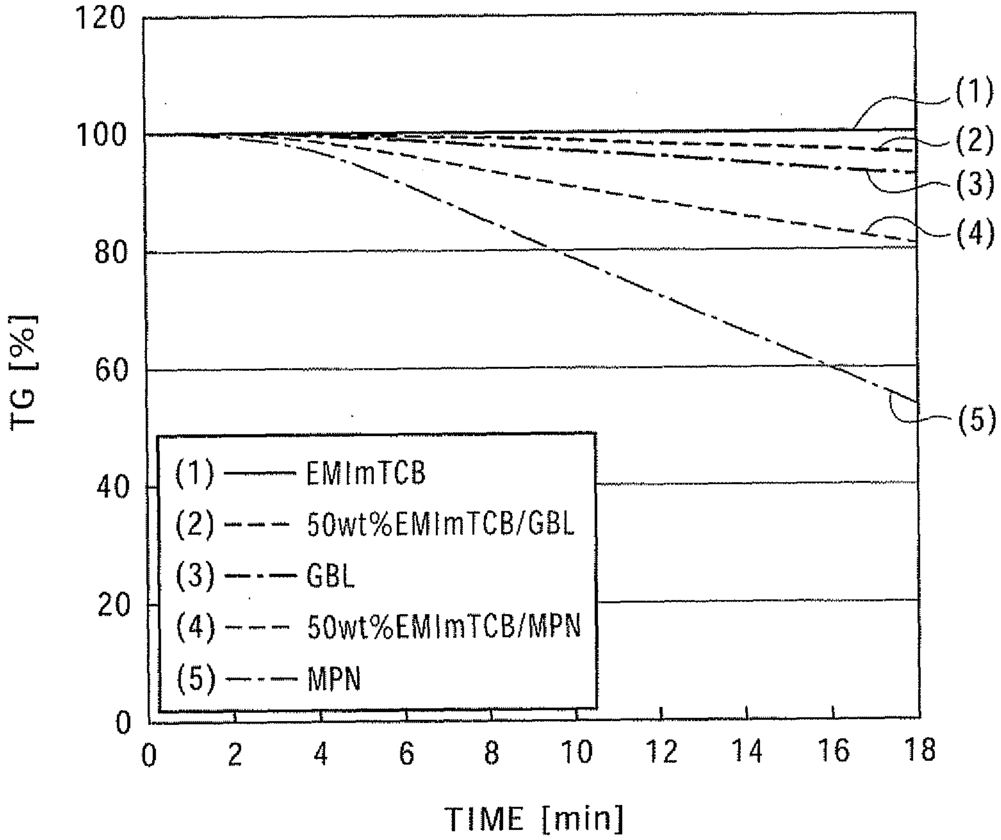

120
100
80
60
40
20
0
TG [%]
0
2
4
6
8
10
12
14
16
18
TIME [min]
(1)
(2)
(3)
(4)
(5)
(1) EMImTCB
(2) 50wt%EMImTCB/GBL
(3) GBL
(4) 50wt%EMImTCB/MPN
(5) MPN

FIG.35

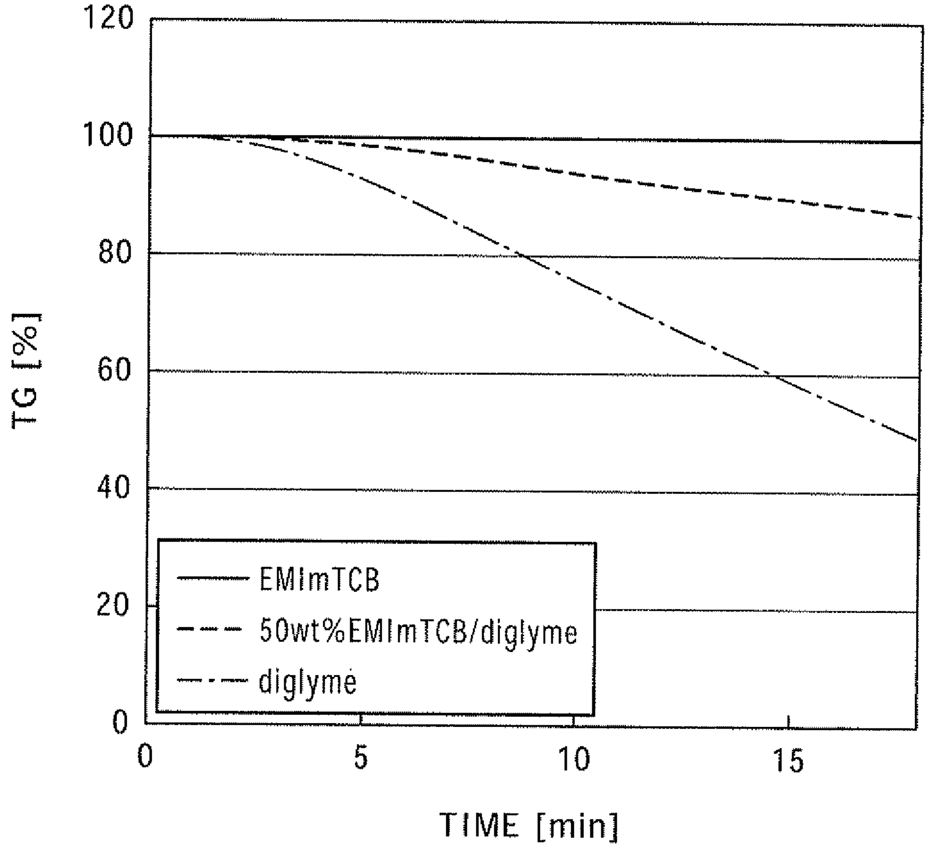
120
100
80
60
40
20
0
TG [%]
0
5
10
15
TIME [min]
EMImTCB
50wt%EMImTCB/diglyme
diglyme

FIG.36

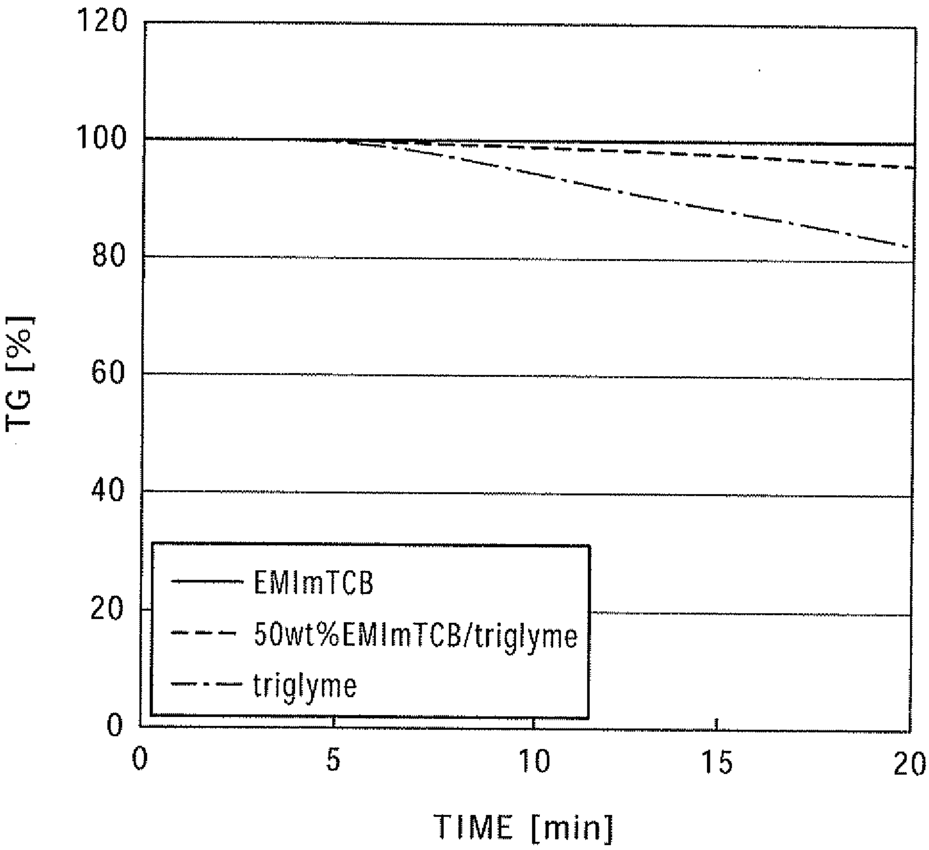
120
100
80
60
40
20
0
TG [%]
0
5
10
15
20
TIME [min]
EMImTCB
50wt%EMImTCB/triglyme
triglyme

FIG. 37

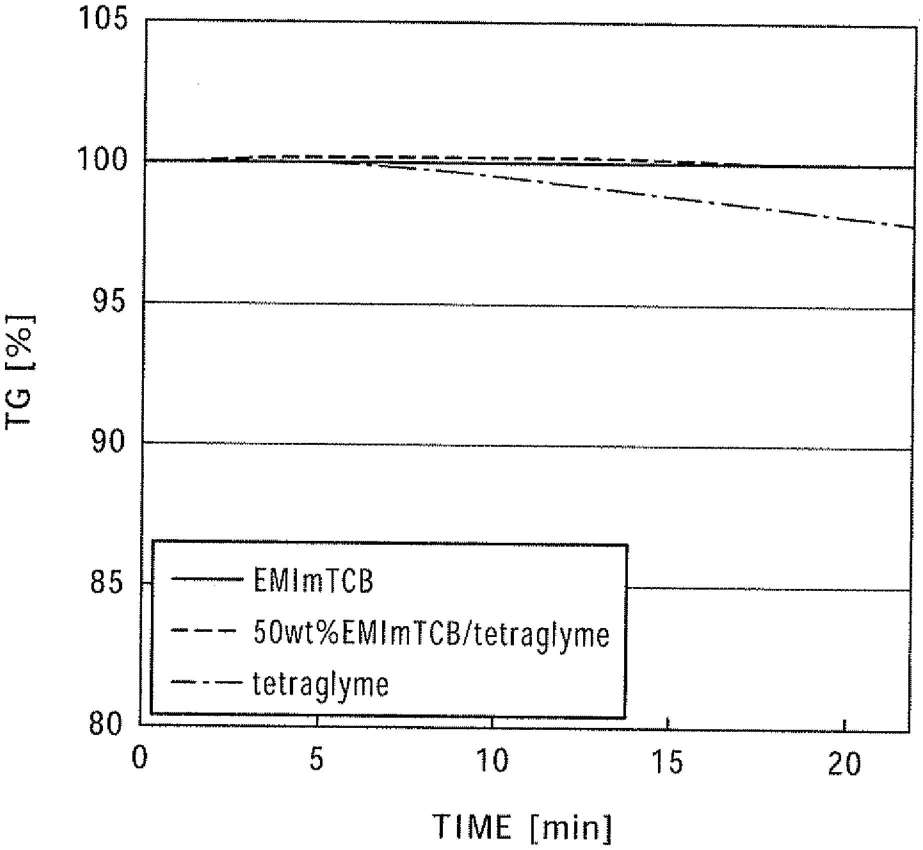
105
100
95
90
85
80
TG [%]
0
5
10
15
20
TIME [min]
EMImTCB
50wt%EMImTCB/tetraglyme
tetraglyme

FIG.38

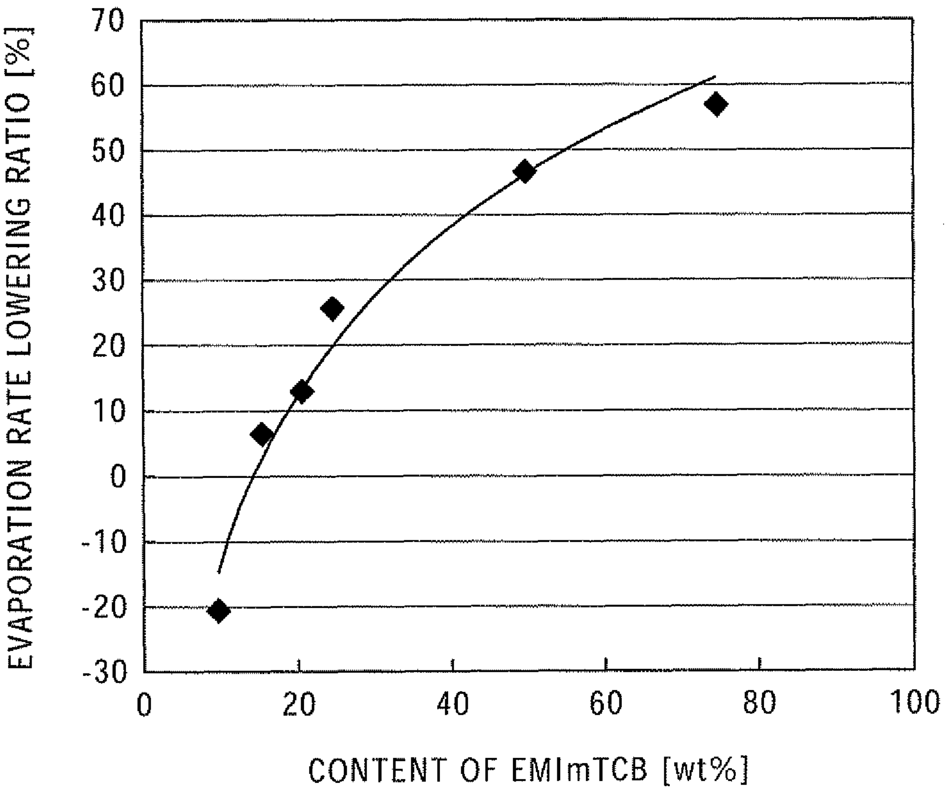
EVAPORATION RATE LOWERING RATIO [%]
70
60
50
40
30
20
10
0
-10
-20
-30
0
20
40
60
80
100
CONTENT OF EMImTCB [wt%]

FIG.39

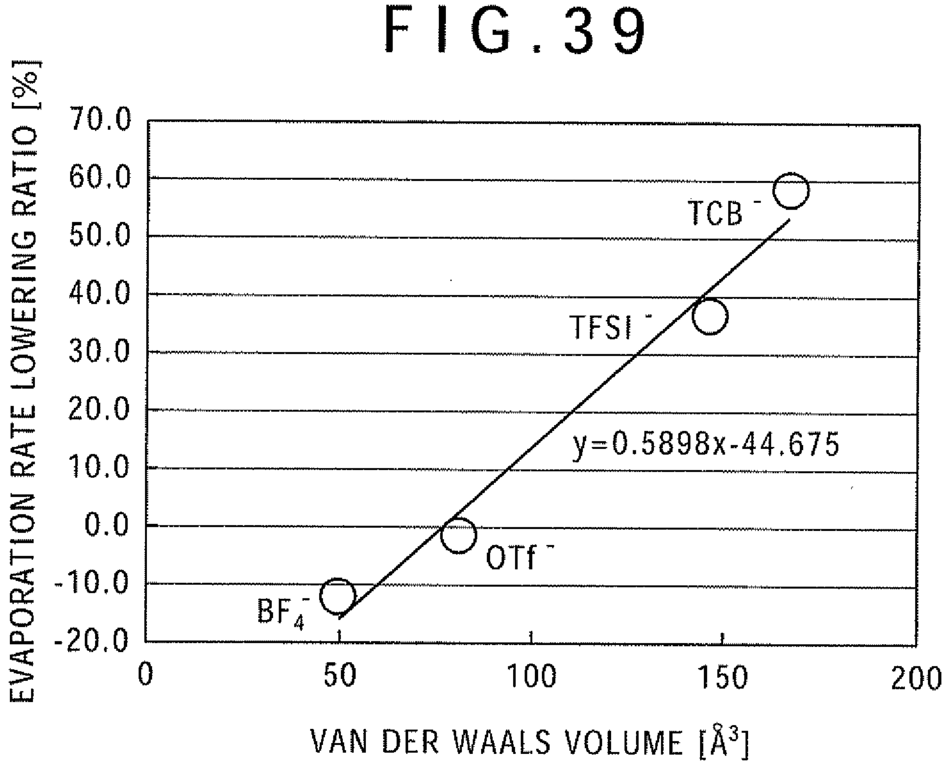
EVAPORATION RATE LOWERING RATIO [%]
70.0
60.0
50.0
40.0
30.0
20.0
10.0
0.0
-10.0
-20.0
0
50
100
150
200
VAN DER WAALS VOLUME [Å³]
TCB⁻
TFSI⁻
y=0.5898x-44.675
OTf⁻
BF₄⁻

FIG.40

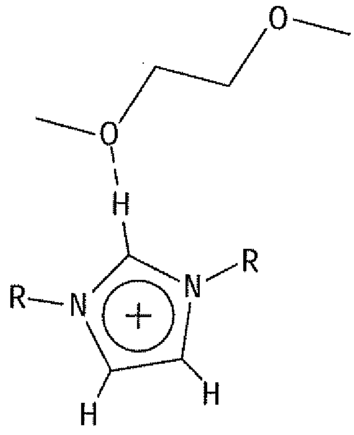

FIG.41

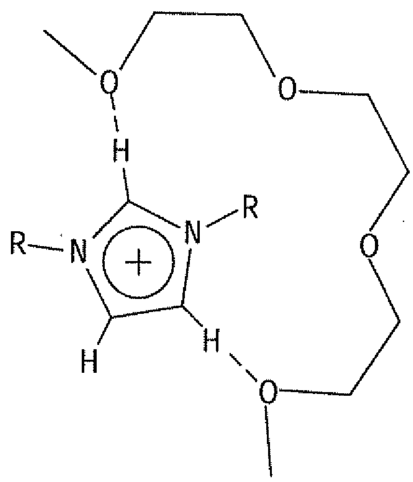

FIG.42

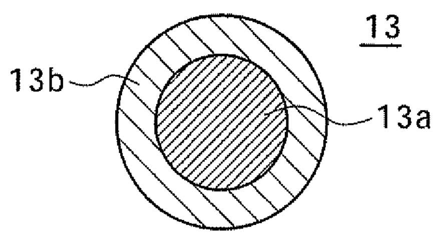

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006236960 A
- JP 2010147257 A


### Non-patent literature cited in the description


- *Nature,* 1991, vol. 353, 737-740
- *Inorg. Chem.,* 1996, vol. 35, 1168-1178
- *J. Chem. Phys.,* 2006, vol. 124, 184902
- **HIRONORI ARAKAWA.** Shikiso Zokan Taiyo Denchi No Saishin Gijutsu. CMC Publishing Co., Ltd, 2001
- *Journal of The Electrochemical Society 002,* 2002, vol. 149 (10), A1385-A1388
- *Jpn- J. Appl. Phys.,* 2007, vol. 46 (4B), 2567-2570